(19) Europäisches Patentamt
European Patent Office
Office européen des brevets

(11) EP 4 210 454 A1

(12) **EUROPEAN PATENT APPLICATION**

(43) Date of publication:
**12.07.2023 Bulletin 2023/28**

(21) Application number: **23150919.1**

(22) Date of filing: **10.01.2023**

(51) International Patent Classification (IPC):
***H10K 50/858*** *(2023.01)* ***H10K 85/30*** *(2023.01)*
*H10K 50/11* *(2023.01)*

(52) Cooperative Patent Classification (CPC):
**H10K 50/858; H10K 85/342;** H10K 50/11; H10K 59/879

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **10.01.2022 KR 20220003636**

(71) Applicant: **Samsung Display Co., Ltd.**
**Yongin-si, Gyeonggi-do 17113 (KR)**

(72) Inventors:
- **Kim, Hoilim**
  **Yongin-si, Gyeonggi-do 17113 (KR)**
- **Jung, Hyojoo**
  **Yongin-si, Gyeonggi-do 17113 (KR)**
- **Kim, Jihye**
  **Yongin-si, Gyeonggi-do 17113 (KR)**
- **Park, Saerom**
  **Yongin-si, Gyeonggi-do 17113 (KR)**
- **Yoo, Dongsun**
  **Yongin-si, Gyeonggi-do 17113 (KR)**
- **Han, Younho**
  **Yongin-si, Gyeonggi-do 17113 (KR)**

(74) Representative: **Gulde & Partner**
**Patent- und Rechtsanwaltskanzlei mbB**
**Wallstraße 58/59**
**10179 Berlin (DE)**

(54) **LIGHT-EMITTING DEVICE AND ELECTRONIC APPARATUS INCLUDING THE SAME**

(57) A light-emitting device and an electronic apparatus including the same are provided. The light-emitting device includes a first electrode (110), a second electrode (150) facing the first electrode, an interlayer (130) between the first electrode and the second electrode and including an emission layer, and a capping layer (170). The emission layer includes a first emitter, the first emitter emits a first light having a first emission spectrum, the capping layer is in a path on which the first light travels, an emission peak wavelength of the first light is about 520 nm to about 550 nm. The first emitter includes iridium, the capping layer includes an amine-free compound, and the value of ratio of CIEy to reflective index (RCR value) of the first light extracted to the outside through the capping layer is 38 or less, and the RCR value is calculated according to CIEy/R(cap) × 100.

**FIG. 2**

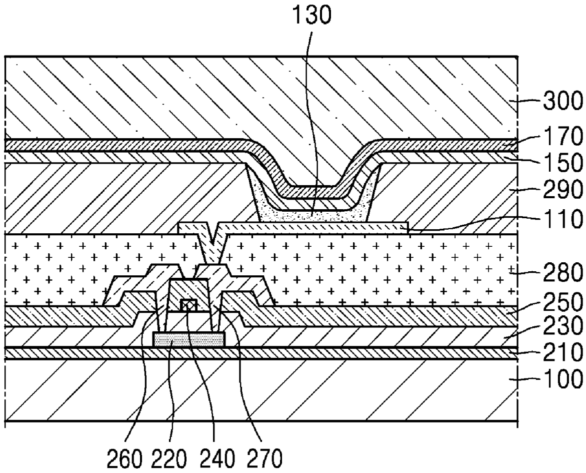


EP 4 210 454 A1

## Description

## BACKGROUND

### 1. Field

Aspects of one or more embodiments of the present disclosure relate to a light-emitting device and an electronic apparatus including the same.

### 2. Description of the Related Art

From among light-emitting devices, self-emissive devices (for example, organic light-emitting devices, etc.) have wide viewing angles, excellent or suitable contrast ratios, fast response times, and excellent or suitable characteristics in terms of luminance, driving voltage, and response speed.

In a light-emitting device, a first electrode is on a substrate, and a hole transport region, an emission layer, an electron transport region, and a second electrode are sequentially arranged on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. These excitons are transitioned from an excited state to a ground state to generate light.

## SUMMARY

An aspect of one or more embodiments of the present disclosure is directed toward a light-emitting device having frontal luminescence efficiency and lateral luminescence efficiency at substantially the same time (concurrently), and an electronic apparatus including the light-emitting device.

Additional aspects of embodiments of the present disclosure will be set forth in part in the description which follows and, in part, will be apparent from the description, or may be learned by practice of the presented embodiments of the disclosure.

According to an embodiment, provided is a light emitting device, the light-emitting device including:

a first electrode,
a second electrode facing the first electrode,
an interlayer between the first electrode and the second electrode and including an emission layer, and
a capping layer,
wherein the emission layer includes a first emitter,
the first emitter emits first light having a first emission spectrum,
the capping layer is in the path on which (e.g., via or through which) the first light travels,
an emission peak wavelength of the first light is from about 520 nm to about 550 nm,
the first emitter includes iridium,
the capping layer contains an amine-free compound, and
the value of ratio of CIEy to reflective index (RCR value) of the first light extracted to the outside through the capping layer is 38 or less, and
the RCR value is calculated by Equation 1

Equation 1

$$CIEy/R(cap) \times 100$$

wherein, in Equation 1,
CIEy is the y coordinate value of the CIE color coordinates of the first light extracted to the outside through the capping layer, and
R(cap) is the refractive index of the amine-free compound with respect to second light having a wavelength of the emission peak wavelength of the first light ± 20 nm.

According to an embodiment of the present disclosure, provided is a light-emitting device, the light-emitting device including:

a first electrode,
a second electrode facing the first electrode,
an interlayer between the first electrode and the second electrode and including an emission layer, and
a capping layer,
wherein the emission layer includes a first emitter,
the first emitter emits first light having a first emission spectrum,
the capping layer is in the path on which the first light travels,
the first emitter includes a first ligand, a second ligand, and a third ligand, each of which is bonded to the iridium,
the first ligand is a bidentate ligand including $Y_1$-containing ring $B_1$ and $Y_2$-containing ring $B_2$,
the second ligand is a bidentate ligand including $Y_3$-containing ring $B_3$ and $Y_4$-containing ring $B_4$,
the third ligand is a bidentate ligand including Ys-containing ring $B_5$ and $Y_6$-containing ring $B_6$,
each of $Y_1$, $Y_3$, and $Y_5$ is nitrogen (N),
each of $Y_2$, $Y_4$, and $Y_6$ is carbon (C), and
$Y_2$-containing ring $B_2$ and $Y_4$-containing ring $B_4$ are different from each other,
the capping layer contains an amine-free compound, and
the amine-free compound includes three or more $C_1$-$C_{60}$ cyclic groups which are linked to each other only via a single bond, not via an atom.

According to an embodiment of the present disclosure, provided is a light-emitting device, the light-emitting device including:

a first electrode,
a second electrode facing the first electrode,
an interlayer between the first electrode and the second electrode and including an emission layer,
a capping layer,
wherein the emission layer includes a first emitter,
the first emitter emits first light having a first emission spectrum,
the capping layer is in the path on which (e.g., via or through which) the first light travels,
an emission peak wavelength of the first light is from about 520 nm to about 550 nm,
the first emitter includes iridium,
the capping layer contains an amine-free compound, and
a refractive index of the amine-free compound with respect to second light having a wavelength of the range of the emission peak wavelength of the first light ± 20 nm is 1.85 or more.

An embodiment of the present disclosure provides an electronic apparatus including the light-emitting device.
An embodiment of the present disclosure provides a consumer product including the light-emitting device.

## BRIEF DESCRIPTION OF THE DRAWINGS

The above and other aspects and features of certain embodiments of the disclosure will be more apparent from the following description taken in conjunction with the accompanying drawings, in which:

FIG. 1 shows a schematic view of a light-emitting device according to an embodiment;
FIG. 2 shows a cross-sectional view of an electronic apparatus according to an embodiment; and
FIG. 3 shows a cross-sectional view of an electronic apparatus according to an embodiment.

## DETAILED DESCRIPTION

Reference will now be made in more detail to embodiments, examples of which are illustrated in the accompanying drawings, wherein like reference numerals refer to like elements throughout, and duplicative descriptions thereof may not be provided. In this regard, the present embodiments may have different forms and should not be construed as being limited to the descriptions set forth herein. Accordingly, the embodiments are merely described, by referring to the drawings, to explain aspects of the present disclosure. As utilized herein, the term "and/or" includes any and all combinations of one or more of the associated listed items. Throughout the disclosure, the expression "at least one of a, b or c", "at least one selected from a, b, and c", etc., indicates only a, only b, only c, both (e.g., simultaneously) a and b, both (e.g., simultaneously) a and c, both (e.g., simultaneously) b and c, all of a, b, and c, or variations thereof.
A light-emitting device according to an aspect of embodiments of the present disclosure may include: a first electrode; a second electrode facing the first electrode; an interlayer which is between the first electrode and the second

electrode and includes an emission layer; and a capping layer.

The emission layer may include a first emitter. The first emitter may emit first light having a first emission spectrum, and the capping layer may be in a path on which (e.g., via or through which) the first light travels.

The emission peak wavelength (maximum emission wavelength, or maximum emission peak wavelength) of the first light may be in the range of about 520 nm to about 550 nm.

For example, the emission peak wavelength of the first light may be in the range of about 520 nm to about 545 nm, about 520 nm to about 540 nm, about 520 nm to about 535 nm, about 525 nm to about 550 nm, about 525 nm to about 545 nm, about 525 nm to about 540 nm, or about 525 nm to about 535 nm.

A full width at half maximum (FWHM) of the first light may be in the range of about 15 nm to about 60 nm.

For example, the FWHM of the first light may be in the range of about 20 nm to about 60 nm, about 25 nm to about 60 nm, about 30 nm to about 60 nm, about 35 nm to about 60 nm, about 40 nm to about 60 nm, about 45 nm to about 60 nm, about 50 nm to about 60 nm, or about 55 nm to about 60 nm.

The emission peak wavelength (or maximum emission wavelength) and FWHM of the first light described in the present disclosure may be evaluated from the emission spectrum of a film including the first emitter (for example, see Evaluation Example 2). The emission peak wavelength in the present disclosure refers to the peak wavelength having the maximum emission intensity in the emission spectrum or electroluminescence spectrum.

The first light having the emission peak wavelength and FWHM as described above may be green light.

The first emitter may include iridium.

In an embodiment, the first emitter may be an organometallic compound containing iridium. The first emitter may be neutral, may include one iridium, and may not include (e.g., may exclude) transition metals other than iridium.

In an embodiment, the first emitter may include, in addition to the iridium, a first ligand, a second ligand, and a third ligand, each of which is coupled to the iridium. In this regard, the first ligand may be a bidentate ligand including $Y_1$-containing ring B, and $Y_2$-containing ring $B_2$, the second ligand may be a bidentate ligand including $Y_3$-containing ring $B_3$ and $Y_4$-containing ring $B_4$, the third ligand may be a bidentate ligand including $Y_5$-containing ring $B_5$ and $Y_6$-containing ring $B_5$, $Y_1$, $Y_3$, and $Y_5$ may each be nitrogen(N),$Y_2$, $Y_4$, and $Y_6$ may each be carbon(C), and $Y_2$-containing ring $B_2$ and $Y_4$-containing ring $B_4$ may be different from each other.

In one or more suitable embodiments, the $Y_2$-containing ring $B_2$ may be a polycyclic group. For example, the $Y_2$-containing ring $B_2$ may be a polycyclic group in which three or more a monocyclic group are condensed with each other. In an embodiment, the $Y_2$-containing ring $B_2$ may be a polycyclic group in which one 5-membered monocyclic group (for example, a furan group, a thiophene group, a selenophene group, a pyrrole group, a cyclopentadiene group, a silole group, etc.) is condensed with at least two 6-membered monocyclic groups (for example, a benzene group, a pyridine group, a pyrimidine group, a pyrazine group, a pyridazine group, etc.).

In an embodiment, the $Y_4$-containing ring $B_4$ may be a monocyclic group. For example, the $Y_4$-containing ring $B_4$ may be a 6-membered monocyclic group (for example, a benzene group, a pyridine group, a pyrimidine group, a pyrazine group, a pyridazine group, etc.).

In an embodiment, the first emitter may be a heteroleptic complex.

In an embodiment, the third ligand may be identical to the second ligand.

In an embodiment, the third ligand may be identical to the first ligand.

In an embodiment, the third ligand may be different from each of the first ligand and the second ligand.

More details for the first emitter are as described herein.

The capping layer is in a path on which the first light travels and is extracted to the outside of the light-emitting device, thereby increasing the external extraction rate of the first light.

The capping layer may include an amine-free compound. The amine-free compound does not include "amine". The "amine" in the amine-free compound refers to a group represented by,

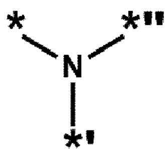

wherein *, *', and *" indicate binding sites to neighboring atoms $A_1$, $A_2$ and $A_3$, respectively, and each of $A_1$, $A_2$, and $A_3$ is not linked via a single bond or an any atom group therebetween. Each of $A_1$, $A_2$ and $A_3$ may be any atom, for example, carbon, hydrogen, and/or the like. For example, Compound 40 belongs to the amine-free compound described herein.

In an embodiment, the amine-free compound included in the capping layer may include three $C_1$-$C_{60}$ cyclic groups or more (for example, 4 or more, or 5 or more) which are linked to each other only via a single bond, not via an atom. The $C_1$-$C_{60}$ cyclic group may include a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$ which are described herein.

For example, Compounds 15 and 40 belonging to the amine-free compound do not include "amine" as defined herein. Additionally, Compound 15 contains 5 $C_1$-$C_{60}$ cyclic groups that are linked to each other only via a single bond, not an atom (refer to ring "1" to ring "5"), and Compound 40 contains 4 $C_1$-$C_{60}$ cyclic groups that are linked to each other only via a single bond, not an atom (refer to ring "1" to ring "4").

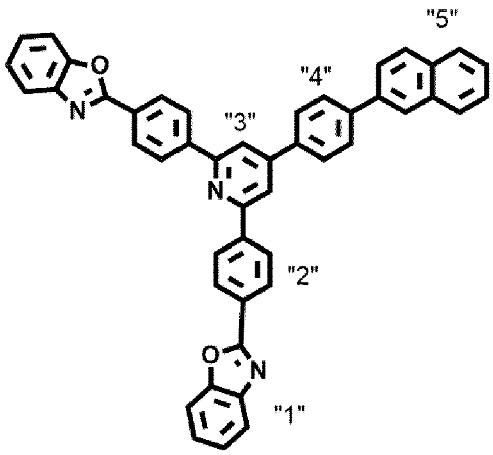

15

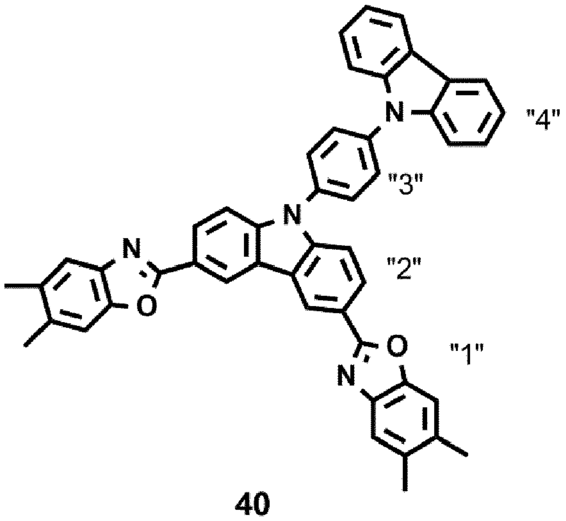

40

.

In contrast, Compound B01 utilized in Comparative Example 1 includes "amine" as defined herein, and therefore does not belong to the amine-free compound as defined herein. Additionally, in Compound B01, "N" exists between a benzene group represented by "b" and a carbazole group represented by "c". Accordingly, a benzene group represented by "a", the benzene group represented by "b", and the carbazole group represented by "c" do not belong to "three or more $C_1$-$C_{60}$ cyclic groups, linked to each other only via a single bond, not via an atom."

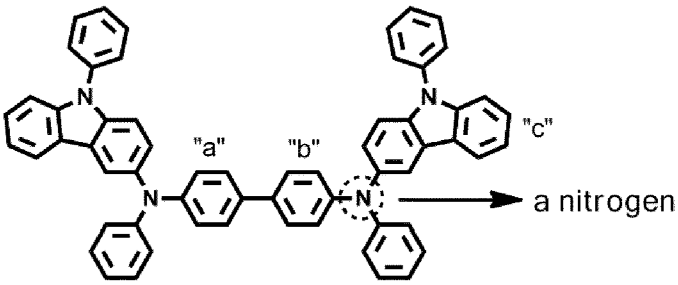


B01

.

In an embodiment, the amine-free compound included in the capping layer may include at least one $\pi$ electron-deficient nitrogen-containing $C_1$-$C_{60}$ cyclic group. The $\pi$ electron-deficient nitrogen-containing $C_1$-$C_{60}$ cyclic group may be, for example, a pyridine group, a pyrimidine group, a pyrazine group, a pyridazine group, a triazine group, a quinoline group, an isoquinoline group, a quinoxaline group, a benzquinoline group, a benzisoquinoline group, a benzquinoxaline group, a benzoxazole group, a benzthiazole group, a naphthooxazole group, or a naphthothiazole group.

In an embodiment, the amine-free compound included in the capping layer may include a benzoxazole group, a benzthiazole group, a naphthooxazole group, a naphthothiazole group, or one or more combinations thereof.

The amine-free compound is the same as described in the present disclosure.

The value of ratio of CIEy to reflective index (RCR value) of the first light extracted to the outside through the capping layer may be 38 or less. In this regard, the RCR value can be calculated by Equation 1:

**Equation 1**

$$CIEy/R(cap) \times 100$$

wherein, in Equation 1,

CIEy is the y coordinate value of the CIE color coordinates of the first light extracted to the outside through the capping layer, and

R(cap) is the refractive index of the amine-free compound with respect to second light having a wavelength of the emission peak wavelength of the first light ± 20 nm. For example, the R(cap) may be the refractive index of the amine-free compound with respect to second light having a wavelength of the emission peak wavelength of the first light ± 15 nm, the emission peak wavelength of the first light ±10 nm, or the emission peak wavelength of the first light ± 5 nm.

In an embodiment, the RCR value of the first light extracted through the capping layer may be 38 or less.

In an embodiment, the RCR value of the first light extracted through the capping layer may be 32.0 to 38.0, 32.5 to 38.0, 33.0 to 38.0, 33.5 to 38.0, 34.0 to 38.0, 34.5 to 38.0, 35.0 to 38.0, 35.5 to 38.0, 36.0 to 38.0, 32.0 to 37.5, 32.5 to 37.5, 33.0 to 37.5, 33.5 to 37.5, 34.0 to 37.5, 34.5 to 37.5, 35.0 to 37.5, 35.5 to 37.5, or 36.0 to 37.5.

When the emission peak wavelength of the first light is 520 nm to 550 nm, and the RCR value of the first light extracted to the outside through the capping layer satisfies the ranges as described above, the light-emitting device has excellent or suitable frontal (0°) luminescence efficiency and lateral luminescence efficiency (for example, at a location moved 45° from the front (0°)) at the same time (concurrently). By utilizing such a light-emitting device, a high-quality electronic apparatus may be manufactured.

In an embodiment, the CIEy may be 0.705 to 0.740, 0.705 to 0.735, 0.705 to 0.730, 0.710 to 0.740, 0.710 to 0.735, 0.710 to 0.730, 0.715 to 0.740, 0.715 to 0.735, 0.715 to 0.730, 0.720 to 0.740, 0.720 to 0.735, or 0.720 to 0.730.

The R(cap) may be evaluated by measuring the refractive index of a film including (e.g., consisting of) the amine-free compound (see, for example, Evaluation Example 3).

In an embodiment, the R(cap) may be the refractive index of the amine-free compound with respect to second light having a wavelength of 530 nm.

In an embodiment, the R(cap) may be 1.85 or more.

In an embodiment, R(cap) may be 1.85 or more, 1.85 to 2.5, 1.86 to 2.5, 1.87 to 2.5, 1.85 to 2.45, 1.86 to 2.45, 1.87 to 2.45, 1.85 to 2.4, 1.86 to 2.4, 1.87 to 2.4, 1.85 to 2.35, 1.86 to 2.35, 1.87 to 2.35, 1.85 to 2.3, 1.86 to 2.3, 1.87 to 2.3, 1.85 to 2.25, 1.86 to 2.25, 1.87 to 2.25, 1.85 to 2.2, 1.86 to 2.2, 1.87 to 2.2, 1.85 to 2.15, 1.86 to 2.15, 1.87 to 2.15, 1.85 to 2.1, 1.86 to 2.1, or 1.87 to 2.1.

According to an embodiment, the light-emitting device includes: a first electrode; a second electrode facing the first electrode; an interlayer which is between the first electrode and the second electrode and includes an emission layer; and a capping layer, wherein the emission layer includes a first emitter, the first emitter emits first light having a first emission spectrum, the capping layer is in the path on which (e.g., via or through which) the first light travels, the first emitter includes a first ligand, a second ligand, and a third ligand, each of which is bonded to the iridium, the first ligand is a bidentate ligand including $Y_1$-containing ring $B_1$ and $Y_2$-containing ring $B_2$, the second ligand is a bidentate ligand including $Y_3$-containing ring $B_3$ and $Y_4$-containing ring $B_4$, the third ligand is a bidentate ligand including Ys-containing ring $B_5$ and $Y_6$-containing ring $B_6$, each of $Y_1$, $Y_3$, and $Y_5$ is nitrogen (N), each of $Y_2$, $Y_4$, and $Y_6$ is carbon (C), and $Y_2$-containing ring $B_2$ and $Y_4$-containing ring $B_4$ are different from each other, the capping layer contains an amine-free compound, and the amine-free compound may include three $C_1$-$C_{60}$ cyclic groups or more (e.g., four or more or five or more $C_1$-$C_{60}$ cyclic groups) that are linked to each other only via a single bond, not via an atom.

The first light, the first emitter, and the amine-free compound may each independently be the same as described above.

In an embodiment, the $Y_2$-containing ring $B_2$ may be a polycyclic group.

In an embodiment, the emission peak wavelength of the first light may be in the range of about 520 nm to about 550 nm, about 520 nm to about 545 nm, about 520 nm to about 540 nm, about 520 nm to about 535 nm, about 525 nm to about 550 nm, about 525 nm to about 545 nm, about 525 nm to about 540 nm, about or 525 nm to about 535 nm.

In an embodiment, the FWHM of the first light may be in the range of about 20 nm to about 60 nm, about 25 nm to about 60 nm, about 30 nm to about 60 nm, about 35 nm to about 60 nm, about 40 nm to about 60 nm, about 45 nm to about 60 nm, about 50 nm to about 60 nm, or about 55 nm to about 60 nm.

The first light having the emission peak wavelength and FWHM as described above may be green light.

In an embodiment, the refractive index of the amine-free compound with respect to second light having a wavelength of the emission peak wavelength of the first light ± 20 nm (for example, second light having a wavelength of the emission peak wavelength of the first light ± 15 nm, a wavelength of the emission peak wavelength of the first light ± 10 nm, or a wavelength of the emission peak wavelength of the first light ± 5 nm) may be 1.85 or more, or in the range of 1.85 to 2.5, 1.86 to 2.5, 1.87 to 2.5, 1.85 to 2.45, 1.86 to 2.45, 1.87 to 2.45, 1.85 to 2.4, 1.86 to 2.4, 1.87 to 2.4, 1.85 to 2.35, 1.86 to 2.35, 1.87 to 2.35, 1.85 to 2.3, 1.86 to 2.3, 1.87 to 2.3, 1.85 to 2.25, 1.86 to 2.25, 1.87 to 2.25, 1.85 to 2.2, 1.86 to 2.2, 1.87 to 2.2, 1.85 to 2.15, 1.86 to 2.15, 1.87 to 2.15, 1.85 to 2.1, 1.86 to 2.1, or 1.87 to 2.1.

As described above, a light-emitting device concurrently (e.g., simultaneously) including i) an emission layer including iridium and a first emitter including a first ligand, a second ligand, and a third ligand, each of which is bonded to the iridium and ii) a capping layer including the amine-free compound, the amine-free compound including three or more $C_1$-$C_{60}$ cyclic groups which are linked to each other only via a single bond, not an atom, may have excellent or suitable frontal luminescence efficiency and excellent or suitable lateral luminescence efficiency at the same time (concurrently). Accordingly, by utilizing the light-emitting device, high-quality electronic apparatuses can be manufactured.

According to an embodiment, the light-emitting device includes: a first electrode; a second electrode facing the first electrode; an interlayer which is between the first electrode and the second electrode and includes an emission layer; and a capping layer, wherein the emission layer includes a first emitter, the first emitter emits first light having a first emission spectrum, the capping layer is in the path on which (e.g., via or through which) the first light travels, an emission peak wavelength of the first light is from about 520 nm to about 550 nm, the first emitter includes iridium, the capping layer contains an amine-free compound, and a refractive index of the amine-free compound with respect to second light having a wavelength of the range of the emission peak wavelength of the first light $\pm$ 20 nm is 1.85 or more. The first light, the first emitter, and the amine-free compound may each independently be the same as described above. Because the light-emitting device may have excellent or suitable frontal luminescence efficiency and lateral luminescence efficiency at the same time (concurrently), a high-quality electronic apparatus can be manufactured by utilizing such a light-emitting device.

In an embodiment, the first emitter may include at least one deuterium.

In an embodiment, the first emitter may include a deuterated $C_1$-$C_{20}$ alkyl group, a deuterated $C_3$-$C_{10}$ cycloalkyl group, or a combination thereof.

In an embodiment, at least one selected from the first ligand, the second ligand, and the third ligand may include at least one deuterium.

In an embodiment, at least one selected from the first ligand, the second ligand, and the third ligand may include a deuterated $C_1$-$C_{20}$ alkyl group, a deuterated $C_3$-$C_{10}$ cycloalkyl group, or a combination thereof.

In an embodiment, the highest occupied molecular orbital (HOMO) energy level of the first emitter may be in the range of -5.30 eV to -4.70 eV or -5.25 eV to -4.80 eV.

In an embodiment, the lowest unoccupied molecular orbital (LUMO) energy level of the first emitter may be in the range of -2.20 eV to -1.50 eV or -2.10 eV to -1.80 eV.

The HOMO and LUMO energy levels may be evaluated through cyclic voltammetry analysis (for example, Evaluation Example 1) of the organometallic compound.

In an embodiment, the triplet ($T_1$) energy of the first emitter may be 2.10 eV to 2.60 eV or 2.20 eV to 2.50 eV.

The evaluation method for the triplet energy of the first emitter may be understood by referring to, for example, Evaluation Example 2.

The emission layer may further include, in addition to the first emitter, a host, an auxiliary dopant, a sensitizer, a delayed fluorescence material, or one or more combinations thereof. Each of the host, the auxiliary dopant, the sensitizer, the delayed fluorescence material, or one or more combinations thereof may include at least one deuterium.

For example, the emission layer may include the first emitter and the host. The host may be different from the first emitter, and the host may include an electron-transporting compound, a hole-transporting compound, a bipolar compound, or one or more combinations thereof. The host may not include (e.g., may exclude) metal. The electron-transporting compound, the hole-transporting compound, and the bipolar compound are different from each other.

In an embodiment, the emission layer includes the first emitter and a host, and the host may include an electron-transporting compound and a hole-transporting compound. The electron-transporting compound and the hole-transporting compound may form an exciplex.

For example, the electron-transporting compound may include at least one $\pi$ electron-deficient nitrogen-containing $C_1$-$C_{60}$ cyclic group. For example, the electron-transporting compound may include a pyridine group, a pyrimidine group, a pyrazine group, a pyridazine group, a triazine group, or one or more combinations thereof.

In an embodiment, the hole-transporting compound may include at least one $\pi$ electron-rich $C_3$-$C_{60}$ cyclic group, a pyridine group, or a combination thereof, and may not include (e.g., may exclude) an electron transport group (for example, a $\pi$ electron-deficient nitrogen-containing $C_1$-$C_{60}$ cyclic group, a cyano group, a sulfoxide group, and/or a phosphine oxide group; in which a pyridine group is excluded from the foregoing listing).

In an embodiment, the following compounds may be excluded from the hole-transporting compound.

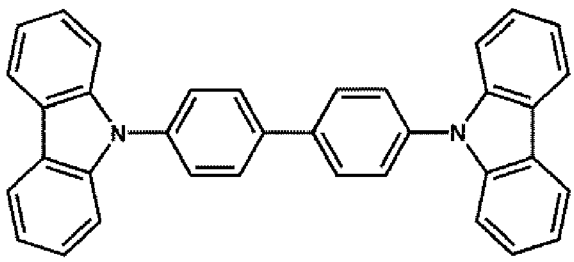

CBP

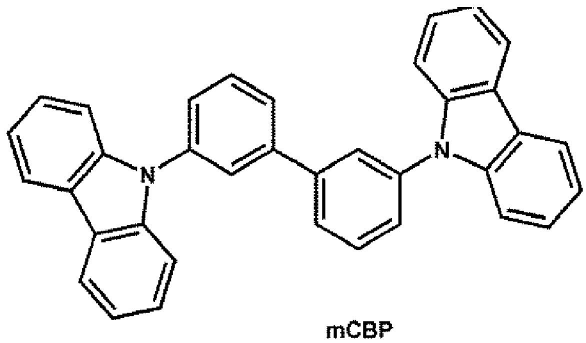

mCBP

.

In an embodiment, the electron-transporting compound may include a compound represented by Formula 2-1 or a compound represented by Formula 2-2:

Formula 2-1

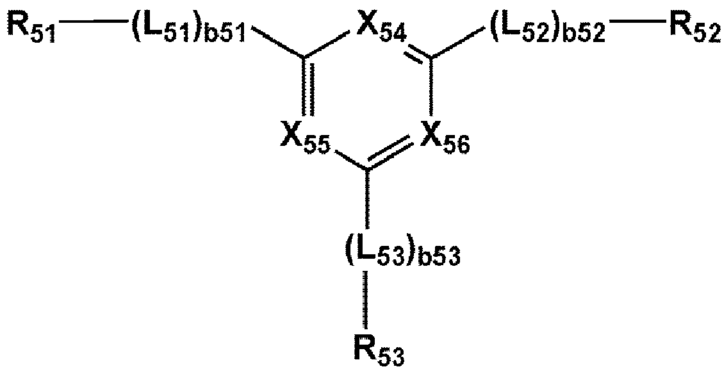

Formula 2-2

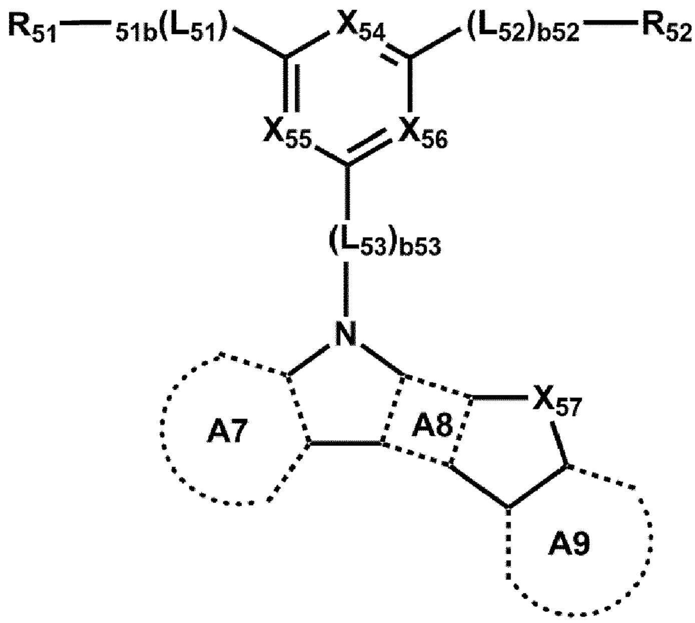

,

wherein, in Formulae 2-1 and 2-2,

$L_{51}$ to $L_{53}$ may each independently be a single bond, a $C_3$-$C_{60}$ carbocyclic group unsubstituted or substituted with

at least one $R_{10a}$, or a $C_1$-$C_{60}$ heterocyclic group unsubstituted or substituted with at least one $R_{10a}$,
b51 to b53 may each independently be an integer from 1 to 5,
A7 to A9 may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$ (for example, a benzene group or a naphthalene group, each unsubstituted or substituted with at least one $R_{10a}$),
$X_{54}$ is N or C($R_{54}$), $X_{55}$ is N or C($R_{55}$), $X_{56}$ is N or C($R_{56}$), and at least one of $X_{54}$ to $X_{56}$ is N,
$X_{57}$ may be O, S, N($R_{57}$), C($R_{57a}$)($R_{57b}$), or Si($R_{57a}$)($R_{57b}$), and
$R_{51}$ to $R_{57}$, $R_{57a}$, $R_{57b}$, and $R_{10a}$ are each the same as described above.

In an embodiment, the hole-transporting compound may include a compound represented by Formula 3-1, a compound represented by Formula 3-2, a compound represented by Formula 3-3, a compound represented by Formula 3-4, a compound represented by Formula 3-5, or one or more combinations thereof:

Formula 3-1

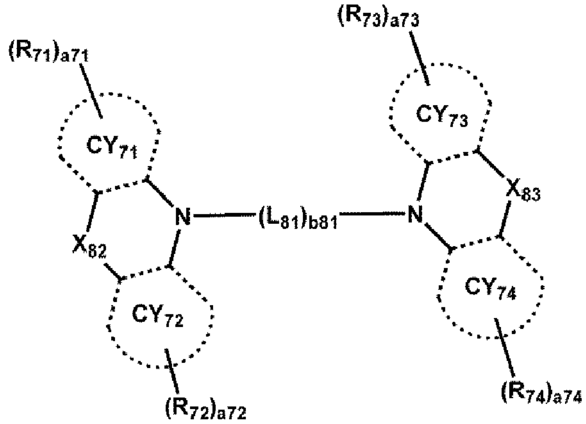

Formula 3-2

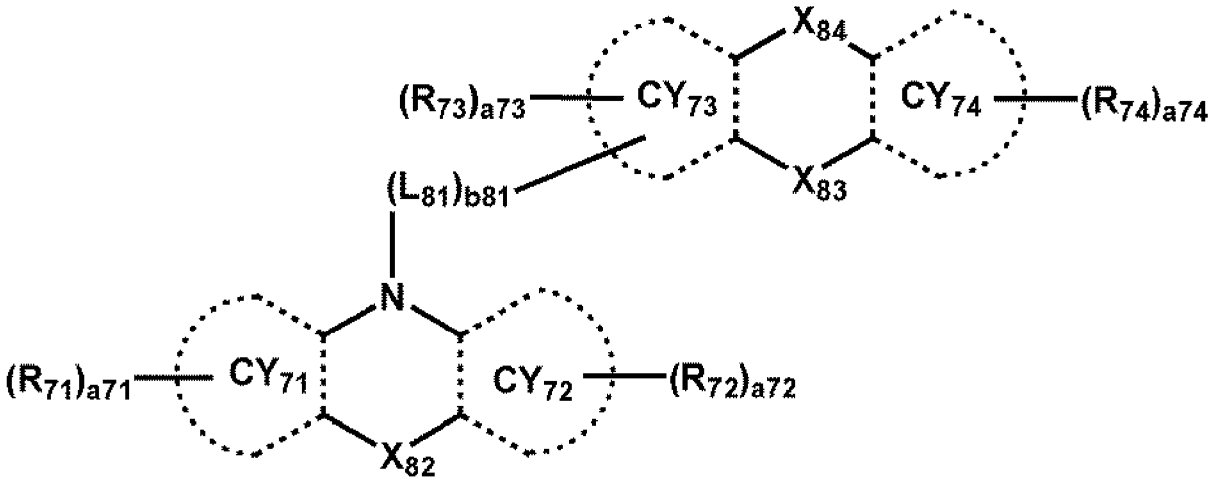

Formula 3-3

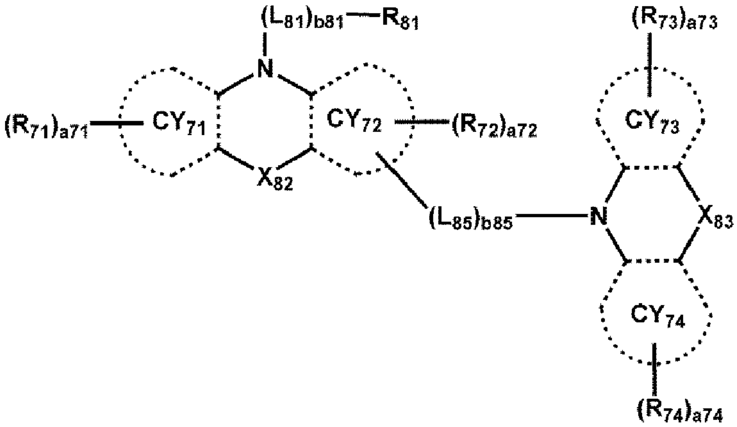

Formula 3-4

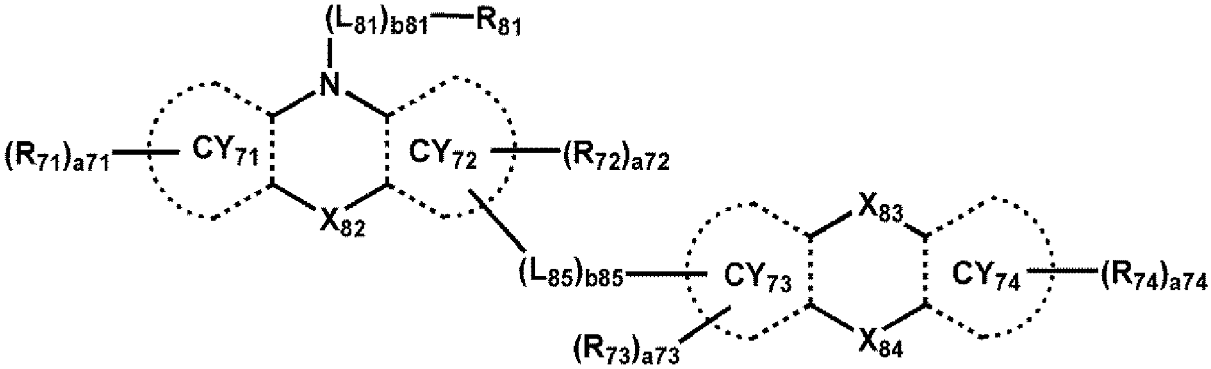

Formula 3-5

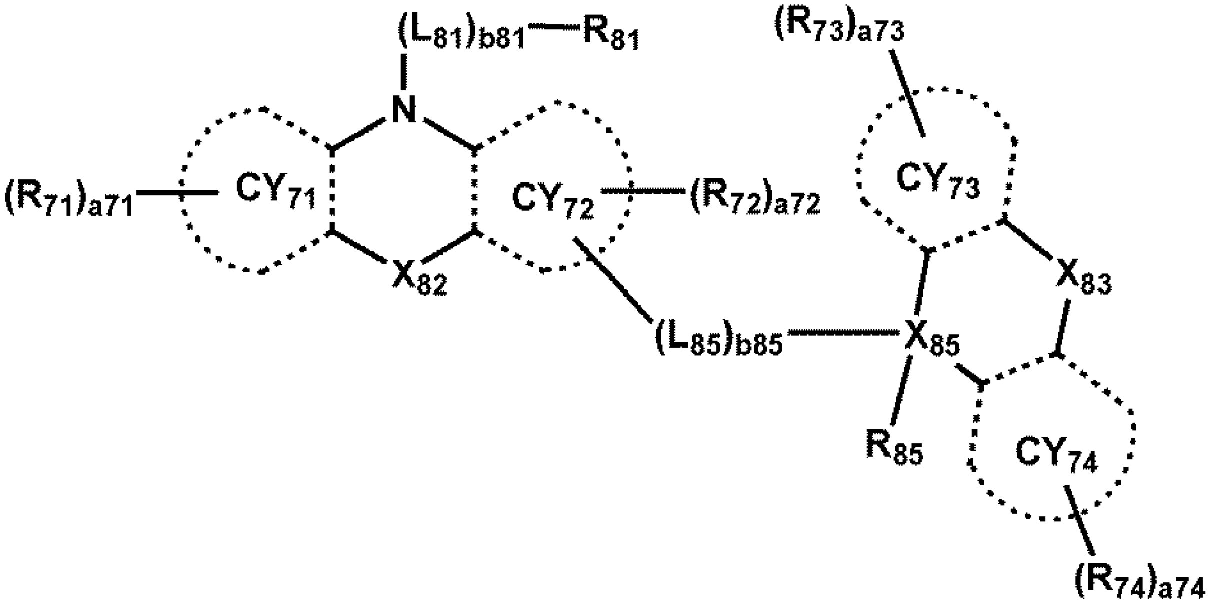

,

wherein, in Formulae 3-1 to 3-5,

ring $CY_{71}$ to ring $CY_{74}$ may each independently be a π electron-rich $C_3$-$C_{60}$ cyclic group (for example, a benzene group, a naphthalene group, a fluorene group, a anthracene group, a carbazole group, a dibenzofuran group, or a dibenzothiophene group), or a pyridine group,

$X_{82}$ may be a single bond, O, S, N-[$(L_{82})_{b82}$-$R_{82}$], C($R_{82a}$)($R_{82b}$), or Si($R_{82a}$)($R_{82b}$),

$X_{83}$ may be a single bond, O, S, N-[$(L_{83})_{b83}$-$R_{83}$], C($R_{83a}$)($R_{83b}$), or Si($R_{33a}$)($R_{33b}$),

$X_{84}$ may be O, S, N-[$(L_{84})_{b84}$-$R_{84}$], C($R_{84a}$)($R_{84b}$), or Si($R_{84a}$)($R_{84b}$),

$X_{85}$ may be C or Si,

$L_{81}$ to $L_{85}$ may each independently be a single bond, *-C($Q_4$)($Q_5$)-*', *-Si($Q_4$)($Q_5$)-*', a $\pi$ electron-rich $C_3$-$C_{60}$ cyclic group unsubstituted or substituted with at least one $R_{10a}$ (for example, a benzene group, a naphthalene group, a fluorene group, a anthracene group, a carbazole group, a dibenzofuran group, or a dibenzothiophene group, each unsubstituted or substituted with at least one $R_{10a}$), or a pyridine group unsubstituted or substituted with at least one $R_{10a}$, wherein $Q_4$ and $Q_5$ may each independently be the same as described in connection with $Q_1$,

b81 to b85 may each independently be an integer from 1 to 5,

$R_{71}$ to $R_{74}$, $R_{81}$ to $R_{85}$, $R_{82a}$, $R_{82b}$, $R_{83a}$, $R_{83b}$, $R_{84a}$, and $R_{84b}$ may each be the same as described herein,

a71 to a74 may each independently be an integer from 0 to 20, and

$R_{10a}$ may be understood by referring to the description of $R_{10a}$ provided herein.

The capping layer of the light-emitting device may be outside the first electrode and/or outside the second electrode.

In an embodiment, the light-emitting device may further include at least one selected from a first capping layer outside of the first electrode and a second capping layer outside of the second electrode, wherein at least one of the first capping layer or the second capping layer may include the amine-free compound described in the present disclosure.

In an embodiment, the light-emitting device may further include:

a first capping layer outside the first electrode and including the amine-free compound described in the present disclosure;

a second capping layer outside the second electrode and including the amine-free compound described in the present disclosure; or

the first capping layer and the second capping layer.

In an embodiment, the light-emitting device may further include a third capping layer, and the third capping layer may include a compound which is different from the amine-free compound described in the present disclosure. The third capping layer may be in a path on which the first light emitted from the first emitter travels.

In an embodiment, the third capping layer may include a material having a refractive index (at 589 nm) of 1.6 or more.

In an embodiment, the third capping layer may be an organic capping layer including an organic material, an inorganic capping layer including an inorganic material, or an organic-inorganic composite capping layer including an organic material and an inorganic material.

For example, the third capping layer may include a carbocyclic compound, a heterocyclic compound, an amine group-containing compound, a porphine derivative, a phthalocyanine derivative, a naphthalocyanine derivative, an alkali metal complex, an alkaline earth-metal complex, or one or more combinations thereof. Optionally, the carbocyclic compound, the heterocyclic compound, and the amine group-containing compound may be substituted with a substituent including O, N, S, Se, Si, F, Cl, Br, I, or one or more combinations thereof.

For example, the third capping layer may include a compound represented by Formula 201, a compound represented by Formula 202, or a combination thereof.

In an embodiment, the third capping layer may include at least one of the Compounds HT28 to HT33, at least one of Compounds CP1 to CP6 (CP3 is the same as B02 in this disclosure), $\beta$-NPB, or one or more compounds thereof:

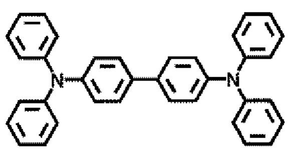

CP1

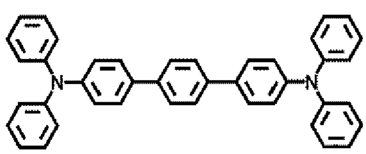

CP2

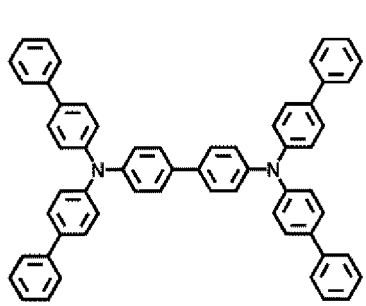

CP3

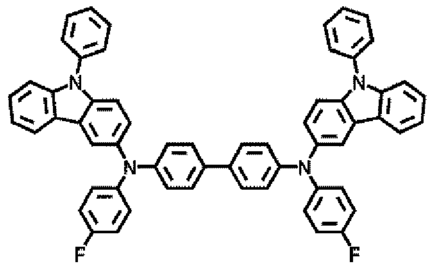

CP4

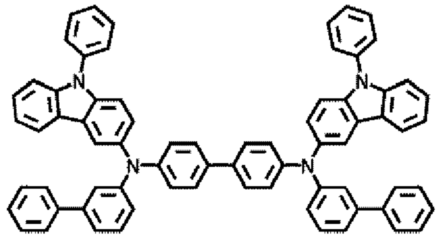

CP5

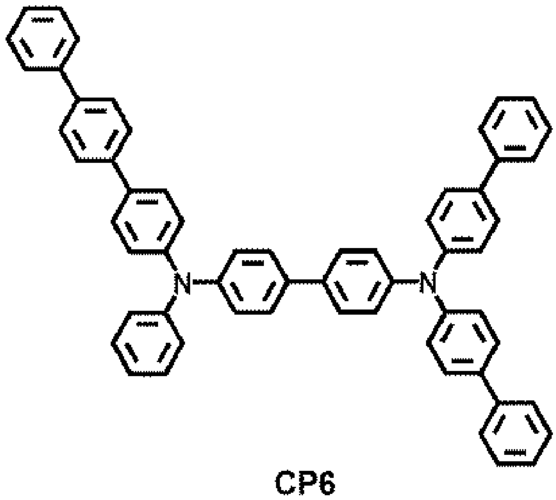

CP6

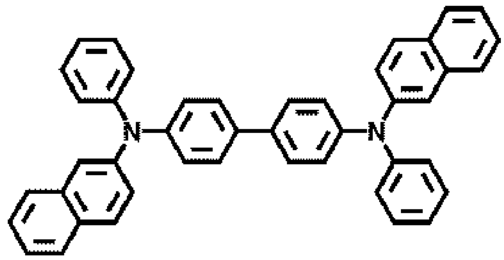

β-NPB .

In one or more embodiments, the light-emitting device may further include:

i) a structure in which the first electrode, the interlayer, the second electrode, and the second capping layer (including the amine-free compound described in the present disclosure) are sequentially stacked;
ii) a structure in which the first electrode, the interlayer, the second electrode, the third capping layer (containing a compound different from the amine-free compound described in the present disclosure), and the second capping layer (including the amine-free compound described in the present disclosure) are sequentially stacked, or
iii) a structure in which the first electrode, the interlayer, the second electrode, the second capping layer (including the amine-free compound described in the present disclosure), and the third capping layer (containing a compound different from the amine-free compound described in the present disclosure) are sequentially stacked.

In this regard, the first light emitted from the first emitter of the emission layer included in the interlayer may be extracted to the outside of the light-emitting device through the second electrode and then the second capping layer (or the second capping layer and the third capping layer), and the second electrode may be a semi-transmissive electrode or a transmissive electrode.

The wording "the interlayer (or, a capping layer) includes a first emitter (or an amine-free compound)" refers to "the interlayer (or a capping layer) may include one type or kind of a compound belonging to the category of the first emitter or two or more types (kinds) of different compounds belonging to the first emitter (or one type or kind of compound belonging to an amine-free compound or two or more different compounds belonging to an amine-free compound).

The term "interlayer" as utilized herein refers to a single layer and/or all of a plurality of layers between the first electrode and the second electrode of the light-emitting device.

An embodiment of the present disclosure provides an electronic apparatus including the light-emitting device. The electronic apparatus may further include a thin-film transistor. For example, the electronic apparatus may further include a thin-film transistor including a source electrode and a drain electrode, wherein the first electrode of the light-emitting device may be electrically connected to the source electrode or the drain electrode. In an embodiment, the electronic apparatus may further include a color filter, a color conversion layer, a touch screen layer, a polarizing layer, or one or more combinations thereof. For more details on the electronic apparatus, related descriptions provided herein may be referred to.

An embodiment of the present disclosure provides a consumer product including the light-emitting device.

For example, the consumer product may be one of a flat panel display, a curved display, a computer monitor, a medical monitor, a TV, a billboard, indoor or outdoor illuminations and/or signal light, a head-up display, a fully or partially transparent display, a flexible display, a rollable display, a foldable display, a stretchable display, a laser printer, a phone, a cell phone, a tablet, a phablet, a personal digital assistant (PDA), a wearable device, laptop computers, digital cameras, camcorders, viewfinders, micro displays, 3D displays, virtual or augmented reality displays, vehicles, a video wall including multiple displays tiled together, a theater or stadium screen, a phototherapy device, a signage etc.

**Description of Formulae**

The first emitter may be, for example, an organometallic compound represented by Formula 1. In some embodiments, the amine-free compound may be, for example, a compound represented by Formula 8:

**Formula 1** $Ir(L1)(L_2)(L_3)$

**Formula 8** $(CY_{100})\text{-}[(Ar_0)_{x0}\text{-}Z_0]_m$

wherein, in Formula 1,

$L_1$ is a first ligand which is bonded to Ir of Formula 1, and is represented by Formula 1-1,
$L_2$ is a second ligand which is bonded to Ir of Formula 1, and is represented by Formula 1-2, and
$L_3$ is a third ligand which is bonded to Ir of Formula 1, and is represented by Formula 1-3:

Formula 1-1

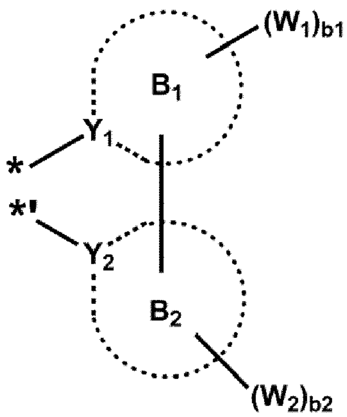

Formula 1-2

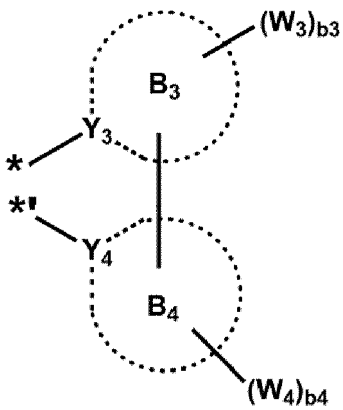

Formula 1-3

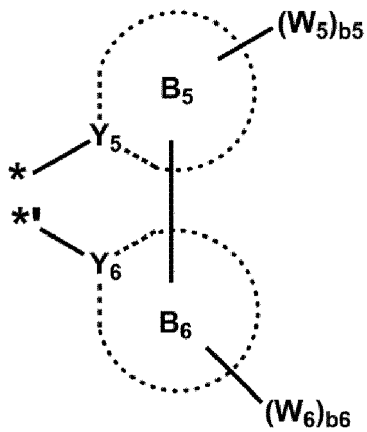

,

wherein, in Formulae 1-1 to 1-3, and 8,

each of $Y_1$, $Y_3$, and $Y_5$ is nitrogen (N),
each of $Y_2$, $Y_4$, and $Y_6$ is carbon (C),
ring $B_1$ to ring $B_6$ may each independently be a $C_3$-$C_{60}$ carbocyclic group or a $C_1$-$C_{60}$ heterocyclic group, and the $Y_2$-containing ring $B_2$ of Formula 1-1 is different from the $Y_4$-containing ring $B_4$ of Formula 1-2,
ring $CY_{100}$, $Ar_0$, and $Z_0$ may each independently be a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
x0 may be an integer from 0 to 10,
when x0 is 0, $*\text{-}(Ar_0)_{x0}\text{-}*'$ may be a single bond,
m may be an integer from 1 to 10, wherein, when m is 2 or more, two or more of a group represented by $*\text{-}(Ar_0)_{x0}\text{-}Z_0$ may be identical to or different from each other,
$W_1$ to $W_6$ may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, a $C_7$-$C_{60}$ arylalkyl group unsubstituted or substituted with at least one $R_{10a}$, a $C_2$-$C_{60}$ heteroarylalkyl group unsubstituted or substituted with at least one $R_{10a}$ $-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or $-P(=O)(Q_1)(Q_2)$,
b1 to b6 may each independently be an integer from 0 to 20,
* and *' in Formulae 1-1 to 1-3 may each indicate a binding site to Ir in Formula 1,
Each of i) two groups of $W_1$(s) in the number of b1, ii) two groups of $W_2$(s) in the number of b2, iii) two groups of $W_3$(s) in the number of b3, iv) two groups of $W_4$(s) in the number of b4, v) two groups of $W_5$(s) in the number of b5, and vi) two groups of $W_6$(s) in the number of b6, may optionally be bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
$R_{10a}$ may be:

deuterium, -F, -Cl, -Br, -I, a hydroxyl group, a cyano group, or a nitro group,
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, $-P(=O)(Q_{11})(Q_{12})$, or one or more combinations thereof,
a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, or a $C_2$-$C_{60}$ heteroaryl alkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, $-Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$, or one or more combinations thereof; or
$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or $-P(=O)(Q_{31})(Q_{32})$,
wherein $Q_1$ to $Q_3$, $Q_{11}$ to $Q_{13}$, $Q_{21}$ to $Q_{23}$, and $Q_{31}$ to $Q_{33}$ may each independently be: hydrogen; deuterium; -F; -Cl; -Br; -I; a hydroxyl group; a cyano group; a nitro group; or a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or one or more combinations thereof.

In an embodiment, the organometallic compound represented by Formula 1 may be a heteroleptic complex.
In one or more embodiments, in Formula 1,

i) $L_3$ may be identical to $L_2$,
ii) $L_3$ may be identical to $L_1$, or
iii) $L_3$ may be different from each of $L_1$ and $L_2$.

In an embodiment, ring $B_1$, ring $B_3$, and ring $B_5$ may each independently be:

a pyridine group, a pyrimidine group, a pyrazine group, a pyridazine group, or a triazine group; or

a pyridine group, a pyrimidine group, a pyrazine group, a pyridazine group, or a triazine group, to which a cyclopentane group, a cyclohexane group, a norbornane group, a benzene group, a pyridine group, a pyrimidine group, a pyrazine group, a pyridazine group, a triazine group, a furan group, a thiophene group, a selenophene group, a pyrrole group, a cyclopentadiene group, a silole group, or one or more combinations thereof is condensed.

In an embodiment, ring $B_1$, ring $B_3$, and ring $B_5$ may each be a pyridine group.
In an embodiment, ring $B_1$, ring $B_3$, and ring $B_5$ may each independently be:

a benzene group, a pyridine group, a pyrimidine group, a pyrazine group, or a pyridazine group; or
a benzene group, a pyridine group, a pyrimidine group, a pyrazine group, or a pyridazine group, to which a cyclopentane group, a cyclohexane group, a norbornane group, a benzene group, a pyridine group, a pyrimidine group, a pyrazine group, a pyridazine group, a furan group, a thiophene group, a selenophene group, a pyrrole group, a cyclopentadiene group, a silole group, or one or more combinations thereof is condensed.

In an embodiment, ring $B_2$ may be a benzene group, a pyridine group, a pyrimidine group, a pyrazine group, or a pyridazine group, to which a cyclopentane group, a cyclohexane group, a norbornane group, a benzene group, a pyridine group, a pyrimidine group, a pyrazine group, a pyridazine group, a furan group, a thiophene group, a selenophene group, a pyrrole group, a cyclopentadiene group, a silole group, or one or more combinations thereof is condensed.
In an embodiment, ring $B_2$ may be a polycyclic group in which one selected from a furan group, thiophene group, a selenophene group, a pyrrole group, a cyclopentadiene group, and a silole group is condensed with at least two selected from a benzene group, a pyridine group, a pyrimidine group, a pyrazine group, and a pyridazine group.
In an embodiment, ring $B_2$ may be a dibenzofuran group, a dibenzothiophene group, a dibenzoselenophene group, a carbazole group, a fluorene group, a dibenzosilole group, a naphthobenzofuran group, a naphthobenzothiophene group, a naphthobenzoselenophene group, a benzocarbazole group, a benzofluorene group, a benzodibenzosilole group, a dinaphthofuran group, a dinaphthothiophene group, a dinaphthoselenophene group, a dibenzocarbazole group, a dibenzofluorene group, a dinaphthosilole group, a phenanthrenonbenzofuran group, a phenanthrenonbenzothiophene group, a phenanthrenobenzoselenophene group, a naphthocarbazole group, a naphthofluorene group, a phenanthrenobenzosilole group, an azadibenzofuran group, an azadibenzothiophene group, an azadibenzoselenophene group, an azacarbazole group, an azafluorene group, an azadibenzosilole group, an azanaphthobenzofuran group, an azanaphthobenzothiophene group, an azanaphthobenzoselenophene group, an azabenzocarbazole group, an azabenzofluorene group, an azabenzodibenzosilole group, an azadinaphthofuran group, an azadinaphthothiophene group, an azadinaphthoselenophene group, an azadibenzocarbazole group, an azadibenzofluorene group, an azadinaphthosilole group, an azaphenanthrenonbenzofuran group, an azaphenanthrenonbenzothiophene group, an azaphenanthrenobenzoselenophene group, an azanaphthocarbazole group, an azanaphthofluorene group, or an azaphenanthrenobenzosilole group.
In an embodiment, ring $B_2$ may be a dibenzofuran group, a dibenzothiophene group, a dibenzoselenophene group, a naphthobenzofuran group, a naphthobenzothiophene group, a naphthobenzoselenophene group, a dinaphthofuran group, a dinaphthothiophene group, a dinaphthoselenophene group, a phenanthrenonbenzofuran group, a phenanthrenonbenzothiophene group, a phenanthrenonbenzoselenophene group, an azadibenzofuran group, an azadibenzothiophene group, an azadibenzoselenophene group, an azanaphthobenzofuran group, an azanaphthobenzothiophene group, an azanaphthobenzoselenophene group, an azadinaphthofuran group, an azadinaphthothiophene group, an azadinaphthoselenophene group, an azaphenanthrenonbenzofuran group, an azaphenanthrenonbenzothiophene group, or an azaphenanthrenonbenzoselenophene group.
In an embodiment, ring $B_4$ may be a benzene group, a pyridine group, a pyrimidine group, a pyrazine group, or a pyridazine group.
In an embodiment, ring $B_6$ may be a benzene group, a pyridine group, a pyrimidine group, a pyrazine group, a pyridazine group, a dibenzofuran group, a dibenzothiophene group, a dibenzoselenophene group, a carbazole group, a fluorene group, a dibenzosilole group, a naphthobenzofuran group, a naphthobenzothiophene group, a naphthobenzoselenophene group, a benzocarbazole group, a benzofluorene group, a benzodibenzosilole group, a dinaphthofuran group, a dinaphthothiophene group, a dinaphthoselenophene group, a dibenzocarbazole group, a dibenzofluorene group, a dinaphthosilole group, a phenanthrenonbenzofuran group, a phenanthrenonbenzothiophene group, a phenanthrenonbenzoselenophene group, a naphthocarbazole group, a naphthofluorene group, a phenanthrenobenzosilole group, an azadibenzofuran group, an azadibenzothiophene group, an azadibenzoselenophene group, an azacarbazole group, an azafluorene group, an azadibenzosilole group, an azanaphthobenzofuran group, an azanaphthobenzothiophene group, an azanaphthobenzoselenophene group, an azabenzocarbazole group, an azabenzofluorene group, an azabenzodibenzosilole group, an azadinaphthofuran group, an azadinaphthothiophene group, an azadinaphthoselenophene group, an azadibenzocarbazole group, an azadibenzofluorene group, an azadinaphthosilole group, an azaphenanthrenonbenzofuran group, an azaphenanthrenonbenzothiophene group, an azaphenanthrenonbenzoselenophene group, an azanaphthocarbazole group, an azanaphthofluorene group, or an azaphenanthrenobenzosilole group.

In an embodiment, ring $CY_{100}$ in Formula 8 may be a benzene group, a pyridine group, a pyrimidine group, a pyrazine group, a pyridazine group, a triazine group, a carbazole group, an acridine group, a phenoxazine group, or a phenothiazine group, each unsubstituted or substituted with at least one $R_{10a}$.

In an embodiment, $Ar_0$ and $Z_0$ in Formula 8 may each independently be a benzene group, a naphthalene group, a phenanthrene group, a pyridine group, a pyrimidine group, a pyrazine group, a pyridazine group, a triazine group, a carbazole group, a benzocarbazole group, a dibenzocarbazole group, a naphthocarbazole group, a dinaphthocarbazole group, a dibenzofuran group, a naphthobenzofuran group, a dinaphthofuran group, a dibenzothiophene group, a naphthobenzothiophene group, a dinaphthothiophene group, a benzoxazole group, a benzthiazole group, a naphthooxazole group, or a naphthothiazole group, each unsubstituted or substituted with at least one $R_{10a}$.

For example, at least one of $Z_0$(s) in the number of m in Formula 8 may each independently be a benzoxazole group, a benzthiazole group, a naphthooxazole group, or a naphthothiazole group, each unsubstituted or substituted with at least one $R_{10a}$. In this regard, $R_{10a}$ may be: deuterium; a $C_1$-$C_{20}$ alkyl group substituted or unsubstituted with at least one deuterium; a $C_3$-$C_{20}$ carbocyclic group, or a $C_1$-$C_{20}$ heterocyclic group, each unsubstituted or substituted with deuterium, a $C_1$-$C_{20}$ alkyl group, a $C_3$-$C_{20}$ carbocyclic group, a $C_1$-$C_{20}$ heterocyclic group, or one or more combinations thereof.

x0 in Formula 8 indicates the number of $Ar_0$(s), and may be, for example, 0, 1, 2, or 3.

m in Formula 8 indicates the number of a group represented by $*-(Ar_0)_{x0}-Z_0$, and may be an integer from 1 to 10. When m is 2 or more, two or more of groups represented by $*-(Ar_0)_{x0}-Z_0$ may be identical to or different from each other. For example, m may be 2, 3, or 4. In an embodiment, m may be 3.

In an embodiment, $W_1$ to $W_6$ in Formula 1 may each independently be:

hydrogen, deuterium, -F, or a cyano group;

a $C_1$-$C_{20}$ alkyl group or a $C_3$-$C_{10}$ cycloalkyl group, each unsubstituted or substituted with deuterium, -F, cyano group, or a combination thereof;

a phenyl group, a biphenyl group, a naphthyl group, a dibenzofuranyl group, or a dibenzothiophenyl group (or a thienyl group), each unsubstituted or substituted with deuterium, -F, cyano group, a $C_1$-$C_{20}$ alkyl group, a deuterated $C_1$-$C_{20}$ alkyl group, a fluorinated $C_1$-$C_{20}$ alkyl group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, a ($C_1$-$C_{20}$ alkyl)biphenyl group, or one or more combinations thereof; or

$-Si(Q_1)(Q_2)(Q_3)$.

In this regard, $Q_1$ to $Q_3$ are each the same as described above.

In an embodiment, at least one of $W_1$ to $W_6$ may include at least one deuterium.

In an embodiment, at least one of $W_1$ to $W_6$ may be a deuterated $C_1$-$C_{20}$ alkyl group, or a deuterated $C_3$-$C_{10}$ cycloalkyl group.

The term "biphenyl group" as utilized herein refers to a monovalent substituent having a structure in which two benzene groups are linked to each other through a single bond.

Examples of the $C_3$-$C_{10}$ cycloalkyl group as utilized herein are a cyclopentyl group, a cyclohexyl group, a cycloheptyl group, an adamantanyl group, a norbornanyl group, and/or the like.

The term "deuterated" utilized herein includes both (e.g., simultaneously) fully deuterated and partially deuterated.

The term "fluorinated" utilized herein includes both (e.g., simultaneously) fully fluorinated and partially fluorinated.

b1 to b6 in Formula 1 respectively indicate the numbers of $W_1$ to $W_6$, and for example, may be, each independently 0, 1, 2, 3, or 4. When b1 is 2 or more, two or more of $W_1$(s) may be identical to or different from each other, when b2 is 2 or more, two or more of $W_2$(s) may be identical to or different from each other, when b3 is 2 or more, two or more of $W_3$(s) may be identical to or different from each other, when b4 is 2 or more, two or more of $W_4$(s) may be identical to or different from each other, when b5 is 2 or more, two or more of $W_5$(s) may be identical to or different from each other, and when b6 is 2 or more, two or more of $W_6$(s) may be identical to or different from each other.

In an embodiment, the first emitter may be an organometallic compound represented by Formula 1A: **Formula 1A**

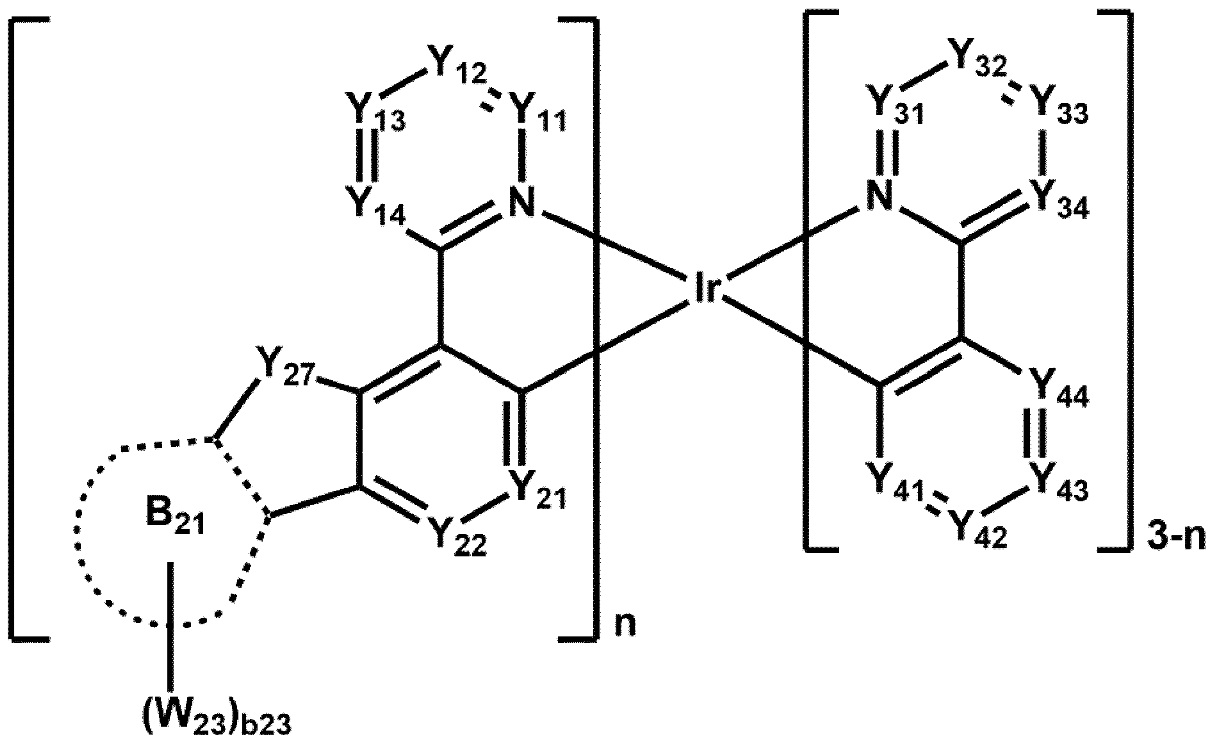

In an embodiment, the first emitter may be an organometallic compound represented by Formula 1A-1:

**Formula 1A-1**

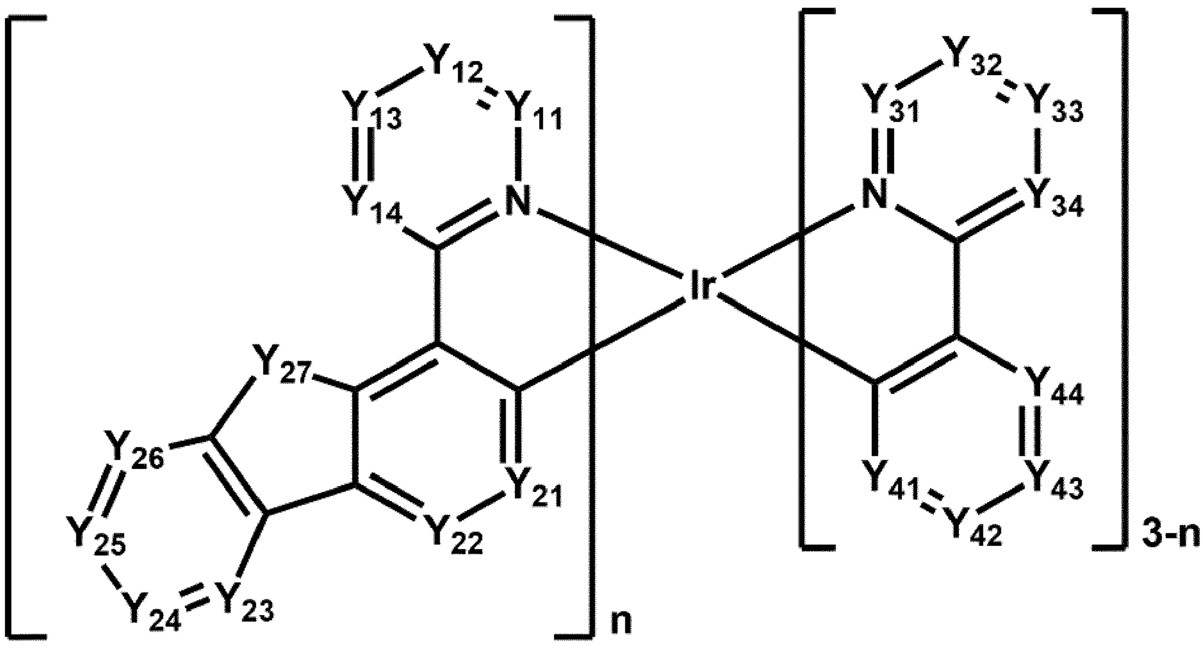

wherein, in Formulae 1A and 1A-1,

n may be 1 or 2,
ring $B_{21}$ may be a $C_3$-$C_{60}$ carbocyclic group or a $C_1$-$C_{60}$ heterocyclic group,
$Y_{11}$ may be $C(W_{11})$ or N, $Y_{12}$ may be $C(W_{12})$ or N, $Y_{13}$ may be $C(W_{13})$ or N, $Y_{14}$ may be $C(W_{14})$ or N, $Y_{21}$ may be $C(W_{21})$ or N, $Y_{22}$ may be $C(W_{22})$ or N, $Y_{23}$ may be $C(W_{23})$ or N, $Y_{24}$ may be $C(W_{24})$ or N, $Y_{25}$ may be $C(W_{25})$ or N, $Y_{26}$ may be $C(W_{26})$ or N, $Y_3$, may be $C(W_{31})$ or N, $Y_{32}$ may be $C(W_{32})$ or N, $Y_{33}$ may be $C(W_{33})$ or N, $Y_{34}$ may be $C(W_{34})$ or N, $Y_{41}$ may be $C(W_{41})$ or N, $Y_{42}$ may be $C(W_{42})$ or N, $Y_{43}$ may be $C(W_{43})$ or N, and $Y_{44}$ may be $C(W_{44})$ or N,

$Y_{27}$ may be O, S, Se, $N(W_{27})$, $C(W_{27a})(W_{27b})$, or $C(W_{27a})(W_{27b})$,
$W_{11}$ to $W_{14}$ are each the same as described in connection with $W_1$,
$W_{21}$ to $W_{27}$, $W_{27a}$, and $W_{27b}$ are each the same as described in connection with $W_2$,
b23 may be an integer from 0 to 20,
$W_{31}$ to $W_{34}$ are each the same as described in connection with $W_3$,
$W_{41}$ to $W_{44}$ are each the same as described in connection with $W_4$,
two or more of $W_{11}$ to $W_{14}$ may optionally be bonded to each other to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,
two or more selected from $W_{21}$ to $W_{27}$, and $W_{27a}$ and $W_{27b}$ may optionally be bonded to each other to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,
two or more of $W_{31}$ to $W_{34}$ may optionally be bonded to each other to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$, and
two or more of $W_{41}$ to $W_{44}$ may optionally be bonded to each other to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$.

Because n is 1 or 2 in Formula 1A and 1A-1, Formulae 1A and 1A-1 may correspond to an organometallic compound in which the third ligand in Formula 1 is the same as the second ligand or the first ligand.

In an embodiment, a ring $B_{21}$ in Formula 1A may be a benzene group, a naphthalene group, a phenanthrene group, an anthracene group, a pyridine group, a pyrimidine group, a pyrazine group, a pyridazine group, a quinoline group, an isoquinoline group, a quinoxaline group, a quinazoline group, a benzoquinoline group, a benzoisoquinoline group, a benzoquinoxaline group, or a benzoquinazoline group.

In an embodiment, ring $B_{21}$ in Formula 1A may be a pyridine group, a pyrimidine group, a pyrazine group, a pyridazine group, a quinoline group, an isoquinoline group, a quinoxaline group, a quinazoline group, a benzoquinoline group, a benzoisoquinoline group, a benzoquinoxaline group, or a benzoquinazoline group.

In an embodiment, at least one of $Y_{21}$ to$Y_{26}$ in Formula 1A-1 may be N.

In an embodiment, at least one of $Y_{23}$ to $Y_{26}$ in Formula 1A-1 may be N.

In an embodiment, $Y_{26}$ in Formula 1A-1 may be N.

In an embodiment, each of $Y_{21}$ to $Y_{25}$ in Formula 1A-1 may not be N, and $Y_{26}$ may be N.

In an embodiment, each of $Y_{11}$ to $Y_{14}$, $Y_{21}$, $Y_{22}$, $Y_{31}$ to $Y_{34}$ and $Y_{41}$ to $Y_{44}$ in Formula 1A and 1A-1 may not be N.

In an embodiment, a group represented by

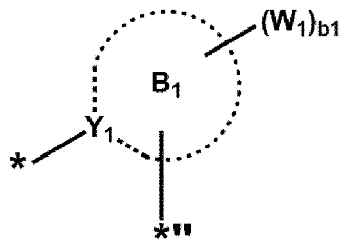

in Formula 1-1, a group represented by

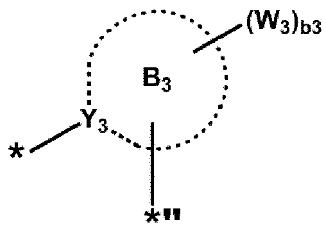

in Formula 1-2, a group represented by

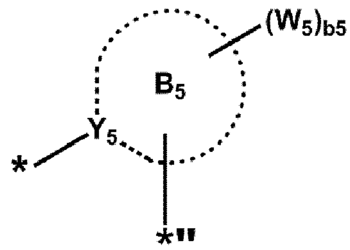

in Formula 1-3, a group represented by

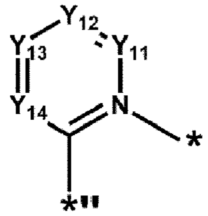

in Formulae 1A and 1A-1, and a group represented by

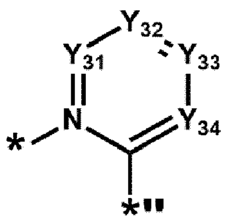

in Formulae 1A and 1A-1 may each independently be a group represented by one of Formulae BN-1 to BN-16:

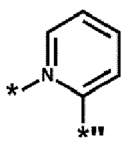
BN-1

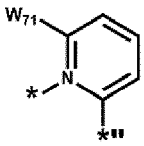
BN-2

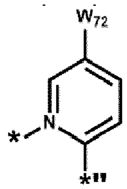
BN-3

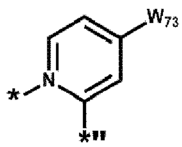
BN-4

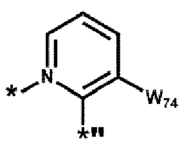
BN-5

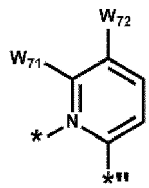
BN-6

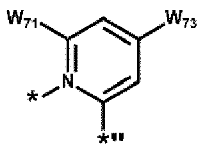
BN-7

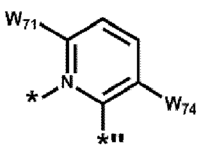
BN-8

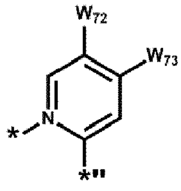
BN-9

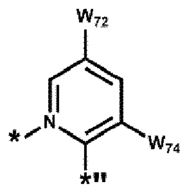
BN-10

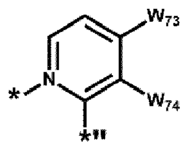
BN-11

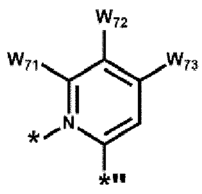
BN-12

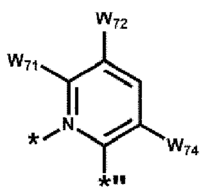
BN-13

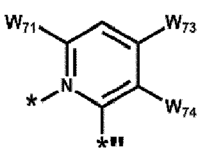
BN-14

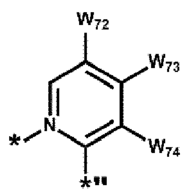
BN-15

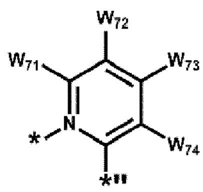
BN-16

wherein, in Formulae BN-1 to BN-16,

$W_{71}$ to $W_{74}$ are each the same as described in connection with $W_1$, $W_3$, or $W_5$, provided that each of $W_{71}$ to $W_{74}$ may not be hydrogen,
* indicates a binding site to iridium in Formulae 1, 1A, and 1A-1, and
*" indicates a binding site to a neighboring atom in Formulae 1, 1A, and 1A-1.

In an embodiment, a group represented by

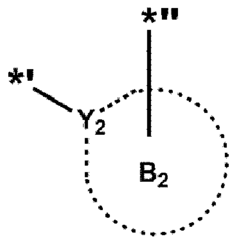

in Formula 1-1, a group represented by

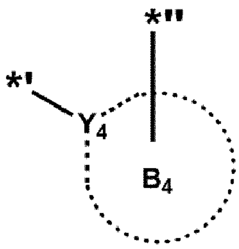

in Formula 1-2, and a group represented by

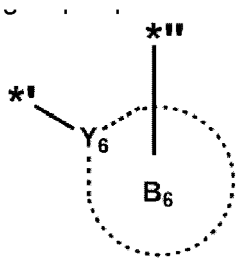

in Formula 1-3 may each independently be a group represented by one of Formulae BC-1 to BC-47:

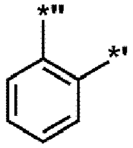
BC-1

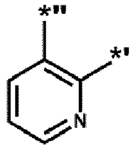
BC-2

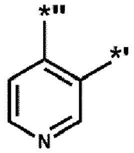
BC-3

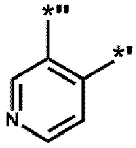
BC-4

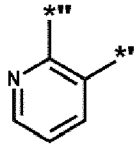
BC-5

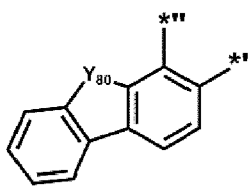
BC-6

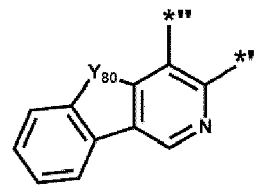
BC-7

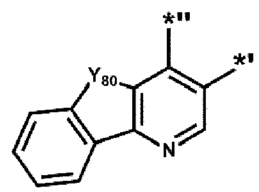
BC-8

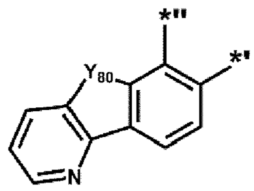
BC-9

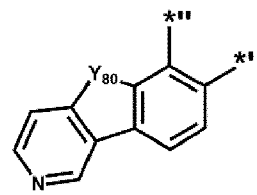
BC-10

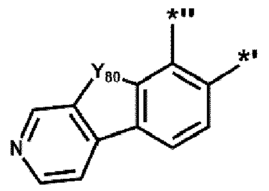
BC-11

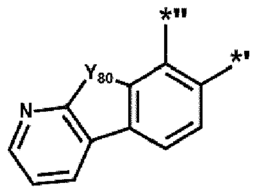
BC-12

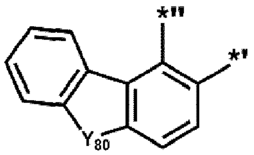
BC-13

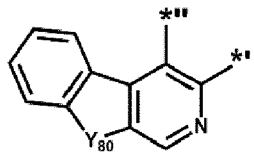
BC-14

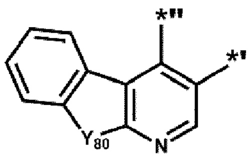
BC-15

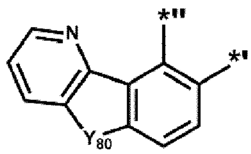
BC-16

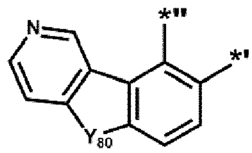
BC-17

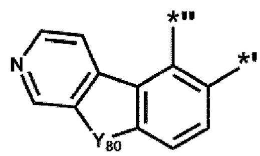
BC-18

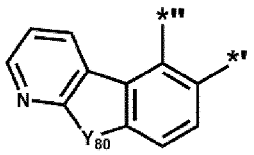
BC-19

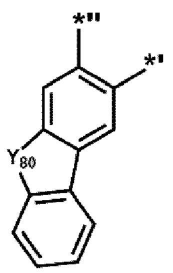
BC-20

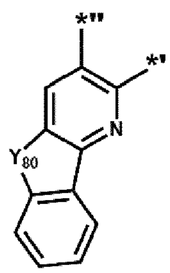
BC-21

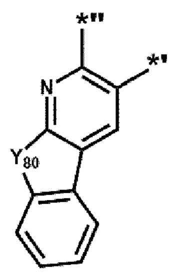
BC-22

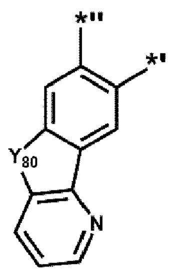
BC-23

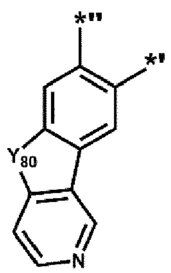
BC-24

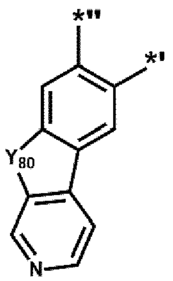
BC-25

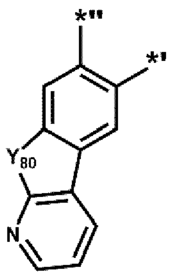
BC-26

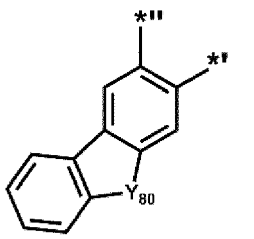
BC-27

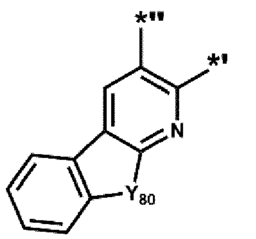
BC-28

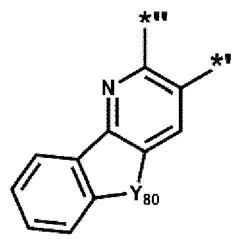
BC-29

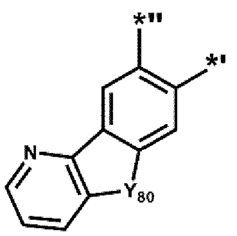
BC-30

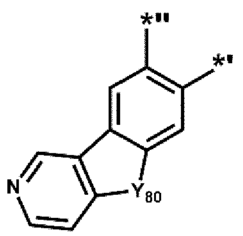
BC-31

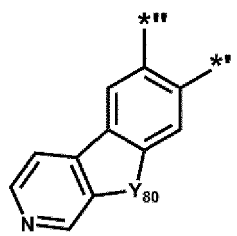
BC-32

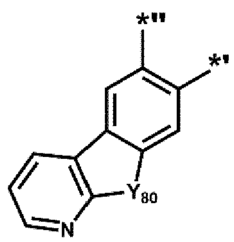
BC-33

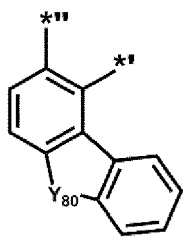
BC-34
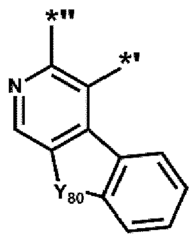
BC-35
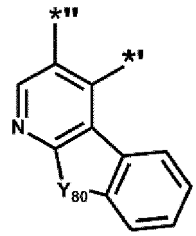
BC-36
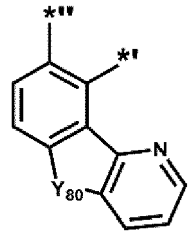
BC-37
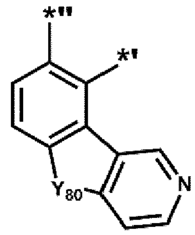
BC-38

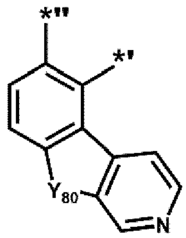
BC-39
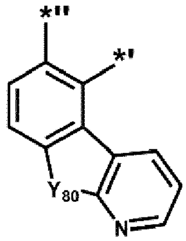
BC-40
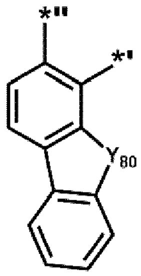
BC-41
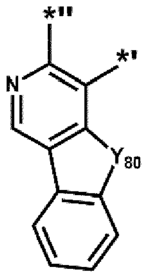
BC-42
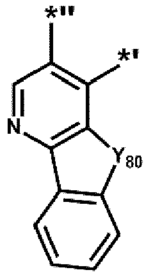
BC-43
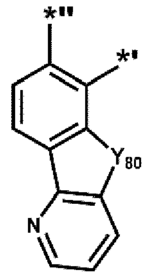
BC-44

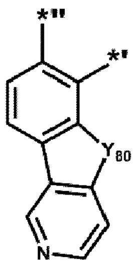
BC-45
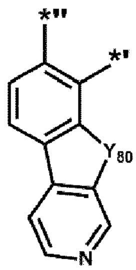
BC-46
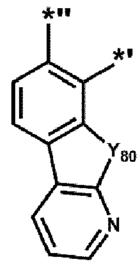
BC-47
,

wherein, in Formulae BC-1 to BC-47,

$Y_{80}$ may be O, S, Se, N(Wso), $C(W_{80a})(W_{80b})$, or $Si(W_{80a})(W_{80b})$,
$W_{80}$, $W_{80a}$, and $W_{80b}$ are each the same as described in connection with $W_2$, $W_4$, or $W_6$,
*' indicates a binding site to iridium in Formula 1, and
*" indicates a binding site to a neighboring atom in Formula 1.

Formulae BC-1 to BC-47 may be substituted or unsubstituted with $W_2$, $W_4$, or $W_6$ as described above, and may be understood with reference to the structures of Formulae 1-1, 1-2, and 1-3.

In an embodiment, a group represented by

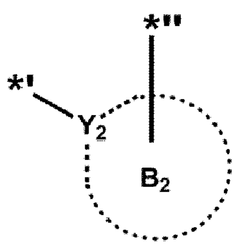

in Formula 1-1 may be one of Formulae BC-6 to BC-47.

In an embodiment, a group represented by

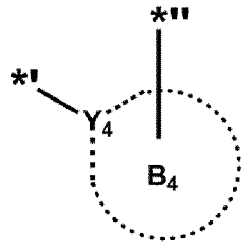

in Formula 1-2 may be represented by one of Formulae BC-1 to BC-5.

In an embodiment, the amine-free compound may be a compound represented by Formula 8-1 or 8-2:

Formula 8-1

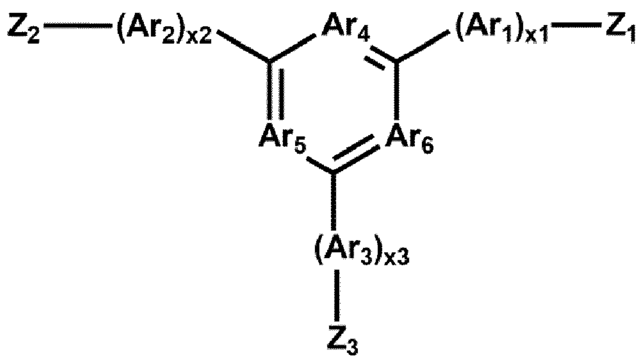

Formula 8-2

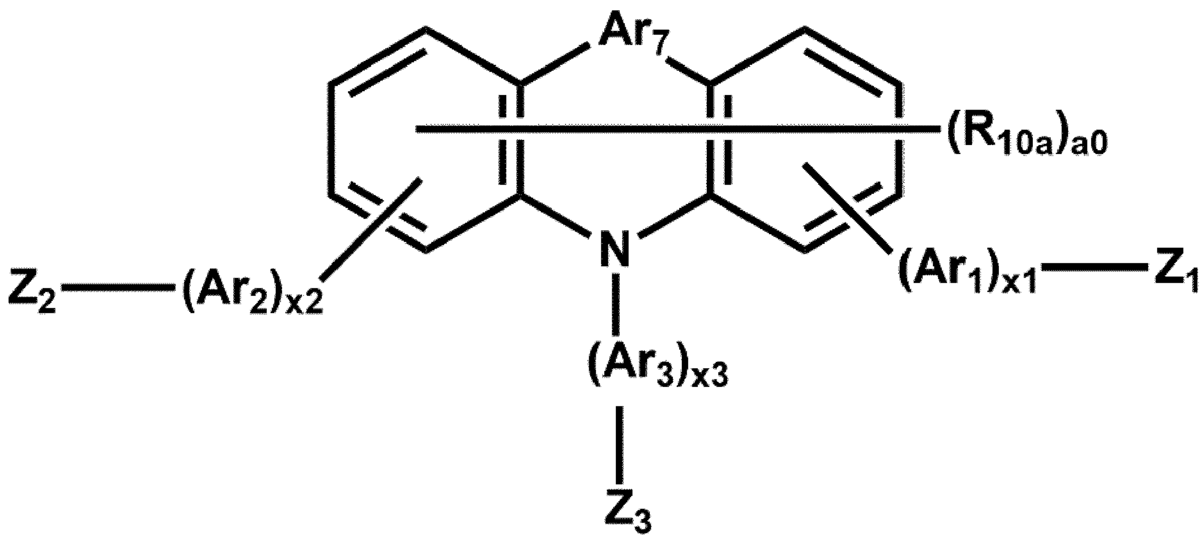

wherein, in Formulae 8-1 and 8-2,

$Ar_1$ to $Ar_3$, x1 to x3, and $Z_1$ to $Z_3$ may each independently be the same as described in connection with $Ar_0$, $x_0$, and $Z_0$, respectively,

$R_{10a}$ may be understood by referring to the description of $R_{10a}$ provided herein, and

$Ar_4$ may be N, C(H), or C($Z_4$), $Ar_5$ may be N, C(H), or C($Z_5$), $Ar_6$ may be N, C(H), or C($Z_6$), $Ar_7$ may be a single bond, O, S, N($Z_7$), or C($Z_{7a}$)($Z_{7b}$), and $Z_4$ to $Z_7$, $Z_{7a}$, and $Z_{7b}$ are each the same as described in connection with $R_{10a}$, and

a0 may be an integer from 0 to 6.

For example, a compound represented by Formula 8-2 may be a compound represented by Formula 8-2A:

Formula 8-2A

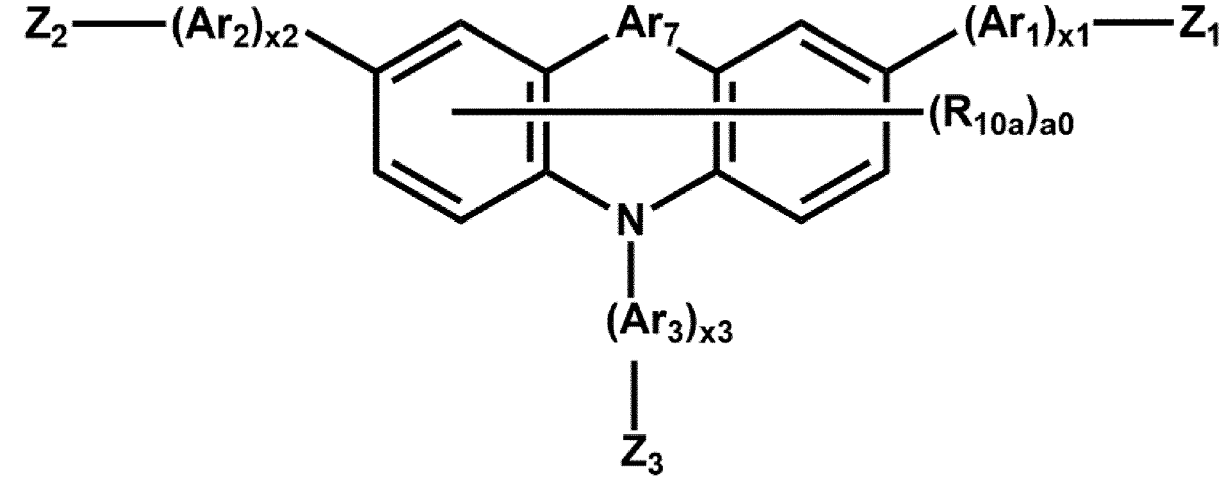

$Ar_1$ to $Ar_3$, x1 to x3, $Z_1$ to $Z_3$, and $Ar_7$ in Formula 8-2 are each the same as described above. b51 to b53 in Formulae 2-1 and 2-2 indicate numbers of $L_{51}$ to $L_{53}$, respectively, and may each be an integer from 1 to 5. When b51 is 2 or more, two or more of $L_{51}$(s) may be identical to or different from each other, when b52 is 2 or more, two or more of $L_{52}$(s) may be identical to or different from each other, and when b53 is 2 or more, two or more of $L_{53}$(s) may be identical to or different from each other. In an embodiment, b51 to b53 may each independently be 1 or 2.

$L_{51}$ to $L_{53}$ in Formulae 2-1 and 2-2 may each independently be

a single bond; or

a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, a oxazole group, a isoxazole group, a thiazole group, an isothiazole group, an oxadiazole group, a thiadiazole group, a benzopyrazole group, a benzimidazole group, a benzoxazole group, a benzothiazole group, a benzooxadiazole group, a benzothiadiazole group, a dibenzooxasiline group, a dibenzothiasiline group, a dibenzodihydroazasiline group, a dibenzodihydrodisiline group, a dibenzodihydrosiline group, a dibenzodioxine group, a dibenzooxathiine group, a dibenzooxazine group, a dibenzopyran group, a dibenzodithiine group, a dibenzothiazine group, a dibenzothiopyran group, a dibenzocyclohexadiene group, a dibenzodihydropyridine group, a dibenzodihydropyrazine group, an indolocarbazole group, an indolodibenzofuran group, or an indolodibenzothiophene group, each unsubstituted or substituted with deuterium, -F, -Cl, -Br, -I, a hydroxyl group, a cyano group, a nitro group, a $C_1$-$C_{20}$ alkyl group, a $C_1$-$C_{20}$ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, $-O(Q_{31})$, $-S(Q_{31})$, $-Si(Q_{31})(Q_{32})(Q_{33})$, $-N(Q_{31})(Q_{32})$, $-B(Q_{31})(Q_{32})$, $-P(Q_{31})(Q_{32})$, $-C(=O)(Q_{31})$, $-S(=O)_2(Q_{31})$, $-P(=O)(Q_{31})(Q_{32})$, or one or more combinations thereof,

wherein $Q_{31}$ to $Q_{33}$ may each independently be hydrogen, deuterium, a $C_1$-$C_{20}$ alkyl group, a $C_1$-$C_{20}$ alkoxy group, a phenyl group, a biphenyl group, a terphenyl group, a pyridinyl group, a pyrimidinyl group, a pyridazinyl group, a pyrazinyl group, or a triazinyl group.

In Formulae 2-1 and 2-2, $X_{54}$ may be N or $C(R_{54})$, $X_{55}$ may be N or $C(R_{55})$, $X_{56}$ may be N or $C(R_{56})$, and at least one of $X_{54}$ to $X_{56}$ may be N. $R_{54}$ to $R_{56}$ may each independently be the same as described above. In an embodiment, two or three of $X_{54}$ to $X_{56}$ may be N.

$R_{51}$ to $R_{57}$, $R_{57a}$, $R_{57b}$, $R_{71}$ to $R_{74}$, $R_{81}$ to $R_{85}$, $R_{82a}$, $R_{82b}$, $R_{83a}$, $R_{83b}$, $R_{84a}$, and $R_{84b}$ may each independently be hydrogen, deuterium, -F, -Cl, -Br, -I, a hydroxyl group, a cyano group, a nitro group, a $C_1$-$C_{60}$ alkyl group unsubstituted

or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, a $C_7$-$C_{60}$ aryl alkyl group unsubstituted or substituted with at least one $R_{10a}$, a $C_2$-$C_{60}$ heteroaryl alkyl group unsubstituted or substituted with at least one $R_{10a}$, $-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or $-P(=O)(Q_1)(Q_2)$.. $Q_1$ to $Q_3$ may each independently be the same as described in the present disclosure.

For example, i) $R_1$ to $R_7$, $R_{5a}$, $R_{5b}$, $R_{6a}$, $R_{6b}$, $R_{7a}$, $R_{7b}$, R', and R" in Formula 1, ii) $R_{51}$ to $R_{57}$, $R_{57a}$, $R_{57b}$, $R_{71}$ to $R_{74}$, $R_{81}$ to $R_{85}$, $R_{82a}$, $R_{82b}$, $R_{83a}$, $R_{83b}$, $R_{84a}$, and $R_{84b}$ in Formulae 2-1, 2-2 and 3-1 to 3-5, and iii) $R_{10a}$ may each independently be:

hydrogen, deuterium, -F, -Cl, -Br, -I, a hydroxyl group, a cyano group, a nitro group, a $C_1$-$C_{20}$ alkyl group, or a $C_1$-$C_{20}$ alkoxy group;

a $C_1$-$C_{20}$ alkyl group or a $C_1$-$C_{20}$ alkoxy group, each substituted with deuterium, -F, - Cl, -Br, -I, $-CD_3$, $-CD_2H$, $-CDH_2$, $-CF_3$, $-CF_2H$, $-CFH_2$, a hydroxyl group, a cyano group, a nitro group, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or one or more combinations thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{10}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium,-F,-Cl,-Br,-I,$-CD_3$,$-CD_2H$,$-CDH_2$,$-CF_3$,$-CF_2H$,$-CFH_2$, a hydroxyl group, a cyano group, a nitro group, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{10}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, $-O(Q_{31})$, $-S(Q_{31})$, $-Si(Q_{31})(Q_{32})(Q_{33})$, $-N(Q_{31})(Q_{32})$, $-B(Q_{31})(Q_{32})$, $-P(Q_{31})(Q_{32})$, $-C(=O)(Q_{31})$, $-S(=O)_2(Q_{31})$, $-P(=O)(Q_{31})(Q_{32})$, or one or more combinations thereof; or

$-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or $-P(=O)(Q_1)(Q_2)$,

$Q_1$ to $Q_3$ and $Q_{31}$ to $Q_{33}$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or $-CD_2CDH_2$; or

an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a $C_1$-$C_{10}$ alkyl group, a phenyl group, a biphenyl group, a pyridinyl group, a pyrimidinyl group, a pyridazinyl group, a pyrazinyl group, a triazinyl group, or one or more combinations thereof:

**Formula 91**

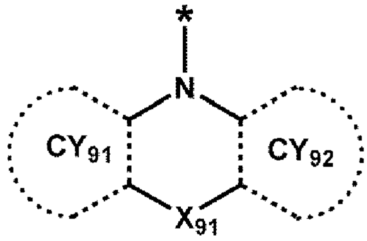

wherein, in Formula 91,

ring $CY_{91}$ and ring $CY_{92}$ may each independently be a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,
$X_{91}$ may be a single bond, O, S, $N(R_{91})$, $B(R_{91})$, $C(R_{91a})(R_{91b})$, or $Si(R_{91a})(R_{91b})$,
$R_{91}$, $R_{91a}$, and $R_{91b}$ may respectively be understood by referring to the descriptions of $R_{82}$, $R_{82a}$, and $R_{82b}$ provided herein,
$R_{10a}$ may be understood by referring to the description of $R_{10a}$ provided herein, and
* indicates a binding site to an adjacent atom.

For example, in Formula 91,

ring $CY_{91}$ and ring $CY_{92}$ may each independently be a benzene group, a pyridine group, a pyrimidine group, a pyrazine group, a pyridazine group, or a triazine group, each unsubstituted or substituted with at least one $R_{10a}$,
$R_{91}$, $R_{91a}$, and $R_{91b}$ may each independently be:
hydrogen or a $C_1$-$C_{10}$ alkyl group; or
a phenyl group, a pyridinyl group, a pyrimidinyl group, a pyridazinyl group, a pyrazinyl group, or a triazinyl group, each unsubstituted or substituted with deuterium, a $C_1$-$C_{10}$ alkyl group, a phenyl group, a biphenyl group, a pyridinyl group, a pyrimidinyl group, a pyridazinyl group, a pyrazinyl group, a triazinyl group, or one or more combinations thereof.

In an embodiment, i) $W_1$ to $W_6$, $W_{11}$ to $W_{14}$, $W_{21}$ to $W_{27}$, $W_{27a}$, $W_{27b}$, $W_{31}$ to $W_{34}$, $W_{41}$ to $W_{44}$, $W_{71}$ to $W_{74}$, $W_{80}$, $W_{80a}$, and $W_{80b}$ in Formulae 1, 1A, 1A-1, BN-1 to BN-16, and BC-1 to BC-47, ii) $R_{51}$ to $R_{57}$, $R_{57a}$, $R_{57b}$, $R_{71}$ to $R_{74}$, $R_{81}$ to $R_{85}$, $R_{82a}$, $R_{82b}$, $R_{83a}$, $R_{83b}$, $R_{84a}$, and $R_{84b}$ in Formulae 2-1, 2-2, 3-1 to 3-5, 502, and 503, and iii) $R_{10a}$ may each independently be hydrogen, deuterium, -F, cyano group, a nitro group, $-CH_3$, $-CD_3$, $-CD_2H$, $-CDH_2$, $-CF_3$, $-CF_2H$, $-CFH_2$, a group represented by one of Formulae 9-1 to 9-19, a group represented by one of Formulae 10-1 to 10-246, $-C(Q_1)(Q_2)(Q_3)$, $-Si(Q_1)(Q_2)(Q_3)$, or $-P(=O)(Q_1)(Q_2)$ (where $Q_1$ to $Q_3$ may each independently be the same as described above) (where each of $R_{10a}$ and $W_{71}$ to $W_{74}$ is not hydrogen):

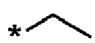
9-1

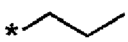
9-2

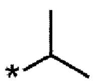
9-3

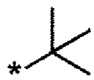
9-4

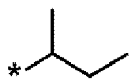
9-5

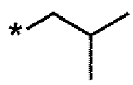
9-6

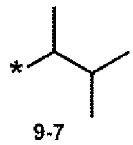
9-7

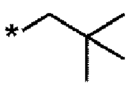
9-8

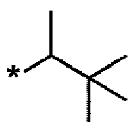
9-9

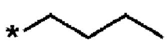
9-10

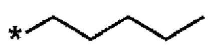
9-11

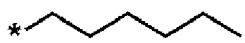
9-12

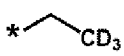
9-13

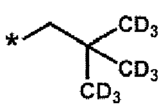
9-14

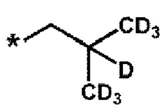
9-15

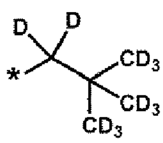
9-16

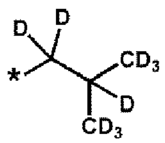
9-17

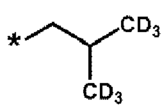
9-18

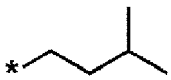

9-19

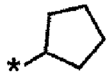 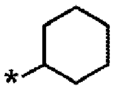 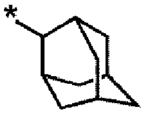 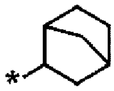 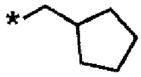 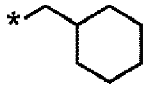 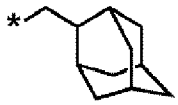

10-1 10-2 10-3 10-4 10-5 10-6 10-7

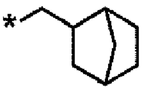 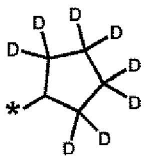 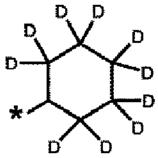 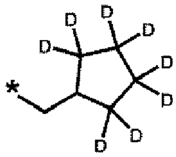 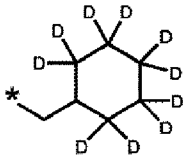 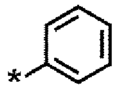

10-8 10-9 10-10 10-11 10-12 10-13

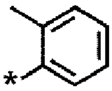 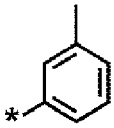 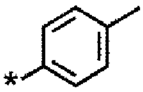 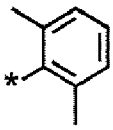 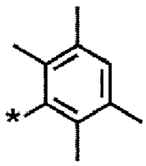 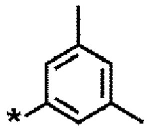 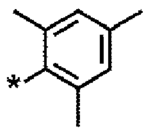

10-14 10-15 10-16 10-17 10-18 10-19 10-20

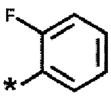 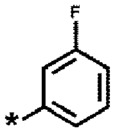 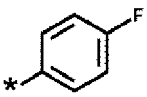 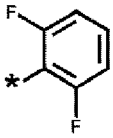 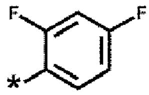 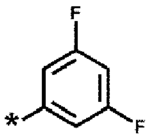 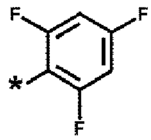

10-21 10-22 10-23 10-24 10-25 10-26 10-27

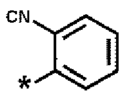 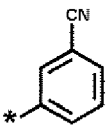 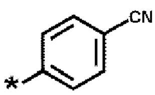 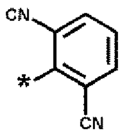 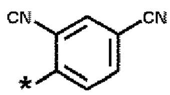 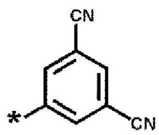 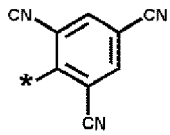

10-28 10-29 10-30 10-31 10-32 10-33 10-34

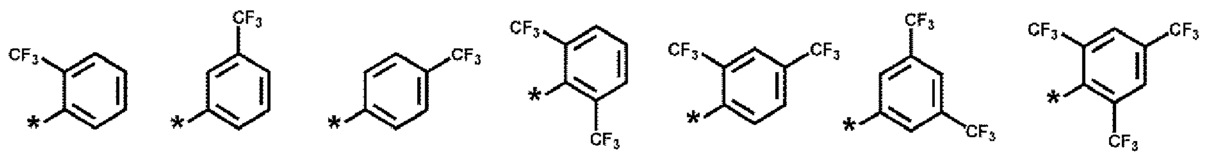

10-35 10-36 10-37 10-38 10-39 10-40 10-41

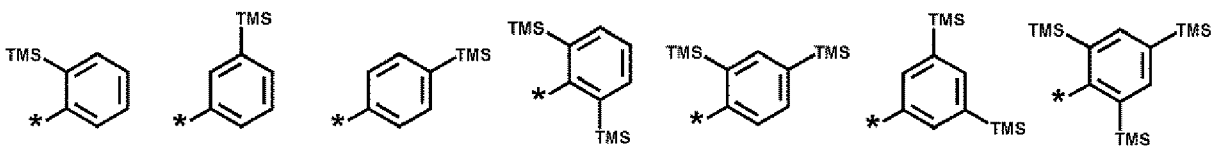

10-42 10-43 10-44 10-45 10-46 10-47 10-48

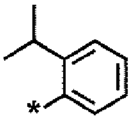
10-49
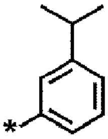
10-50
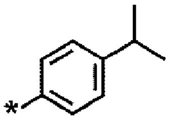
10-51
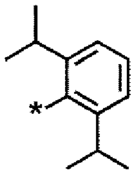
10-52
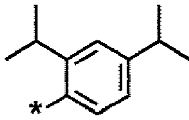
10-53
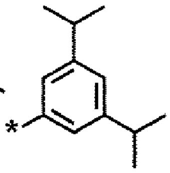
10-54
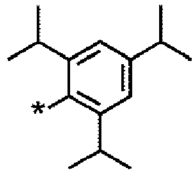
10-55

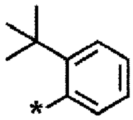
10-56
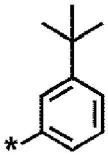
10-57
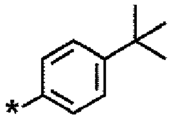
10-58
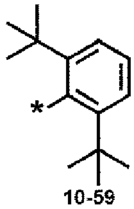
10-59
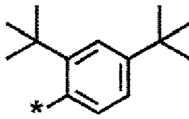
10-60
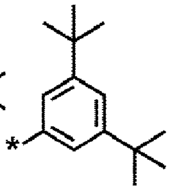
10-61
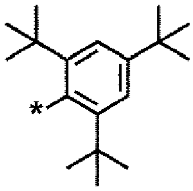
10-62

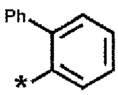
10-63
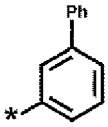
10-64
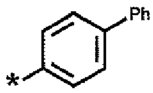
10-65
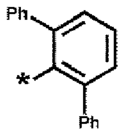
10-66
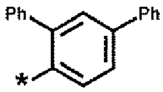
10-67
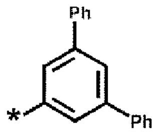
10-68
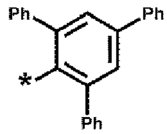
10-69

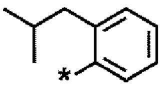
10-70
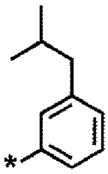
10-71
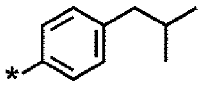
10-72
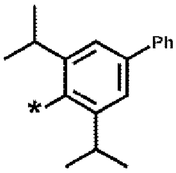
10-73
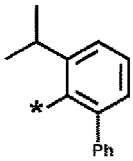
10-74
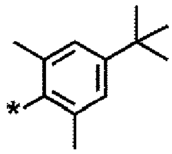
10-75

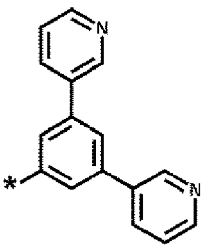
10-76
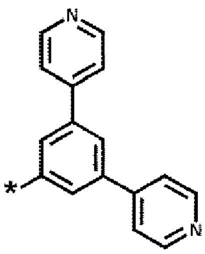
10-77
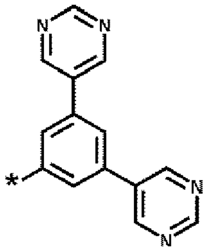
10-78
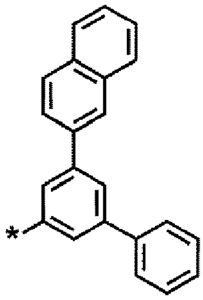
10-79
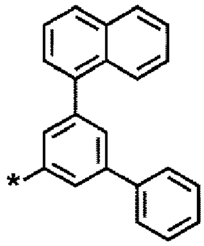
10-80

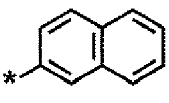
10-81
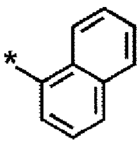
10-82
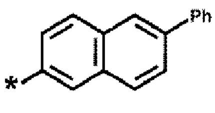
10-83
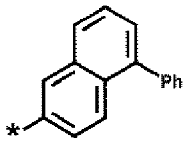
10-84
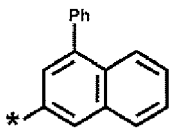
10-85

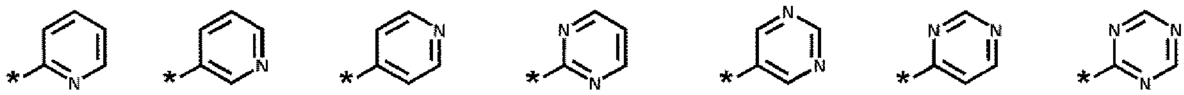
10-86 10-87 10-88 10-89 10-90 10-91 10-92

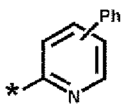
10-93

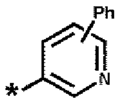
10-94

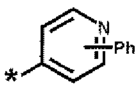
10-95

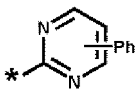
10-96

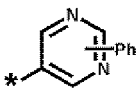
10-97

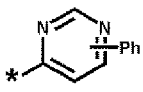
10-98

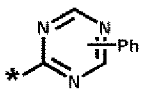
10-99

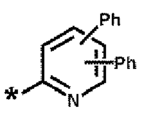
10-100

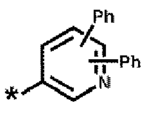
10-101

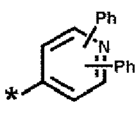
10-102

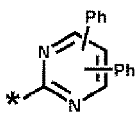
10-103

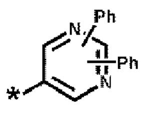
10-104

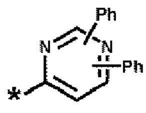
10-105

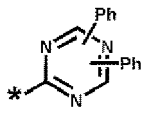
10-106

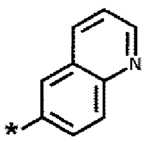
10-107

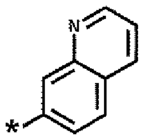
10-108

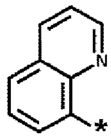
10-109

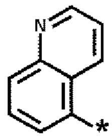
10-110

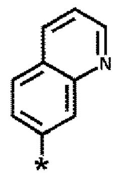
10-111

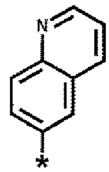
10-112

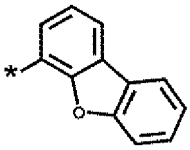
10-113

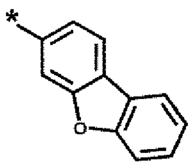
10-114

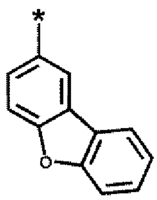
10-115

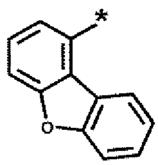
10-116

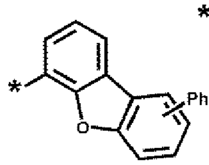
10-117

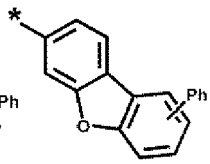
10-118

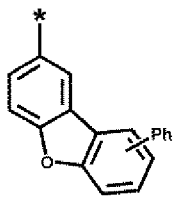
10-119

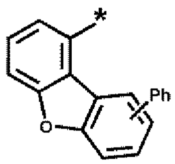
10-120

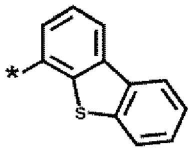
10-121

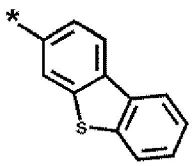
10-122

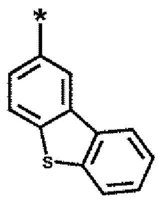
10-123

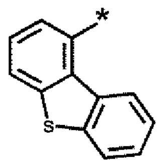
10-124

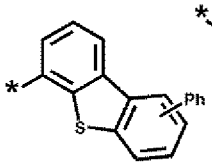
10-125

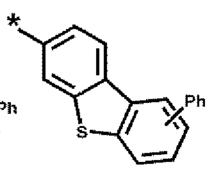
10-126

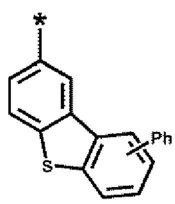
10-127

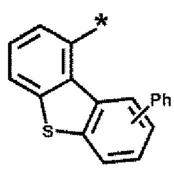
10-128

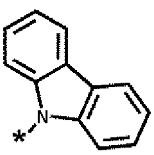
10-129

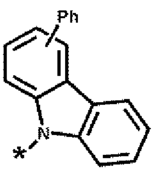
10-130

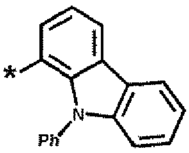
10-131

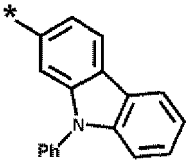
10-132

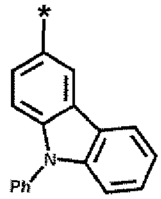
10-133

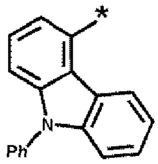
10-134

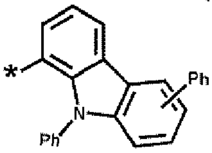
10-135

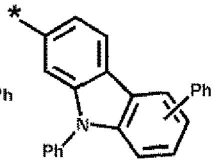
10-136

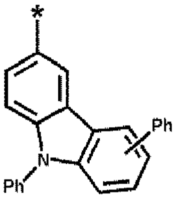
10-137

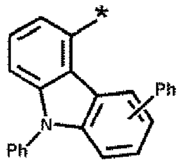
10-138

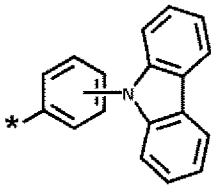
10-139

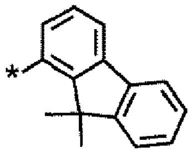
10-140

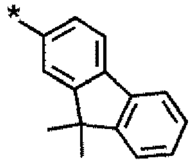
10-141

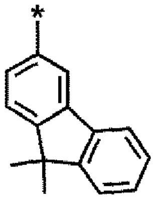
10-142

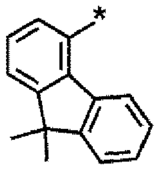
10-143

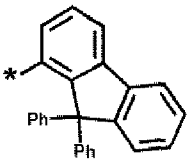
10-144

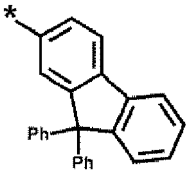
10-145

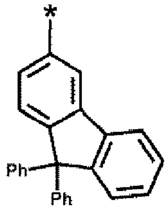
10-146

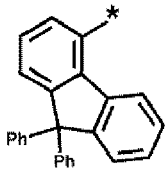
10-147

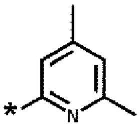
10-148

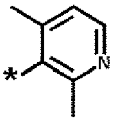
10-149

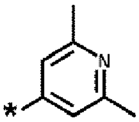
10-150

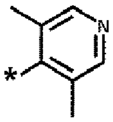
10-151

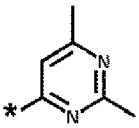
10-152

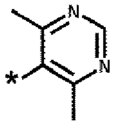
10-153

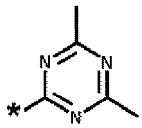
10-154

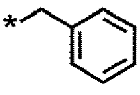
10-155

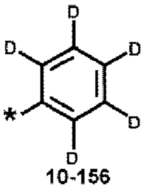
10-156

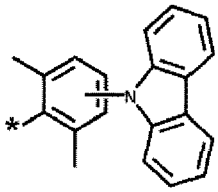
10-157

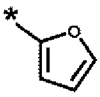
10-158

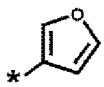
10-159

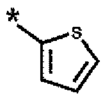
10-160

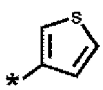
10-161

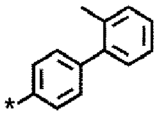
10-162

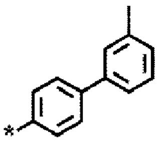
10-163

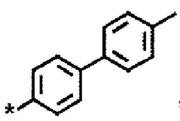
10-164

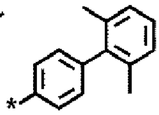
10-165

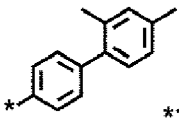
10-166

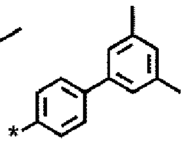
10-167

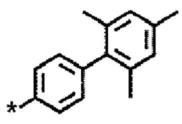
10-168

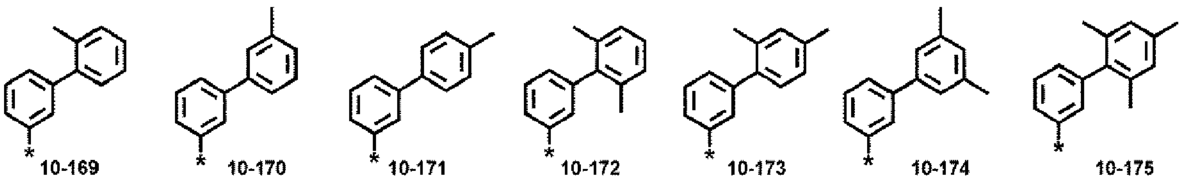
10-169 10-170 10-171 10-172 10-173 10-174 10-175

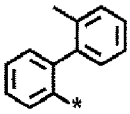
10-176
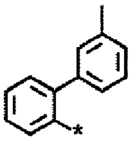
10-177
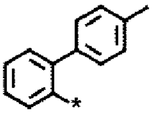
10-178
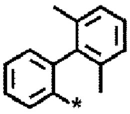
10-179
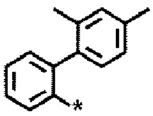
10-180
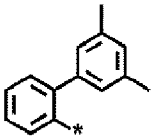
10-181
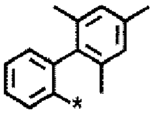
10-182

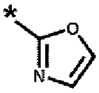
10-183
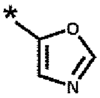
10-184
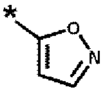
10-185
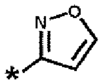
10-186
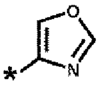
10-187
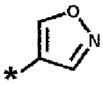
10-188
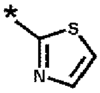
10-189
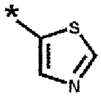
10-190
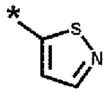
10-191

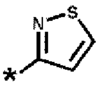
10-192
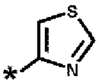
10-193
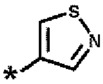
10-194
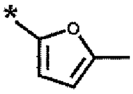
10-195
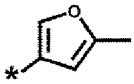
10-196
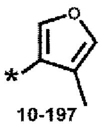
10-197
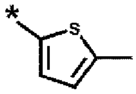
10-198
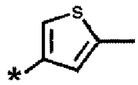
10-199
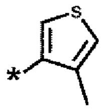
10-200

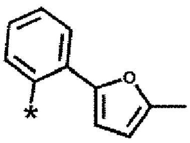
10-201
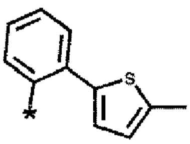
10-202
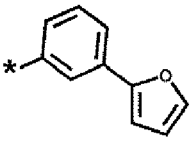
10-203
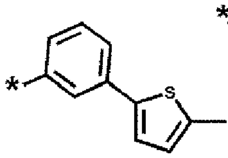
10-204
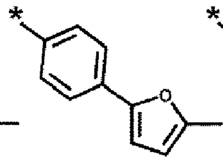
10-205
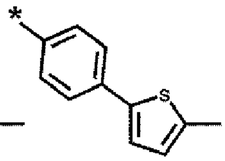
10-206

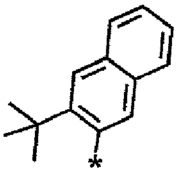
10-207
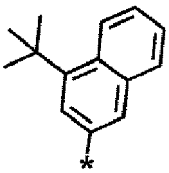
10-208
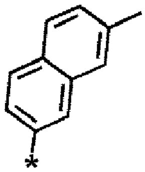
10-209
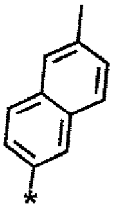
10-210
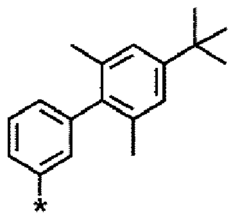
10-211
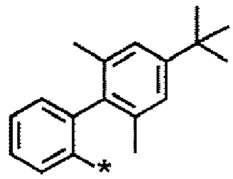
10-212

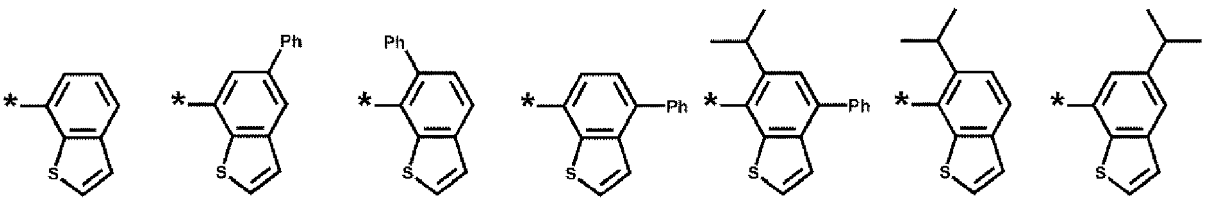
10-213 10-214 10-215 10-216 10-217 10-218 10-219

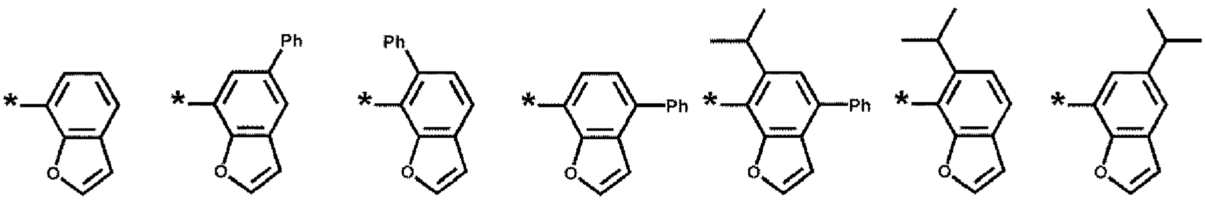
10-220 10-221 10-222 10-223 10-224 10-225 10-226

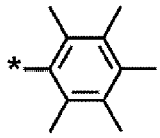
10-227
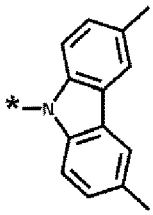
10-228
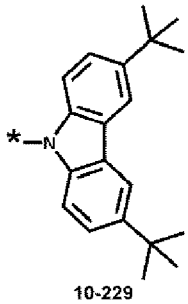
10-229
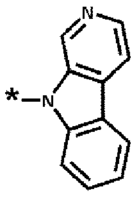
10-230
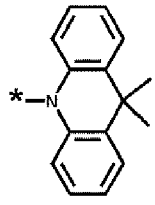
10-231
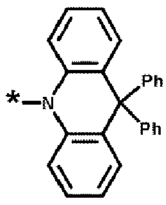
10-232
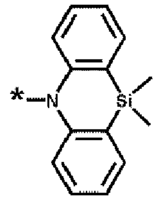
10-233

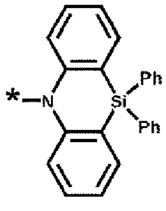
10-234
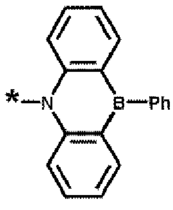
10-235
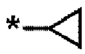
10-236
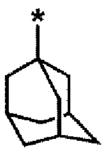
10-237
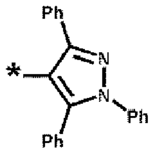
10-238
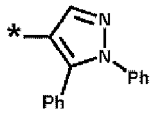
10-239
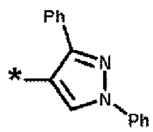
10-240

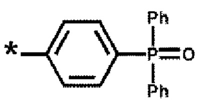
10-241
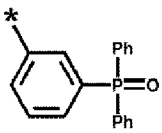
10-242
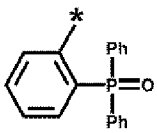
10-243
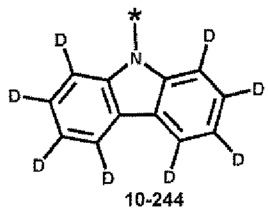
10-244
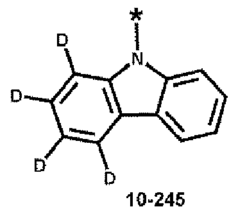
10-245

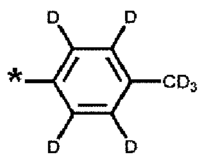
10-246 ,

wherein, in Formulae 9-1 to 9-19 and 10-1 to 10-246, * indicates a binding site to an adjacent atom, "Ph" represents a phenyl group, and "TMS" represents a trimethylsilyl group.

a71 to a74 in Formulae 3-1 to 3-5 respectively indicate numbers of $R_{71}$ to $R_{74}$, and may each independently be an integer from 0 to 20. When a71 is 2 or more, two or more of $R_{71}$(s) may be identical to or different from each other, when a72 is 2 or more, two or more of $R_{72}$(s) may be identical to or different from each other, when a73 is 2 or more, two or more of $R_{73}$(s) may be identical to or different from each other, and when a74 is 2 or more, two or more of $R_{74}$(s) may be identical to or different from each other. a71 to a74 may each independently be an integer from 0 to 8.

In Formula 1, i) two or more of $W_1$(s) in the number of b1 may optionally be bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, ii) two or more of $W_2$(s) in the number of b2 may optionally be bonded to each other to form a $C_3$-$C_{60}$ carbocyclic group unsubstituted or substituted with at least one R10a or a $C_1$-$C_{60}$ heterocyclic group unsubstituted or substituted with at least one $R_{10a}$, iii) two or more of $W_3$(s) in the number of b3 may optionally be bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, iv) two or more of $W_4$(s) in the number of b4 may optionally be bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, v) two or more of $W_5$(s) in the number of b5 may optionally be bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, and vi) two or more of $W_6$(s) in the number of b6 may optionally be bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$.

In Formulae 3-1 to 3-5, $L_{81}$ to $L_{85}$ may each independently be:

a single bond; or

*-C($Q_4$)($Q_5$)-*' or *-Si($Q_4$)($Q_5$)-*'; or

a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, -F, -Cl, -Br, -I, a hydroxyl group, a cyano group, a nitro group, a $C_1$-$C_{20}$ alkyl group, a $C_1$-$C_{20}$ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O($Q_{31}$), -S($Q_{31}$), - Si($Q_{31}$)($Q_{32}$)($Q_{33}$), -N($Q_{31}$)($Q_{32}$), -B($Q_{31}$)($Q_{32}$), -P($Q_{31}$)($Q_{32}$), -C(=O)($Q_{31}$), -S(=O)$_2$($Q_{31}$), - P(=O)($Q_{31}$)($Q_{32}$), or one or more combinations thereof,

wherein $Q_4$, $Q_5$, and $Q_{31}$ to $Q_{33}$ may each independently be hydrogen, deuterium, a $C_1$-$C_{20}$ alkyl group, a $C_1$-$C_{20}$ alkoxy group, a phenyl group, a biphenyl group, a terphenyl group, a pyridinyl group, a pyrimidinyl group, a pyridazinyl group, a pyrazinyl group, or a triazinyl group.

In some embodiments, in Formulae 3-1 and 3-2, a group represented by

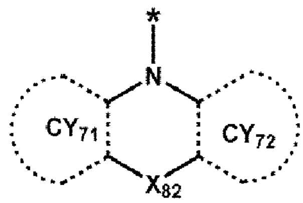

may be represented by one of Formulae CY71-1(1) to CY71-1(8) and/or,

in Formulae 3-1 and 3-3, a group represented by

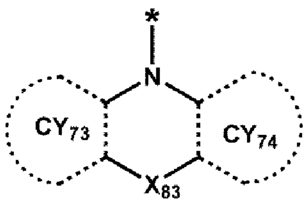

may be represented by one of Formulae CY71-2(1) to CY71-2(8) and/or,

in Formulae 3-2 and 3-4, a group represented by

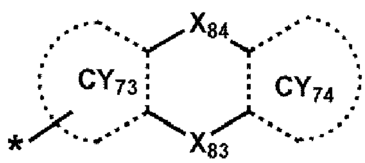

may be represented by one of Formulae CY71-3(1) to CY71-3(32) and/or,

in Formulae 3-3 to 3-5, a group represented by

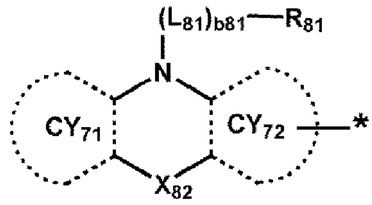

may be represented by one of Formulae CY71-4(1) to CY71-4(32), and/or

in Formula 3-5, a group represented by

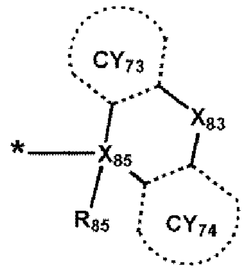

may be represented by one of Formulae CY71-5(1) to CY71-5(8):

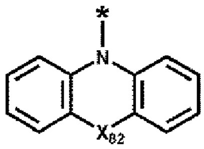
CY71-1(1)

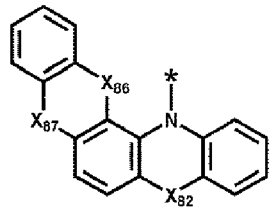
CY71-1(2)

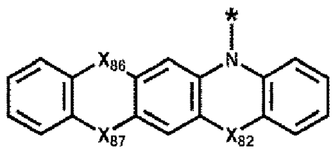
CY71-1(3)

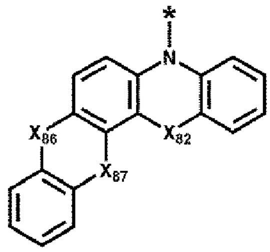
CY71-1(4)

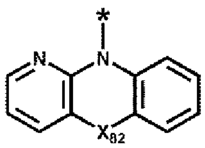
CY71-1(5)

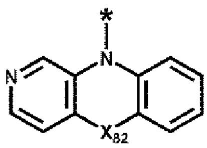
CY71-1(6)

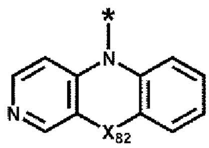
CY71-1(7)

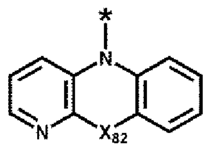
CY71-1(8)

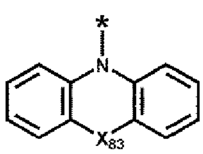
CY71-2(1)

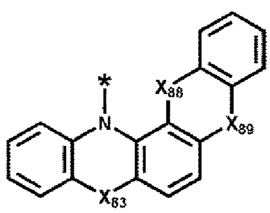
CY71-2(2)

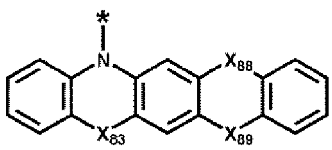
CY71-2(3)

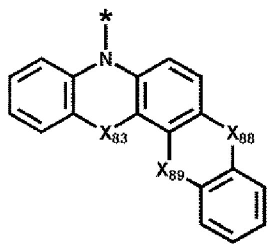
CY71-2(4)

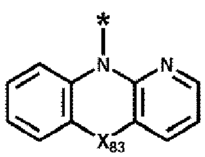
CY71-2(5)

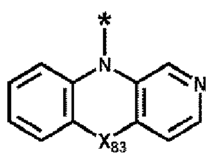
CY71-2(6)

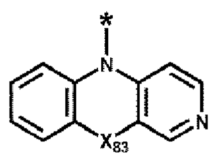
CY71-2(7)

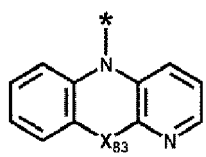
CY71-2(8)

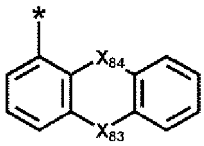
CY71-3(1)

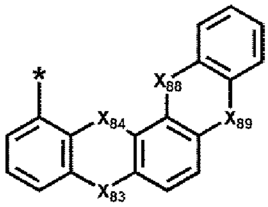
CY71-3(2)

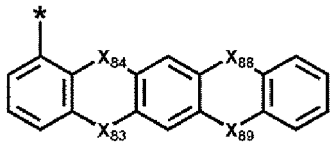
CY71-3(3)

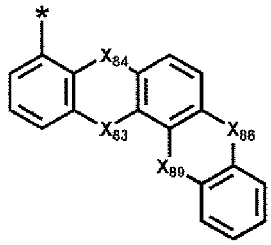
CY71-3(4)

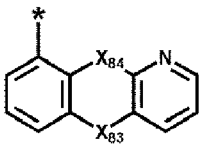
CY71-3(5)

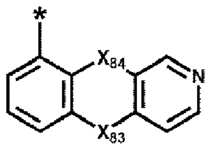
CY71-3(6)

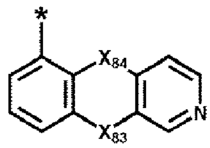
CY71-3(7)

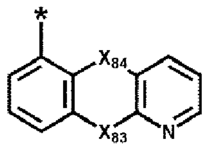
CY71-3(8)

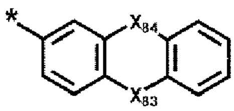
CY71-3(9)

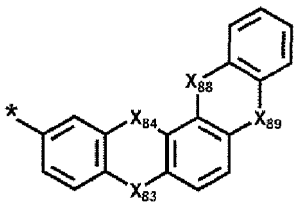
CY71-3(10)

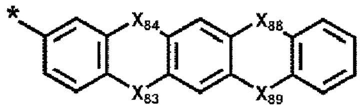
CY71-3(11)

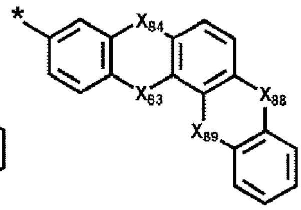
CY71-3(12)

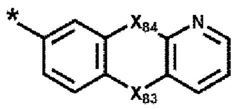
CY71-3(13)

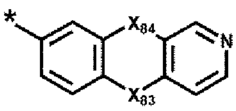
CY71-3(14)

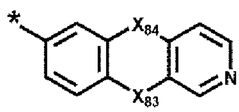
CY71-3(15)

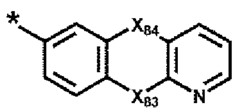
CY71-3(16)

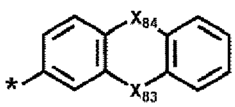
CY71-3(17)

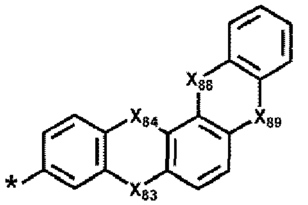
CY71-3(18)

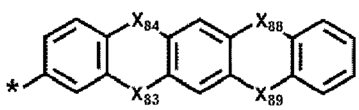
CY71-3(19)

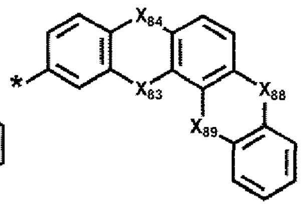
CY71-3(20)

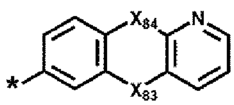
CY71-3(21)

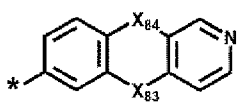
CY71-3(22)

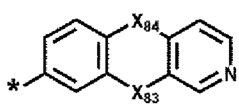
CY71-3(23)

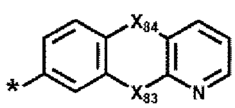
CY71-3(24)

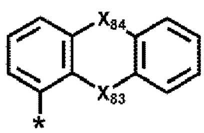
CY71-3(25)

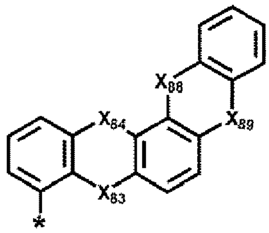
CY71-3(26)

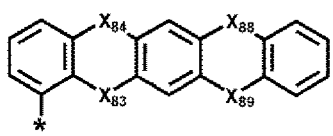
CY71-3(27)

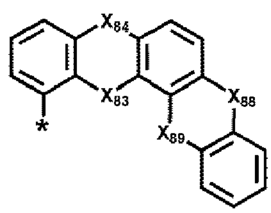
CY71-3(28)

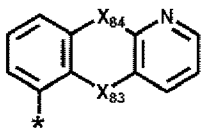
CY71-3(29)

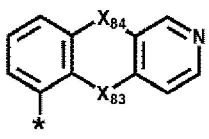
CY71-3(30)

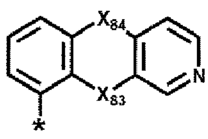
CY71-3(31)

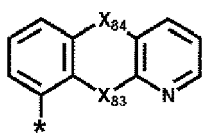
CY71-3(32)

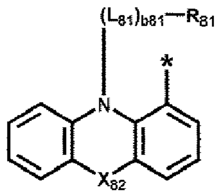
CY71-4(1)

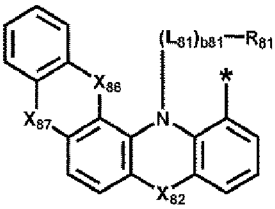
CY71-4(2)

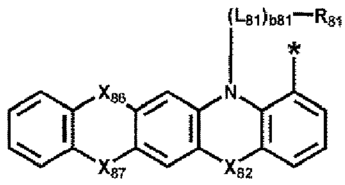
CY71-4(3)

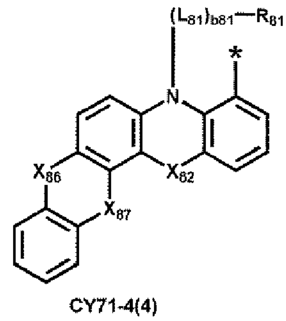
CY71-4(4)

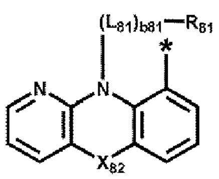
CY71-4(5)

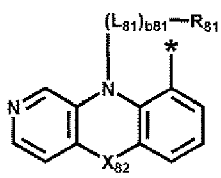
CY71-4(6)

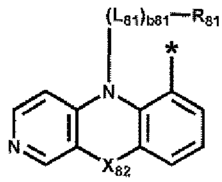
CY71-4(7)

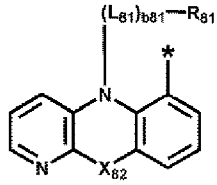
CY71-4(8)

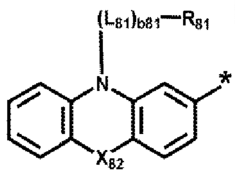
CY71-4(9)

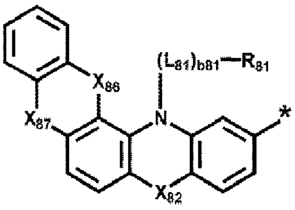
CY71-4(10)

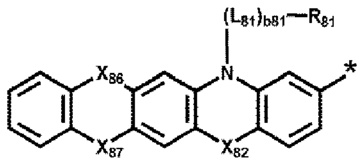
CY71-4(11)

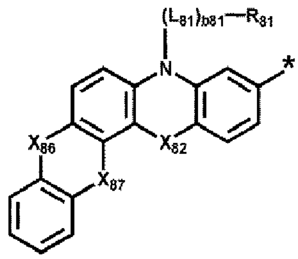
CY71-4(12)

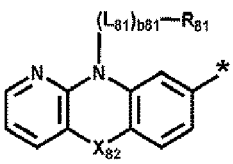
CY71-4(13)

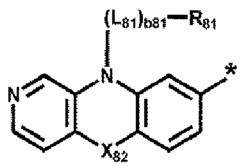
CY71-4(14)

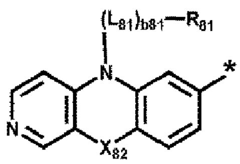
CY71-4(15)

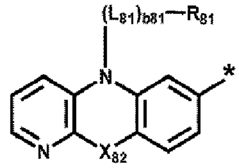
CY71-4(16)

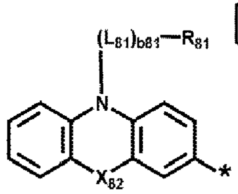
CY71-4(17)

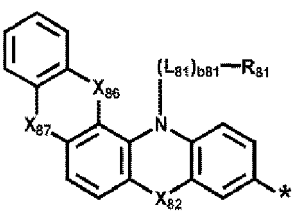
CY71-4(18)

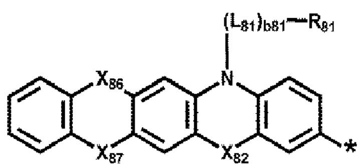
CY71-4(19)

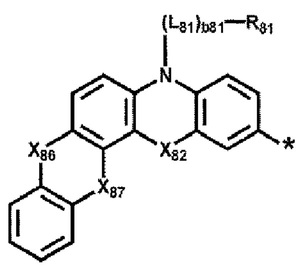
CY71-4(20)

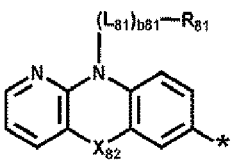
CY71-4(21)

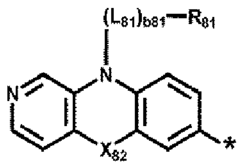
CY71-4(22)

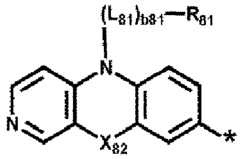
CY71-4(23)

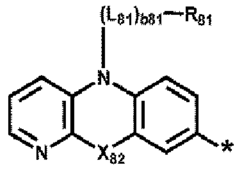
CY71-4(24)

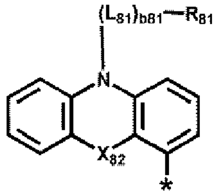
CY71-4(25)

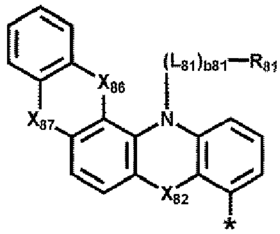
CY71-4(26)

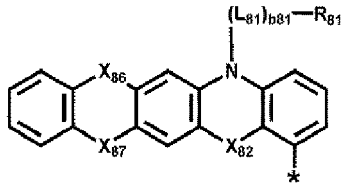
CY71-4(27)

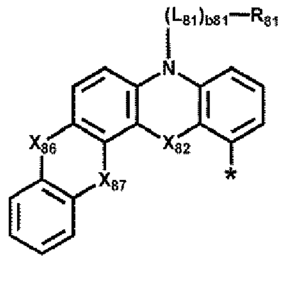
CY71-4(28)

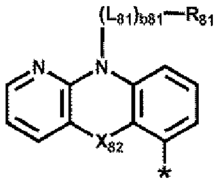
CY71-4(29)

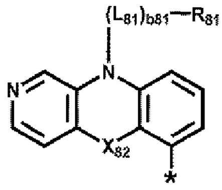
CY71-4(30)

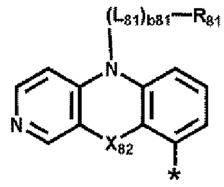
CY71-4(31)

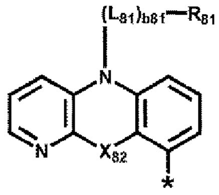
CY71-4(32)

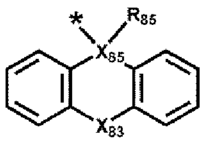
CY71-5(1)

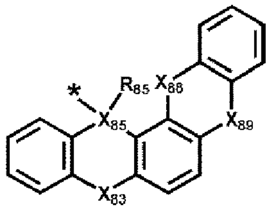
CY71-5(2)

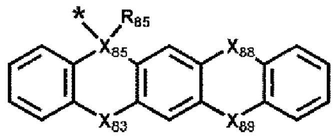
CY71-5(3)

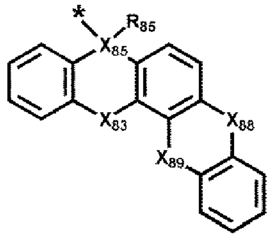
CY71-5(4)

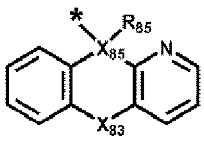
CY71-5(5)

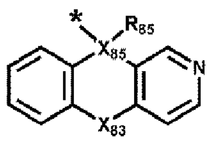
CY71-5(6)

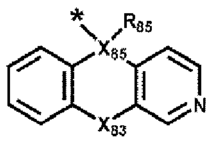
CY71-5(7)

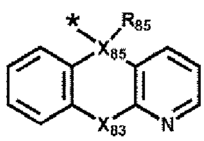
CY71-5(8)

In Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),

$X_{81}$ to $X_{85}$, $L_{81}$, b81, $R_{31}$, and $R_{85}$ may respectively be understood by referring to the descriptions of $X_{81}$ to $X_{85}$, $L_{81}$, b81, $R_{81}$, and $R_{85}$ provided herein,

$X_{86}$ may be a single bond, O, S, $N(R_{86})$, $B(R_{86})$, $C(R_{88a})(R_{86b})$, or $Si(R_{86a})(R_{86b})$,

$X_{87}$ may be a single bond, O, S, $N(R_{87})$, $B(R_{87})$, $C(R_{87a})(R_{87b})$, or $Si(R_{87a})(R_{87b})$,

in Formulae CY71-1(1) to CY71-1(8) and CY71-4(1) to CY71-4(32), $X_{86}$ and $X_{87}$ may not be a single bond at the same time (concurrently),

$X_{88}$ may be a single bond, O, S, $N(R_{88})$, $B(R_{88})$, $C(R_{88a})(R_{88b})$, or $Si(R_{88a})(R_{88b})$,

$X_{89}$ may be a single bond, O, S, $N(R_{89})$, $B(R_{89})$, $C(R_{89a})(R_{89b})$, or $Si(R_{89a})(R_{89b})$,

in Formulae CY71-2(1) to CY71-2(8), CY71-3(1) to CY71-3(32), and CY71-5(1) to CY71-5(8), $X_{88}$ and $X_{88}$ may not

be a single bond at the same time (concurrently), and

$R_{86}$ to $R_{89}$, $R_{86a}$, $R_{86b}$, $R_{87a}$, $R_{87b}$, $R_{88a}$, $R_{88b}$, $R_{89a}$, and $R_{89b}$ may each be understood by referring to the description of $R_{81}$ provided herein.

## Compound Example

In an embodiment, the first emitter or the organometallic compound represented by Formula 1, 1A, or 1A-1 may be one of Compounds GD-1 to GD-8:

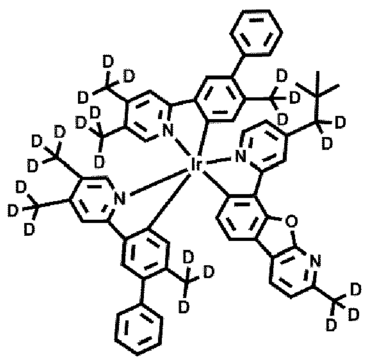

GD-1

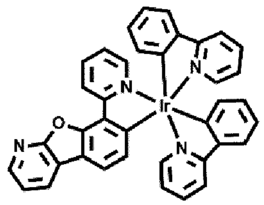

GD-2

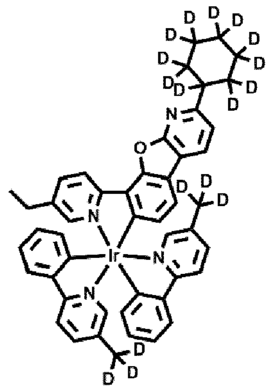

GD-3

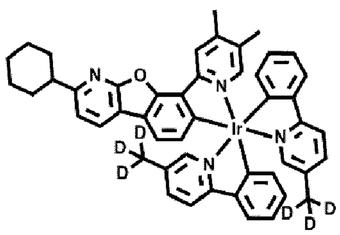

GD-4

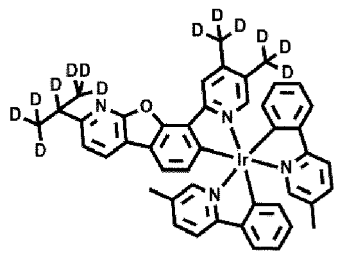

GD-5

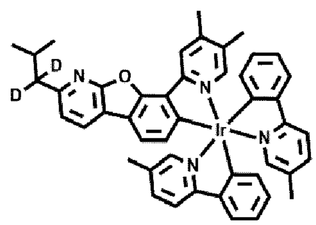

GD-6

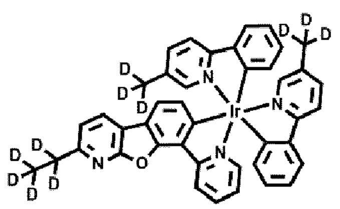

GD-7

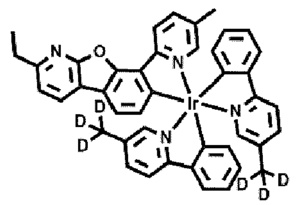

GD-8

.

In an embodiment, the amine-free compound may be one of Compounds 1 to 51:

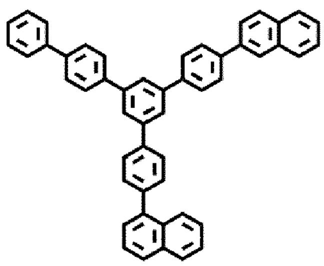

**1**

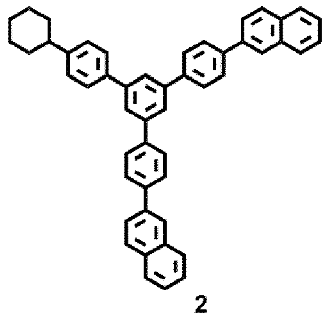

**2**

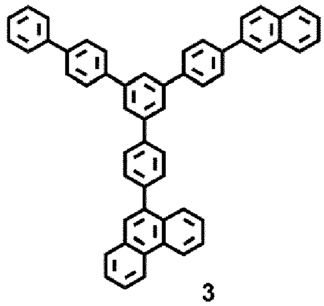

**3**

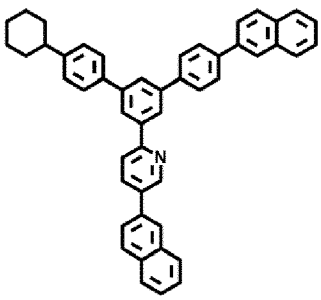

**4**

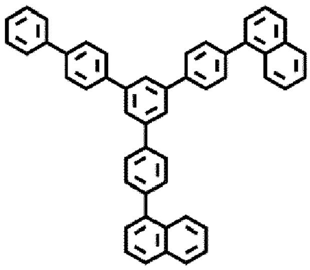

**5**

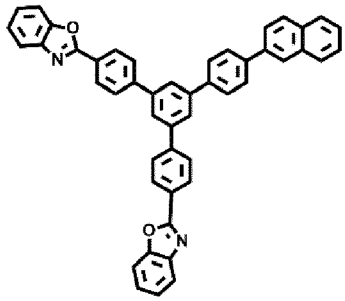

**6**

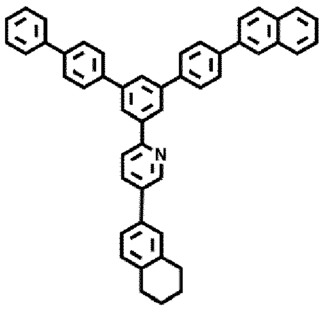

**7**

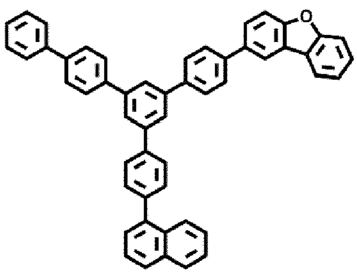

**8**

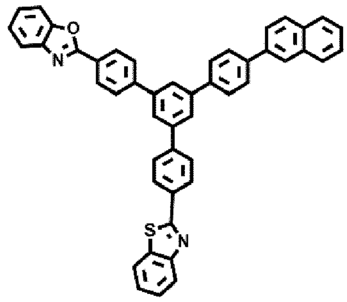

**9**

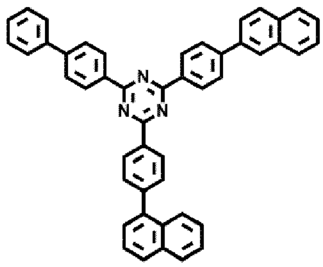

**10**

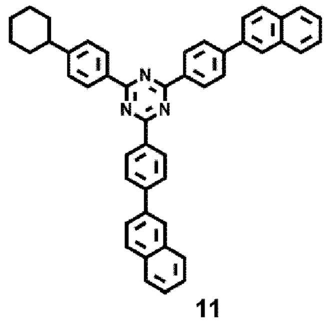

**11**

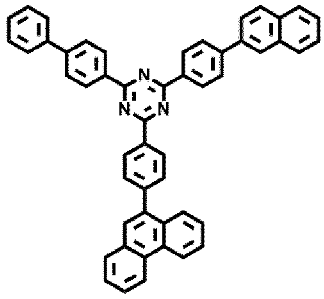

**12**

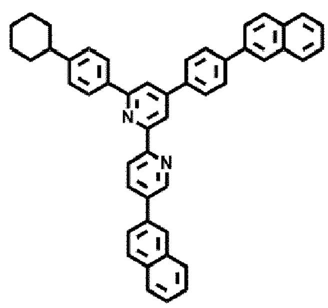

13

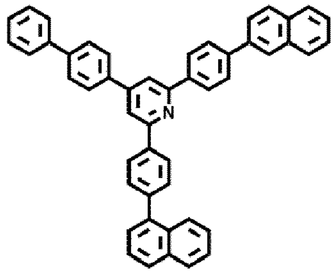

14

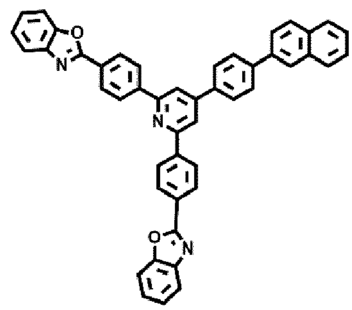

15

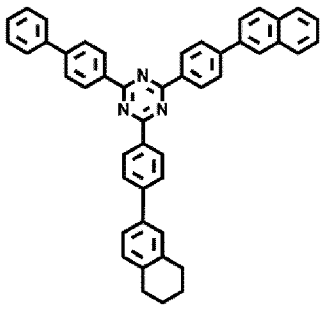

16

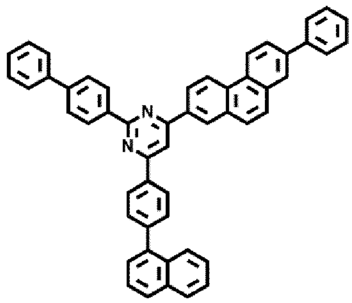

17

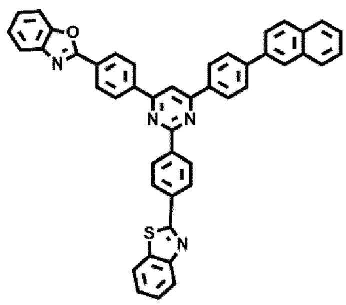

18

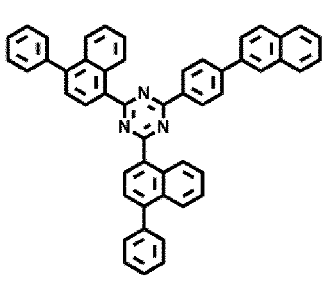

19

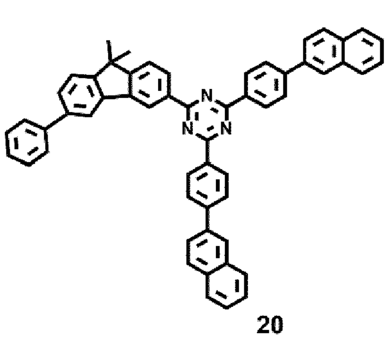

20

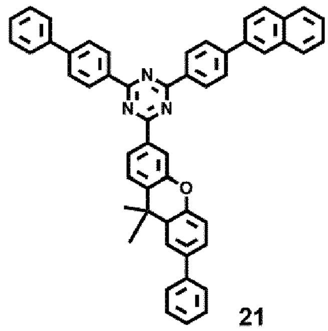

21

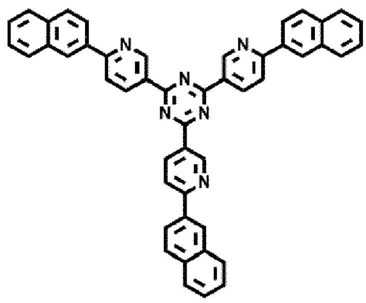

22

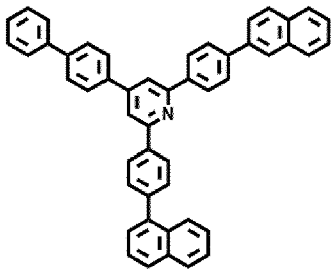

23

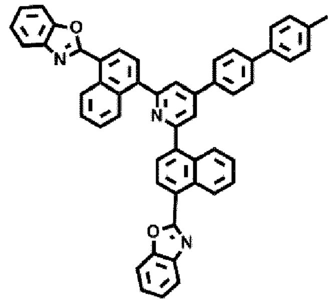

24

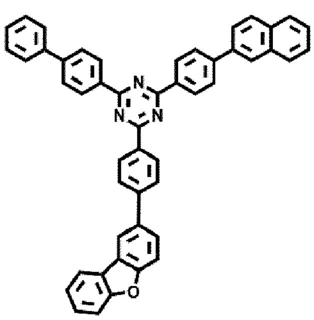
25

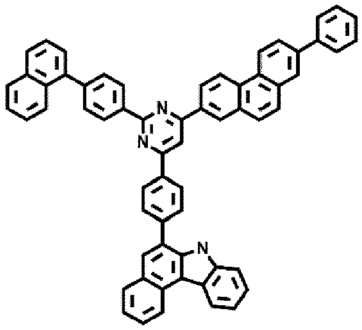
26

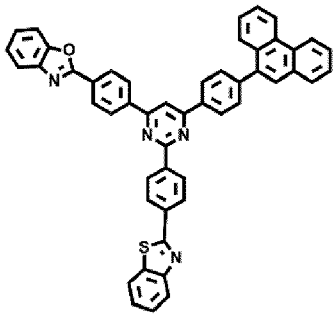
27

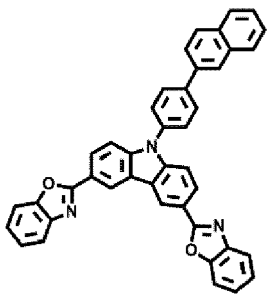
28

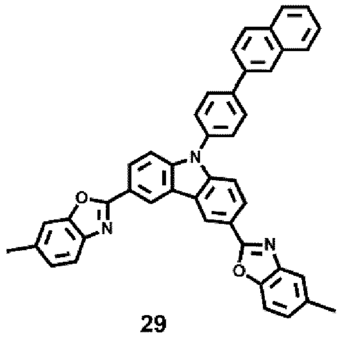
29

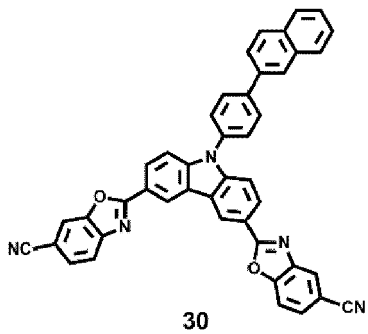
30

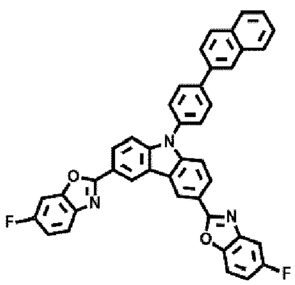
31

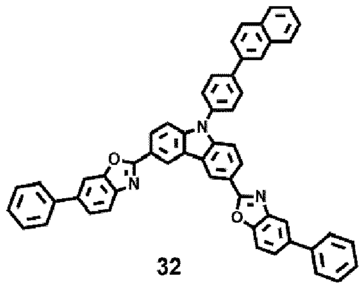
32

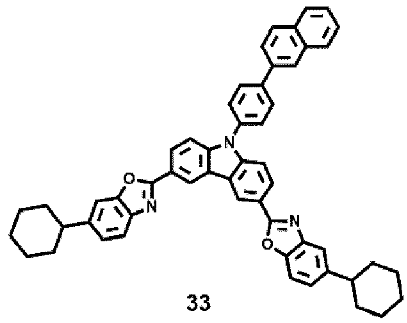
33

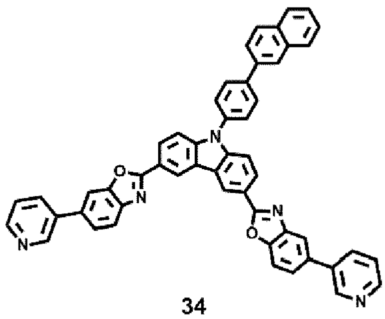
34

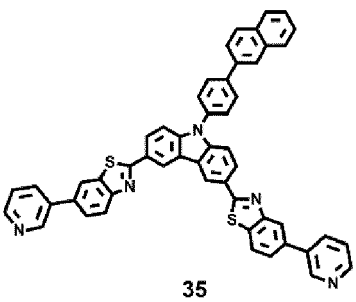
35

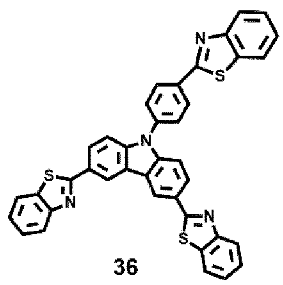
36

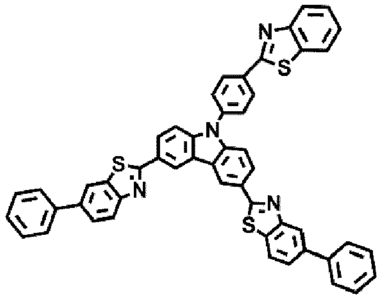

**37**

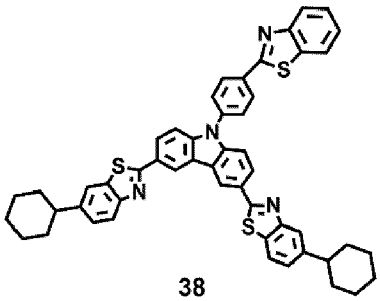

**38**

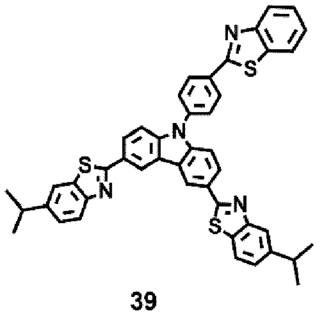

**39**

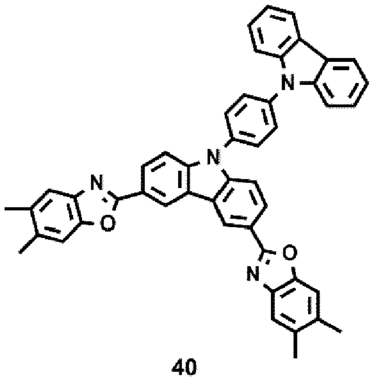

**40**

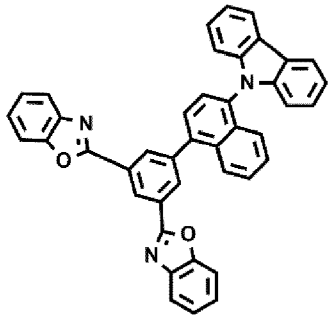

**41**

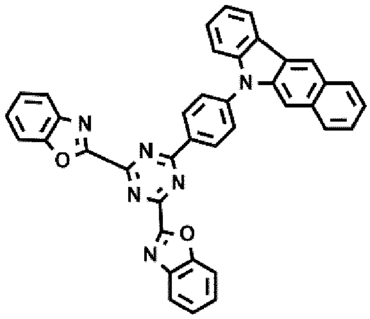

**42**

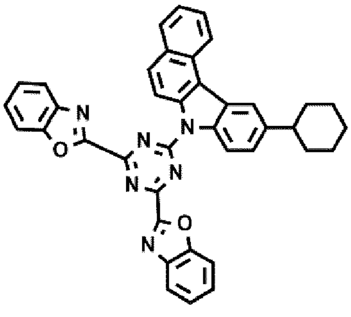

**43**

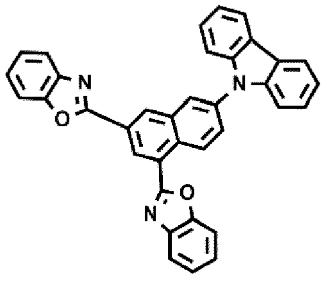

**44**

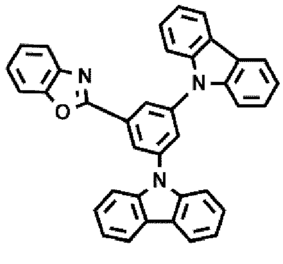

**45**

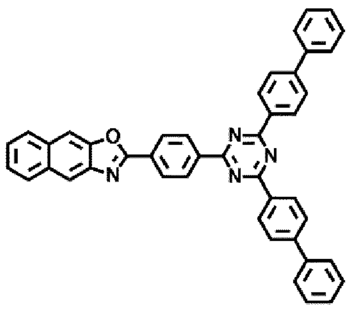

**46**

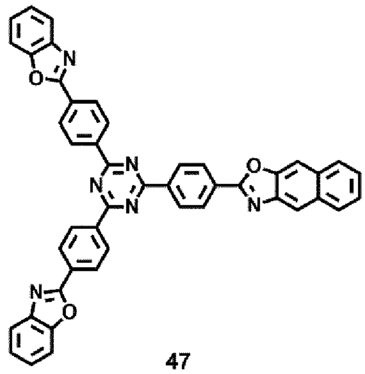

**47**

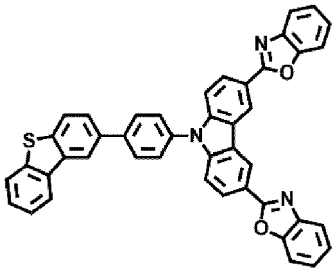

**48**

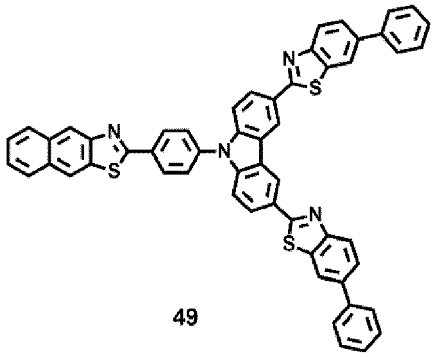

49

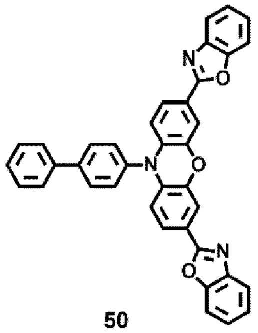

50

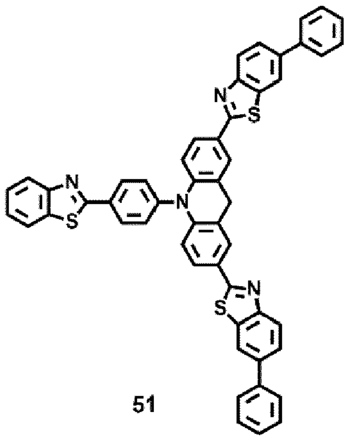

51

.

**Description of FIG. 1**

FIG. 1 is a schematic cross-sectional view of a light-emitting device 10 according to an embodiment. The light-emitting device 10 includes a first electrode 110, an interlayer 130, a second electrode 150, and a second capping layer 170.

Hereinafter, the structure of the light-emitting device 10 according to an embodiment and a method of manufacturing the light-emitting device 10 will be described with reference to FIG. 1.

**First electrode 110**

Referring to FIG. 1, a substrate may be additionally located under the first electrode 110 or above the second capping layer 170. As the substrate, a glass substrate and/or a plastic substrate may be utilized. In one or more embodiments, the substrate may be a flexible substrate, and may include plastics with excellent or suitable heat resistance and durability, such as polyimide, polyethylene terephthalate (PET), polycarbonate, polyethylene napthalate, polyarylate (PAR), polyetherimide, or one or more combinations thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a semi-transmissive electrode, or a transmissive electrode. When the first electrode 110 is a transmissive electrode, a material for forming the first electrode 110 may include indium tin oxide (ITO), indium zinc oxide (IZO), tin oxide ($SnO_2$), zinc oxide (ZnO), or one or more combinations thereof. In one or more embodiments, when the first electrode 110 is a semi-transmissive electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or one or more combinations thereof.

The first electrode 110 may have a single-layered structure including (e.g., consisting of) a single layer or a multi-layered structure including a plurality of layers. For example, the first electrode 110 may have a three-layered structure of ITO/Ag/ITO.

**Interlayer 130**

The interlayer 130 may be on the first electrode 110. The interlayer 130 may include an emission layer.

The interlayer 130 may further include a hole transport region between the first electrode 110 and the emission layer, and an electron transport region between the emission layer and the second electrode 150.

The interlayer 130 may further include, in addition to one or more suitable organic materials, a metal-containing compound such as an organometallic compound, an inorganic material such as quantum dots, and/or the like.

In some embodiments, the interlayer 130 may include i) two or more emitting units sequentially stacked between the first electrode 110 and the second electrode 150 and ii) a charge generation layer between neighboring two emitting units. When the interlayer 130 includes emitting units and a charge generation layer as described above, the light-emitting device 10 may be a tandem light-emitting device.

**Hole transport region in interlayer 130**

The hole transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The hole transport region may include a hole injection layer, a hole transport layer, an emission auxiliary layer, an electron-blocking layer, or one or more combinations thereof.

For example, the hole transport region may have a multi-layered structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron-blocking layer structure, the layers of each structure being stacked sequentially from the first electrode 110.

The hole transport region may include a compound represented by Formula 201, a compound represented by Formula 202, or a combination thereof:

**Formula 201**

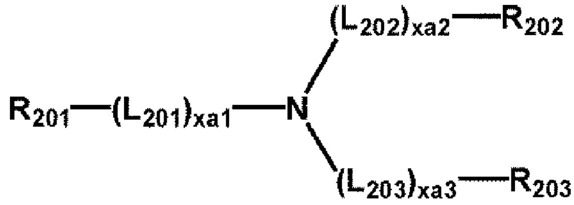

**Formula 202**

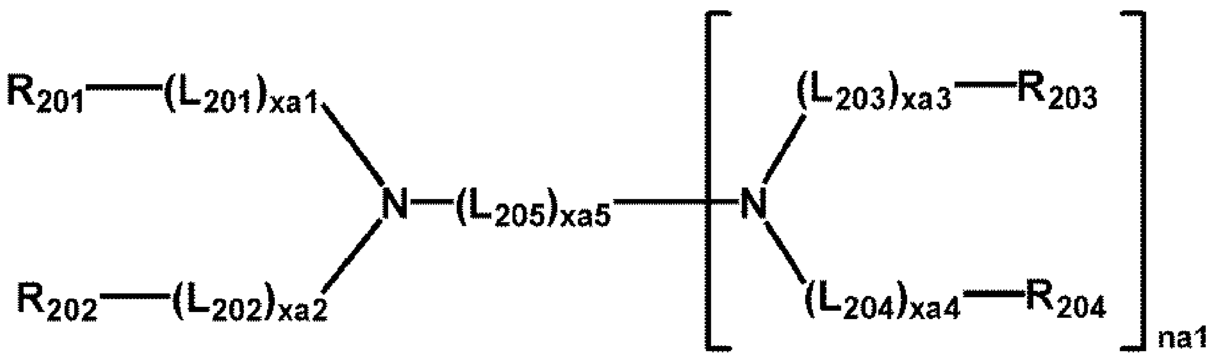

wherein, in Formulae 201 and 202,

$L_{201}$ to $L_{204}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
$L_{205}$ may be *-O-*', *-S-*', *-N($Q_{201}$)-*', a $C_1$-$C_{20}$ alkylene group unsubstituted or substituted with at least one $R_{10a}$, a $C_2$-$C_{20}$ alkenylene group unsubstituted or substituted with at least one $R_{10a}$, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
xa1 to xa4 may each independently be an integer from 0 to 5,
xa5 may be an integer from 1 to 10,
$R_{201}$ to $R_{204}$ and $Q_{201}$ may each independently be a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
$R_{201}$ and $R_{202}$ may optionally be linked to each other, via a single bond, a $C_1$-$C_5$ alkylene group unsubstituted or substituted with at least one $R_{10a}$, or a $C_2$-$C_5$ alkenylene group unsubstituted or substituted with at least one $R_{10a}$, to form a $C_8$-$C_{60}$ polycyclic group (for example, a carbazole group and/or the like) unsubstituted or substituted with at least one $R_{10a}$ (for example, see Compound HT16),
$R_{203}$ and $R_{204}$ may optionally be linked to each other, via a single bond, a $C_1$-$C_5$ alkylene group unsubstituted or

substituted with at least one $R_{10a}$, or a $C_2$-$C_5$ alkenylene group unsubstituted or substituted with at least one $R_{10a}$, to form a $C_8$-$C_{60}$ polycyclic group unsubstituted or substituted with at least one $R_{10a}$, and
na1 may be an integer from 1 to 4.

For example, each of Formulae 201 and 202 may include at least one of groups represented by Formulae CY201 to CY217.

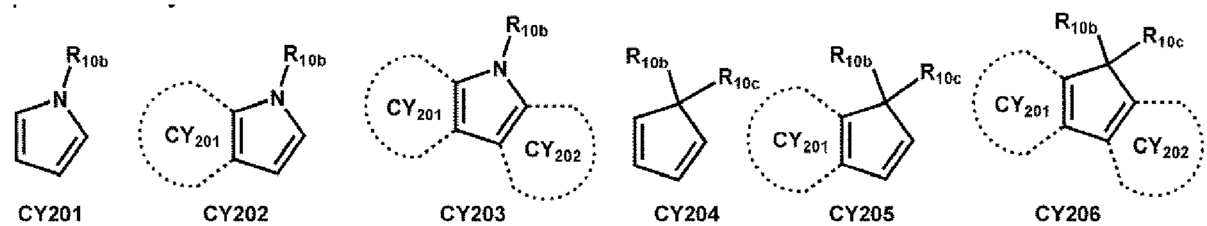

CY201 CY202 CY203 CY204 CY205 CY206

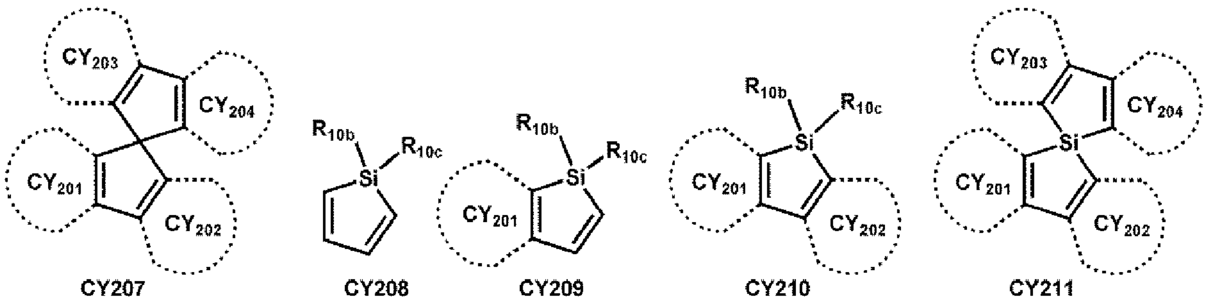

CY207 CY208 CY209 CY210 CY211

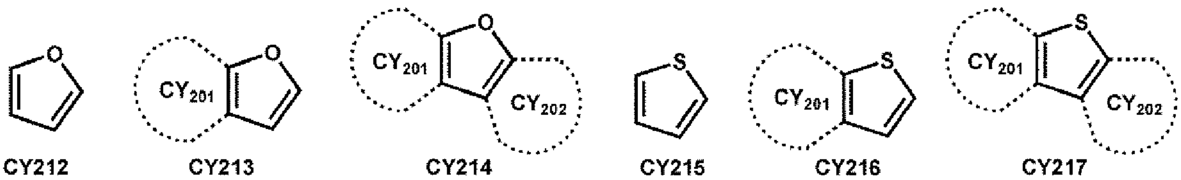

CY212 CY213 CY214 CY215 CY216 CY217

$R_{10b}$ and $R_{10c}$ in Formulae CY201 to CY217 are the same as described in connection with $R_{10a}$, ring $CY_{201}$ to ring $CY_{204}$ may each independently be a $C_3$-$C_{20}$ carbocyclic group or a $C_1$-$C_{20}$ heterocyclic group, and at least one hydrogen in Formulae CY201 to CY217 may be unsubstituted or substituted with $R_{10a}$.

In one or more embodiments, ring $CY_{201}$ to ring $CY_{204}$ in Formulae CY201 to CY217 may each independently be a benzene group, a naphthalene group, a phenanthrene group, or an anthracene group.

In one or more embodiments, each of Formulae 201 and 202 may include at least one of groups represented by Formulae CY201 to CY203.

In one or more embodiments, Formula 201 may include at least one of the groups represented by Formulae CY201 to CY203 and at least one of the groups represented by Formulae CY204 to CY217.

In one or more embodiments, in Formula 201, xa1 may be 1, $R_{201}$ may be a group represented by one of Formulae CY201 to CY203, xa2 may be 0, and $R_{202}$ may be a group represented by one of Formulae CY204 to CY207.

In one or more embodiments, each of Formulae 201 and 202 may not include (e.g., may exclude) a group represented by one of Formulae CY201 to CY203.

In one or more embodiments, each of Formulae 201 and 202 may not include (e.g., may exclude) a group represented by one of Formulae CY201 to CY203, and may include at least one of the groups represented by Formulae CY204 to CY217.

In one or more embodiments, each of Formulae 201 and 202 may not include (e.g., may exclude) a group represented by one of Formulae CY201 to CY217.

In an embodiment, the hole transport region may include one of Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or one or more combinations thereof:

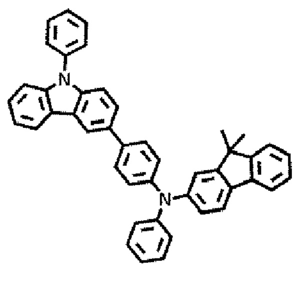

HT1

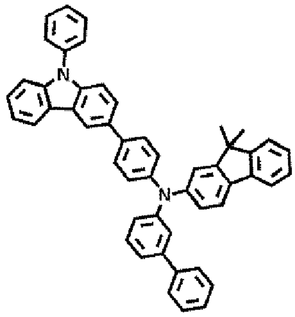

HT2

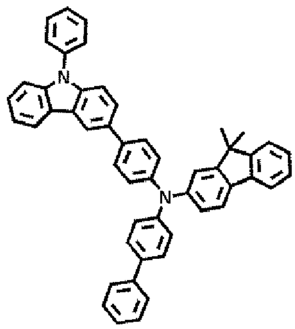

HT3

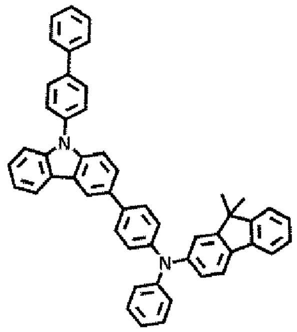

HT4

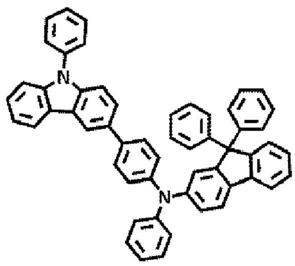

HT5

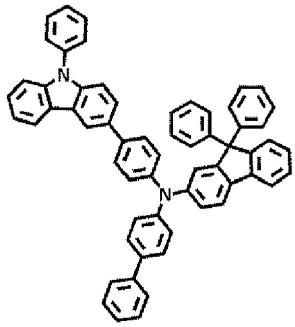

HT6

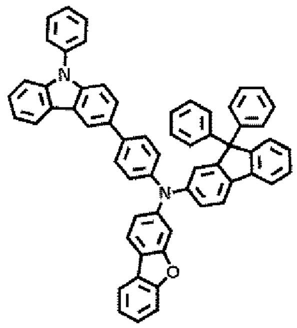

HT7

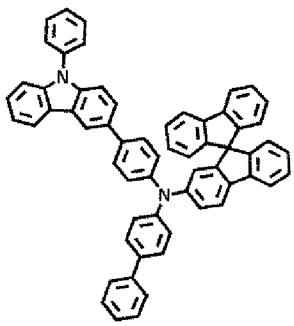

HT8

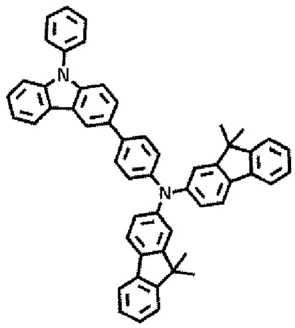

HT9

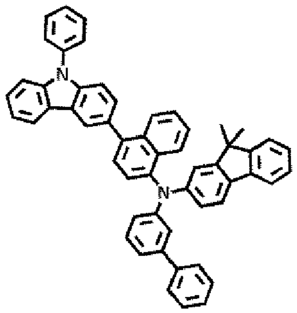

HT10

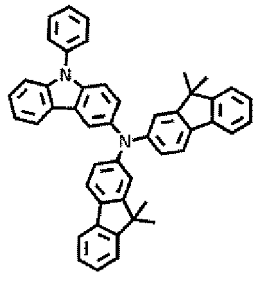

HT11

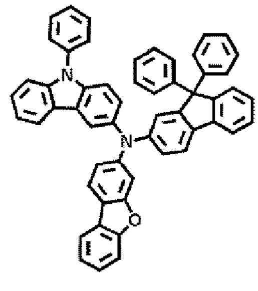

HT12

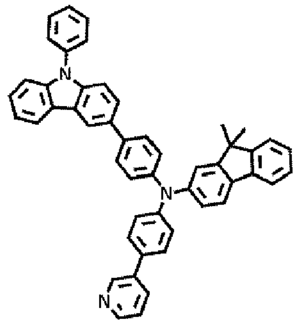
HT13

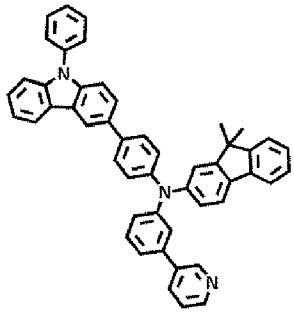
HT14

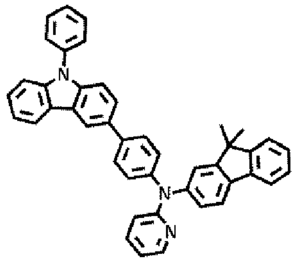
HT15

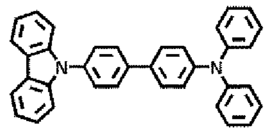
HT16

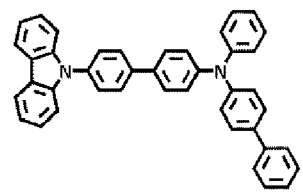
HT17

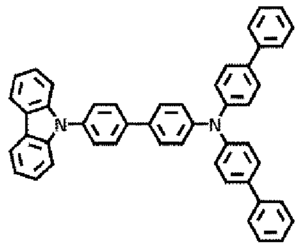
HT18

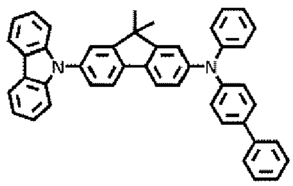
HT19

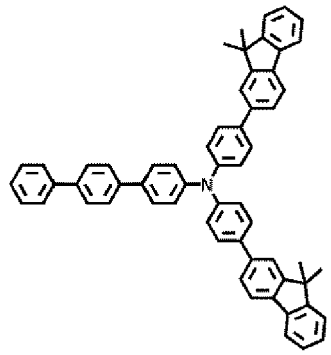
HT20

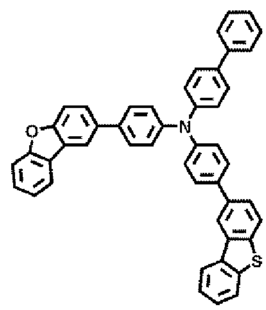
HT21

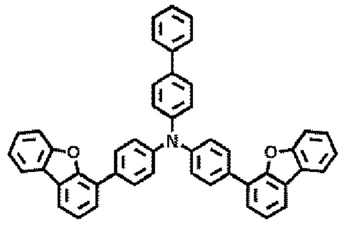
HT22

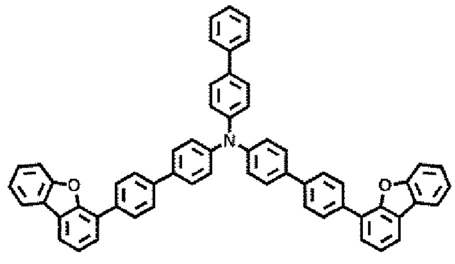
HT23

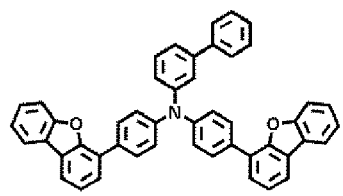
HT24

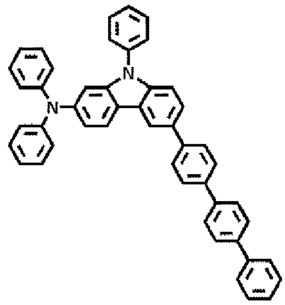

HT25

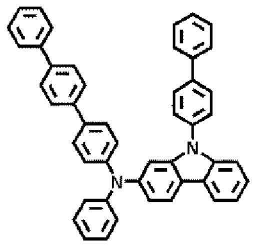

HT26

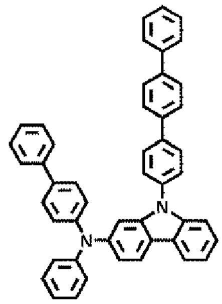

HT27

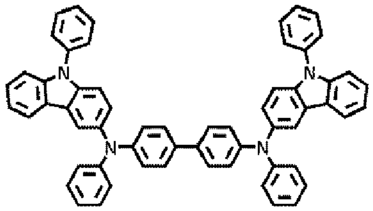

HT28

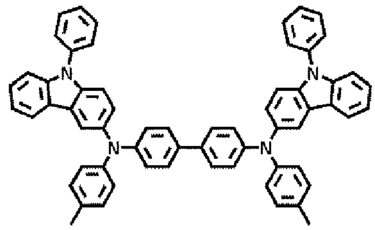

HT29

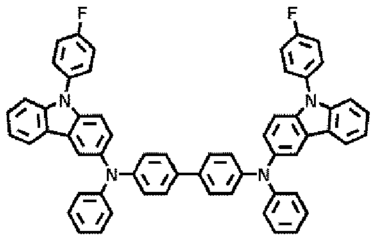

HT30

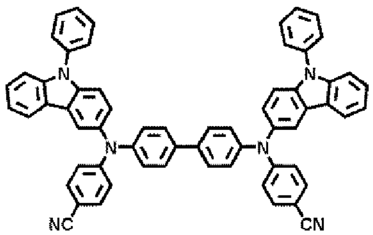

HT31

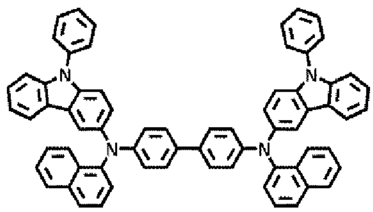

HT32

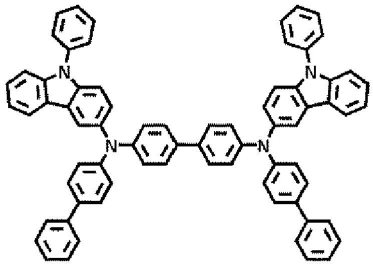

HT33

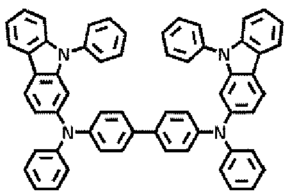

HT34

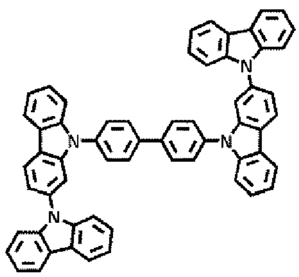

HT35

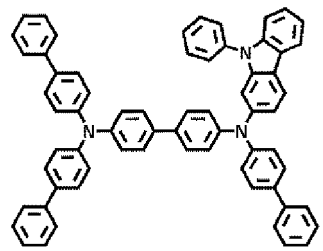

HT36

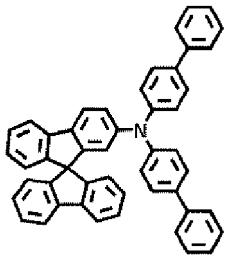

HT37

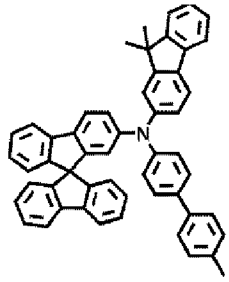

HT38

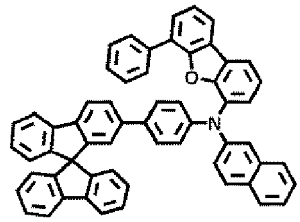

HT39

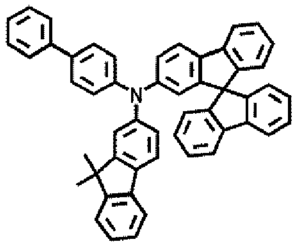

HT40

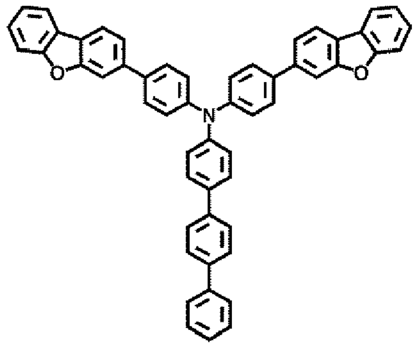

HT41

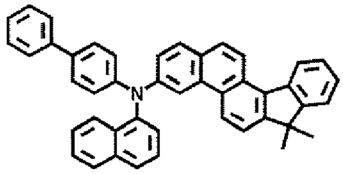

HT42

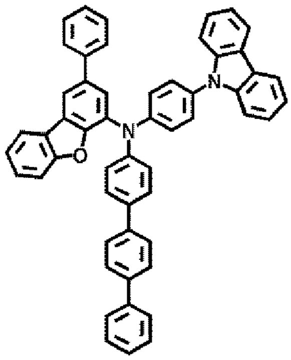

HT43

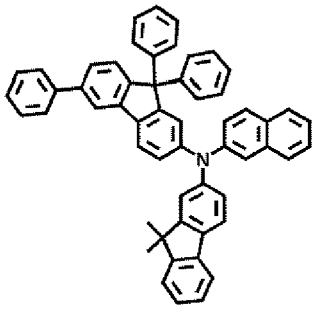

HT44

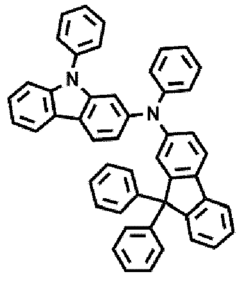

HT45

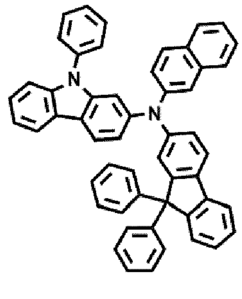

HT46

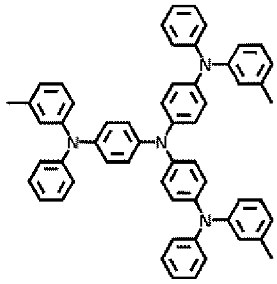
m-MTDATA

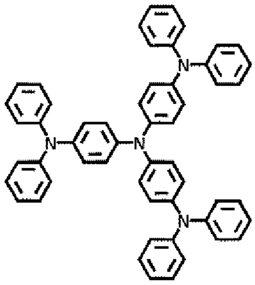
TDATA

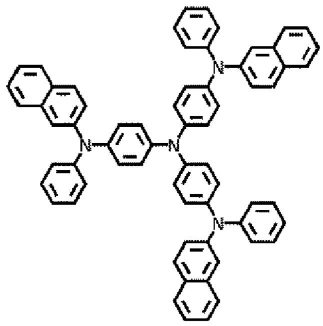
2-TNATA

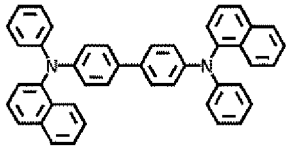
NPB

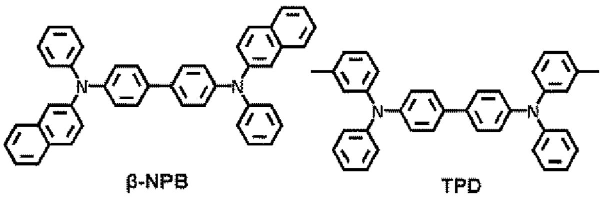
β-NPB

TPD

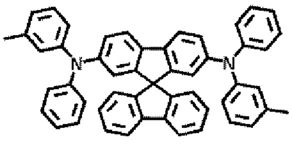
Spiro-TPD

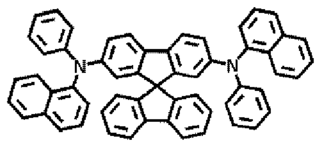
Spiro-NPB

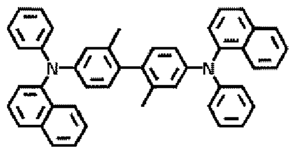
methylated-NPB

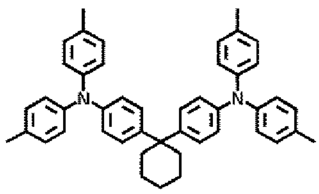
TAPC

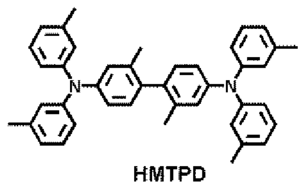
HMTPD

A thickness of the hole transport region may be in a range of about 50 Å to about 10,000 Å, for example, about 100 Å to about 4,000 Å. When the hole transport region includes a hole injection layer, a hole transport layer, or a combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory (suitable) hole transporting characteristics may be obtained without a substantial increase in driving voltage.

The emission auxiliary layer may increase light-emission efficiency by compensating for an optical resonance distance according to the wavelength of light emitted by an emission layer, and the electron-blocking layer may block or reduce the leakage of electrons from an emission layer to a hole transport region. Materials that may be included in the hole transport region may also be included in the emission auxiliary layer and/or the electron-blocking layer.

**p-dopant**

The hole transport region may further include, in addition to these materials, a charge-generation material for the improvement of conductive properties. The charge-generation material may be substantially uniformly or non-uniformly dispersed in the hole transport region (for example, in the form of a single layer including (e.g., consisting of) a charge-generation material).

The charge-generation material may be, for example, a p-dopant.

For example, the lowest unoccupied molecular orbital (LUMO) energy level of the p-dopant may be -3.5 eV or less.

In one or more embodiments, the p-dopant may include a quinone derivative, a cyano group-containing compound, a compound including element EL1 and element EL2, or one or more combinations thereof.

Examples of the quinone derivative are TCNQ, F4-TCNQ, etc.

Examples of the cyano group-containing compound are HAT-CN, and a compound represented by Formula 221.

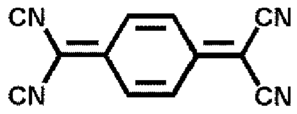

TCNQ

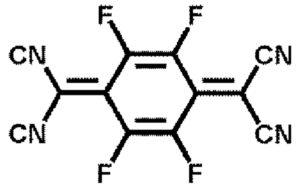

F4-TCNQ

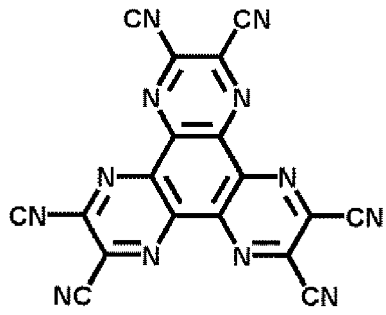

HAT-CN

**Formula 221**

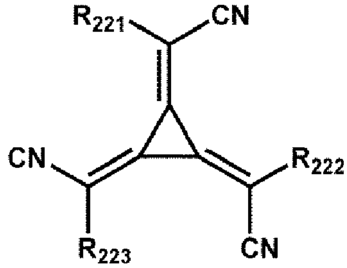

In Formula 221,

$R_{221}$ to $R_{223}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, and
at least one of $R_{221}$ to $R_{223}$ may each independently be a $C_3$-$C_{60}$ carbocyclic group or a $C_1$-$C_{60}$ heterocyclic group, each substituted with a cyano group; -F; -Cl; -Br; -I; a $C_1$-$C_{20}$ alkyl group substituted with a cyano group, -F, -Cl, -Br, -I, or one or more combinations thereof.

In the compound including element EL1 and element EL2, element EL1 may be metal, metalloid, or a combination thereof, and element EL2 may be non-metal, metalloid, or a combination thereof.

Examples of the metal are an alkali metal (for example, lithium (Li), sodium (Na), potassium (K), rubidium (Rb), cesium (Cs), etc.); alkaline earth metal (for example, beryllium (Be), magnesium (Mg), calcium (Ca), strontium (Sr), barium (Ba), etc.); transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); post-transition metal (for example, zinc (Zn), indium (In), tin (Sn), etc.); and lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Examples of the metalloid are silicon (Si), antimony (Sb), and/or tellurium (Te).

Examples of the non-metal are oxygen (O) and/or halogen (for example, F, Cl, Br, I, etc.).

Examples of the compound including element EL1 and element EL2 are metal oxide, metal halide (for example, metal fluoride, metal chloride, metal bromide, and/or metal iodide), metalloid halide (for example, metalloid fluoride, metalloid chloride, metalloid bromide, and/or metalloid iodide), metal telluride, or one or more combinations thereof.

Examples of the metal oxide are tungsten oxide (for example, WO, $W_2O_3$, $WO_2$, $WO_3$, $W_2O_5$, etc.), vanadium oxide (for example, VO, $V_2O_3$, $VO_2$, $V_2O_5$, etc.), molybdenum oxide (MoO, $Mo_2O_3$, $MoO_2$, MoOs, $Mo_2O_5$, etc.), and/or rhenium oxide (for example, $ReO_3$, etc.).

Examples of the metal halide are alkali metal halide, alkaline earth metal halide, transition metal halide, post-transition metal halide, and lanthanide metal halide.

Examples of the alkali metal halide are LiF, NaF, KF, RbF, CsF, LiCl, NaCl, KCl, RbCl, CsCl, LiBr, NaBr, KBr, RbBr, CsBr, LiI, NaI, KI, RbI, and/or CsI.

Examples of the alkaline earth metal halide are $BeF_2$, $MgF_2$, $CaF_2$, $SrF_2$, $BaF_2$, $BeCl_2$, $MgCl_2$, $CaCl_2$, $SrCl_2$,

$BaCl_2$, $BeBr_2$, $MgBr_2$, $CaBr_2$, $SrBr_2$, $BaBr_2$, $BeI_2$, $MgI_2$, $CaI_2$, $SrI_2$, and/or $BaI_2$.

Examples of the transition metal halide are titanium halide (for example, $TiF_4$, $TiCl_4$, $TiBr_4$, $TiI_4$, etc.), zirconium halide (for example, $ZrF_4$, $ZrCl_4$, $ZrBr_4$, $ZrI_4$, etc.), hafnium halide (for example, $HfF_4$, $HfCl_4$, $HfBr_4$, $HfI_4$, etc.), vanadium halide (for example, $VF_3$, $VCl_3$, $VBr_3$, $VI_3$, etc.), niobium halide (for example, $NbF_3$, $NbCl_3$, $NbBr_3$, $NbI_3$, etc.), tantalum halide (for example, $TaF_3$, $TaCl_3$, $TaBr_3$, $TaI_3$, etc.), chromium halide (for example, $CrF_3$, $CrCl_3$, $CrBr_3$, $CrI_3$, etc.), molybdenum halide (for example, $MoF_3$, $MoCl_3$, $MoBr_3$, $MoI_3$, etc.), tungsten halide (for example, $WF_3$, $WCl_3$, $WBr_3$, $WI_3$, etc.), manganese halide (for example, $MnF_2$, $MnCl_2$, $MnBr_2$, $MnI_2$, etc.), technetium halide (for example, $TcF_2$, $TcCl_2$, $TcBr_2$, $TcI_2$, etc.), rhenium halide (for example, $ReF_2$, $ReCl_2$, $ReBr_2$, $ReI_2$, etc.), iron halide (for example, $FeF_2$, $FeCl_2$, $FeBr_2$, $FeI_2$, etc.), ruthenium halide (for example, $RuF_2$, $RuCl_2$, $RuBr_2$, $RuI_2$, etc.), osmium halide (for example, $OsF_2$, $OsCl_2$, $OsBr_2$, $OsI_2$, etc.), cobalt halide (for example, $CoF_2$, $CoCl_2$, $CoBr_2$, $CoI_2$, etc.), rhodium halide (for example, $RhF_2$, $RhCl_2$, $RhBr_2$, $RhI_2$, etc.), iridium halide (for example, $IrF_2$, $IrCl_2$, $IrBr_2$, $IrI_3$, etc.), nickel halide (for example, $NiF_2$, $NiCl_2$, $NiBr_2$, $NH_2$, etc.), palladium halide (for example, $PdF_2$, $PdCl_2$, $PdBr_2$, $PdI_2$, etc.), platinum halide (for example, $PtF_2$, $PtCl_2$, $PtBr_2$, $PtI_2$, etc.), copper halide (for example, CuF, CuCl, CuBr, CuI, etc.), silver halide (for example, AgF, AgCl, AgBr, AgI, etc.), and/or gold halide (for example, AuF, AuCl, AuBr, AuI, etc.).

Examples of the post-transition metal halide are zinc halide (for example, $ZnF_2$, $ZnCl_2$, $ZnBr_2$, $ZnI_3$, etc.), indium halide (for example, $InI_3$, etc.), and/or tin halide (for example, $SnI_2$, etc.).

Examples of the lanthanide metal halide are YbF, $YbF_2$, $YbF_3$, $SmF_3$, YbCl, $YbCl_2$, $YbCl_3$ $SmCl_3$, YbBr, $YbBr_2$, $YbBr_3$, $SmBr_3$, YbI, $YbI_2$, $YbI_3$, $SmI_3$, and/or the like.

An example of the metalloid halide is antimony halide (for example, $SbCl_5$, etc.).

Examples of the metal telluride are alkali metal telluride (for example, $Li_2Te$, $Na_2Te$, $K_2Te$, $Rb_2Te$, $Cs_2Te$, etc.), alkaline earth metal telluride (for example, BeTe, MgTe, CaTe, SrTe, BaTe, etc.), transition metal telluride (for example, $TiTe_2$, $ZrTe_2$, $HfTe_2$, $V_2Te_3$, $Nb_2Te_3$, $Ta_2Te_3$, $Cr_2Te_3$, $Mo_2Te_3$, $W_2Te_3$, MnTe, TcTe, ReTe, FeTe, RuTe, OsTe, CoTe, RhTe, IrTe, NiTe, PdTe, PtTe, $Cu_2Te$, CuTe, $Ag_2Te$, AgTe, $Au_2Te$, etc.), post-transition metal telluride (for example, ZnTe, etc.), and/or lanthanide metal telluride (for example, LaTe, CeTe, PrTe, NdTe, PmTe, EuTe, GdTe, TbTe, DyTe, HoTe, ErTe, TmTe, YbTe, LuTe, etc.).

## Emission layer in interlayer 130

When the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers selected from a red emission layer, a green emission layer, and a blue emission layer, in which the two or more layers contact each other or are separated from each other to emit white light. In one or more embodiments, the emission layer may include two or more materials selected from a red light-emitting material, a green light-emitting material, and a blue light-emitting material, in which the two or more materials are mixed with each other in a single layer to emit white light.

In an embodiment, the emission layer may further include a host, an auxiliary dopant, a sensitizer, delayed fluorescence material, or one or more combinations thereof, in addition to the first emitter as described in the present disclosure.

When the emission layer further includes a host in addition to the first emitter, the amount of the first emitter is from about 0.01 to about 15 parts by weight based on 100 parts by weight of the host.

A thickness of the emission layer may be in a range of about 100 Å to about 1,000 Å, for example, about 200 Å to about 600 Å. When the thickness of the emission layer is within these ranges, excellent or suitable light-emission characteristics may be obtained without a substantial increase in driving voltage.

## Host

The host in the emission layer may include an electron-transporting compound described herein (for example, refer to the compounds represented by Formula 2-1 or 2-2), a hole-transporting compound described herein (for example, refer to a compound represented by one of Formulae 3-1 to 3-5), or a combination thereof.

In one or more embodiments, the host may include an alkali earth metal complex, a post-transition metal complex, or a combination thereof. For example, the host may include a Be complex (for example, Compound H55), an Mg complex, a Zn complex, or one or more combinations thereof.

In one or more embodiments, the host may include at least one of Compounds H1 to H130, 9,10-di(2-naphthyl)anthracene (ADN), 2-methyl-9,10-bis(naphthalen-2-yl)anthracene (MADN), 9,10-di(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), or one or more combinations thereof:

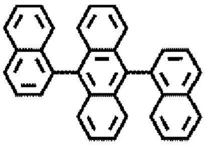

H1

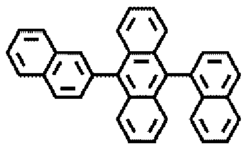

H2

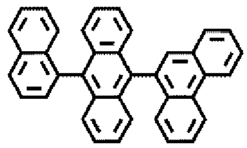

H3

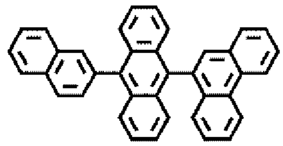

H4

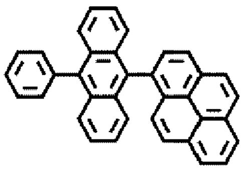

H5

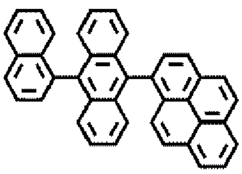

H6

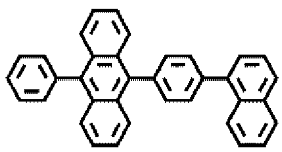

H7

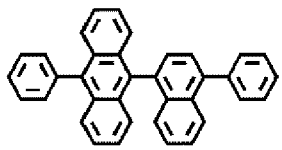

H8

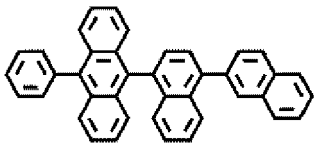

H9

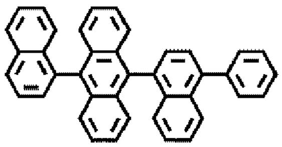

H10

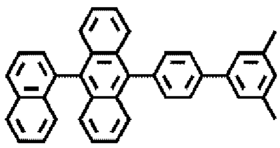

H11

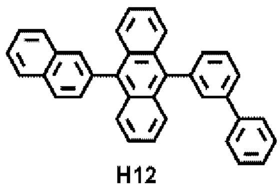

H12

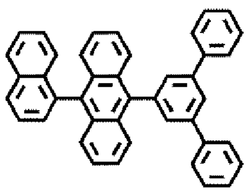

H13

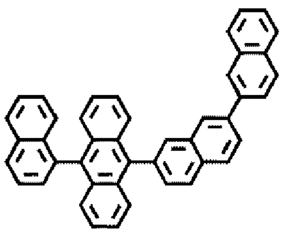

H14

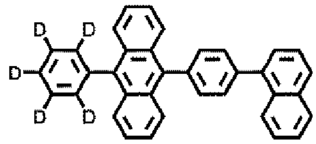

H15

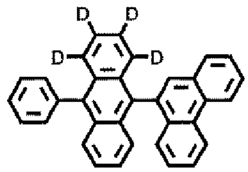

H16

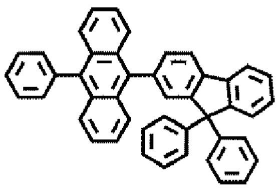

H17

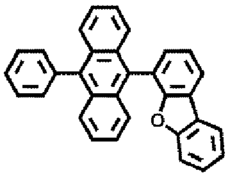

H18

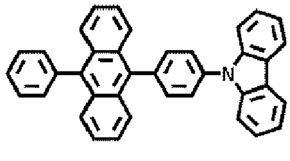

H19

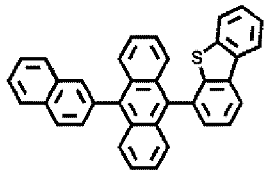

H20

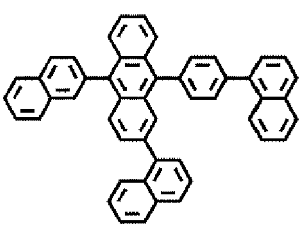

H21

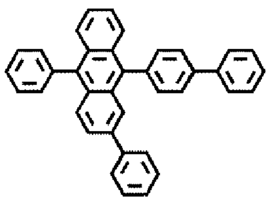

H22

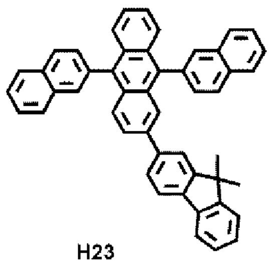

H23

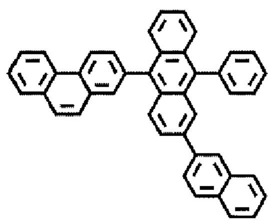

H24

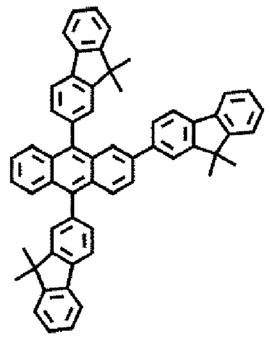
H25

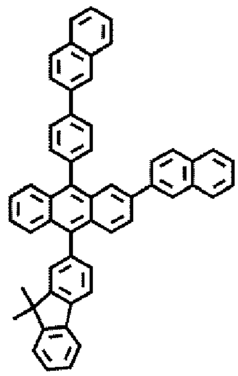
H26

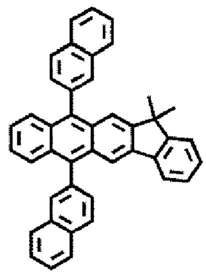
H27

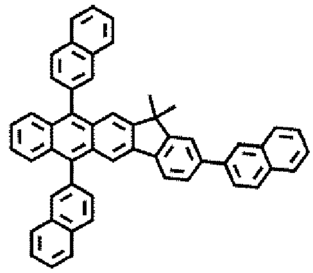
H28

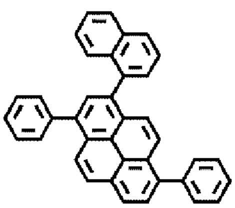
H29

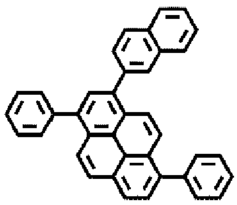
H30

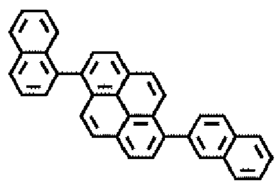
H31

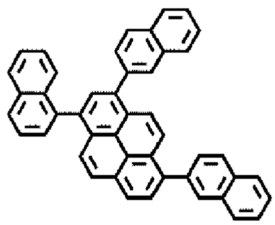
H32

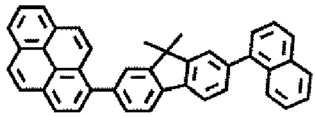
H33

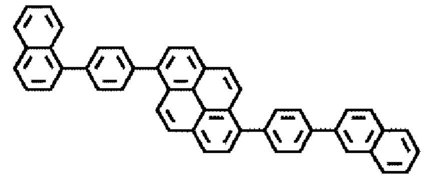
H34

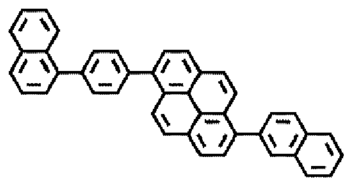
H35

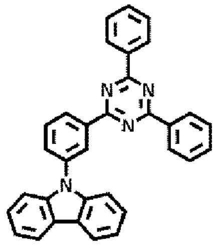
H36

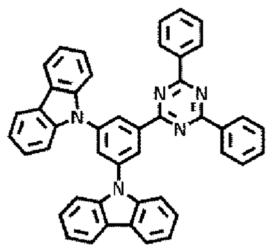
H37

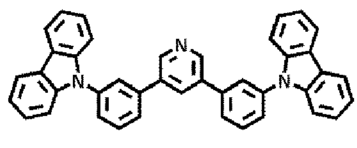
H38

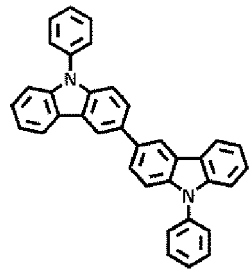
H39

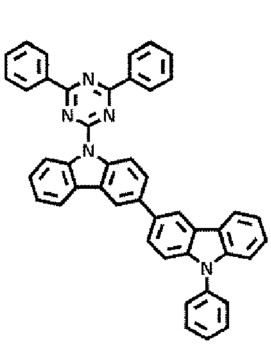
H40

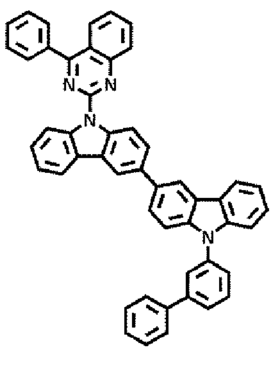
H41

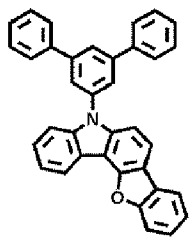
H42

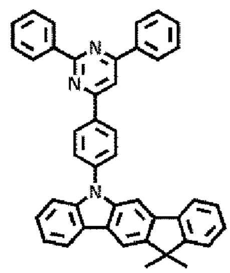
H43

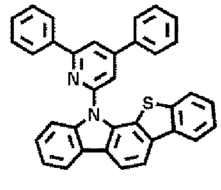
H44

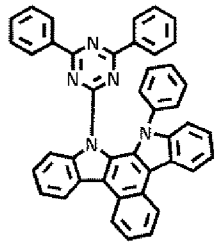
H45

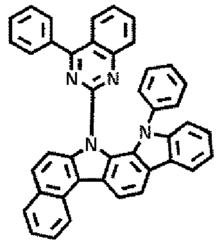
H46

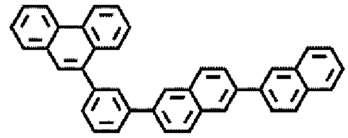
H47

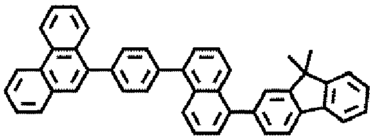
H48

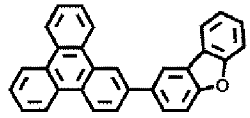
H49

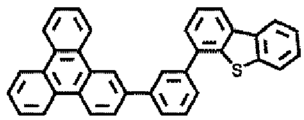
H50

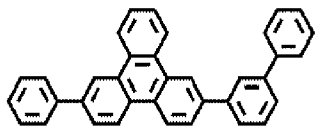
H51

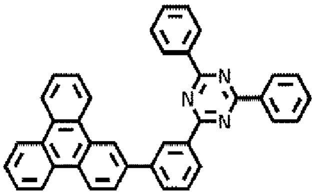
H52

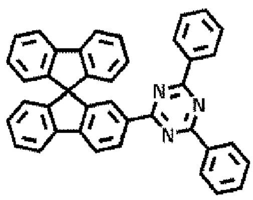
H53

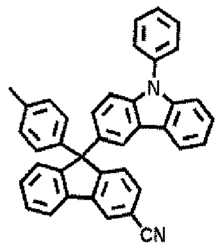
H54

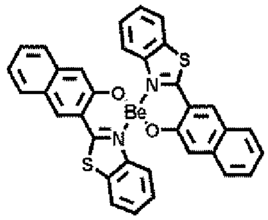
H55

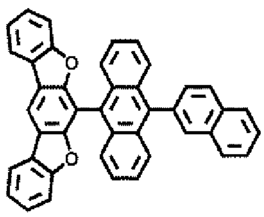
H56

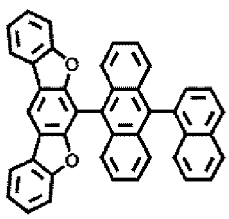
H57

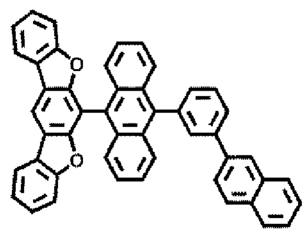
H58

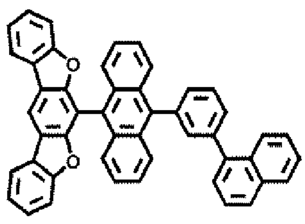
H59

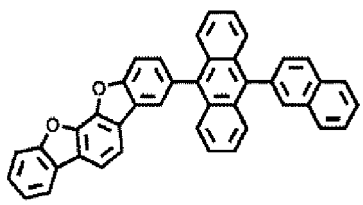
H60

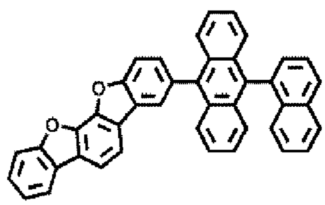
H61

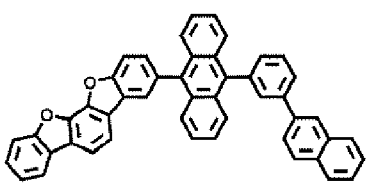
H62

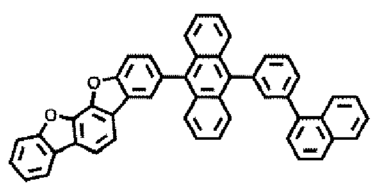
H63

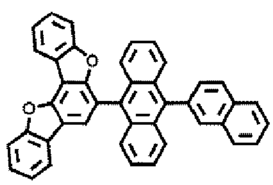
H64

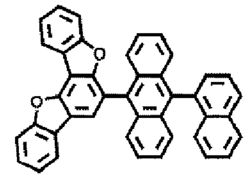
H65
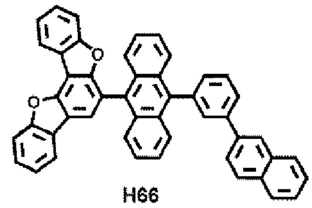
H66
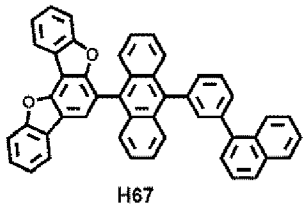
H67

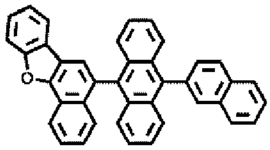
H68
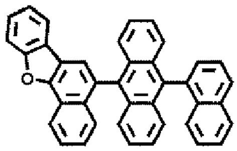
H69
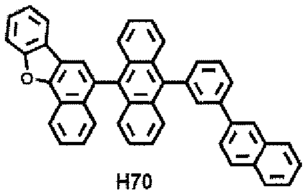
H70
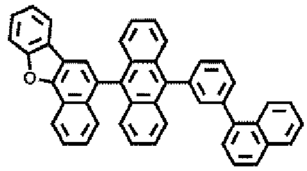
H71

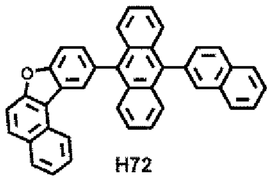
H72
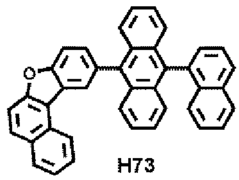
H73
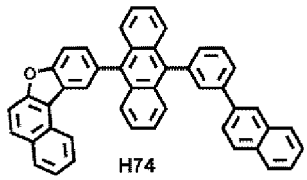
H74
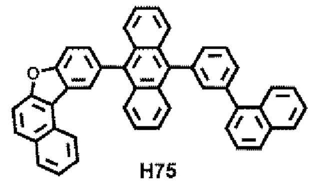
H75

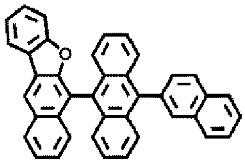
H76
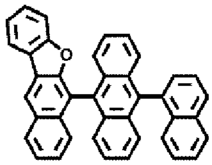
H77
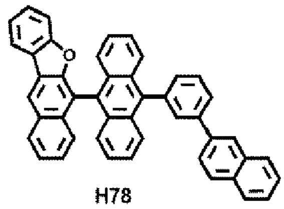
H78
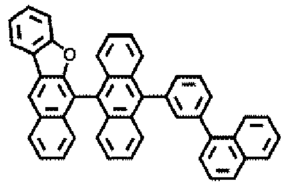
H79

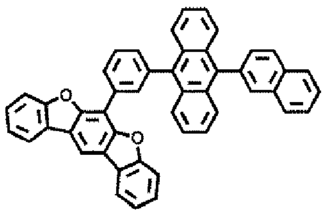
H80
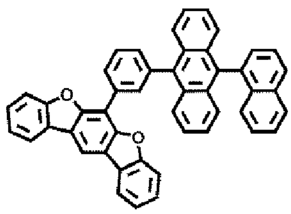
H81
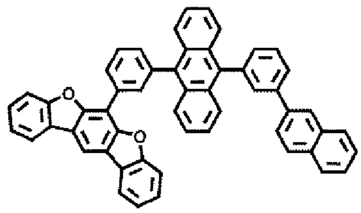
H82

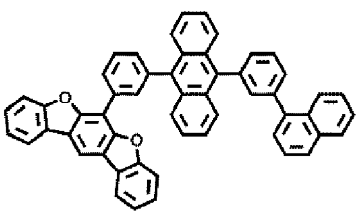
H83
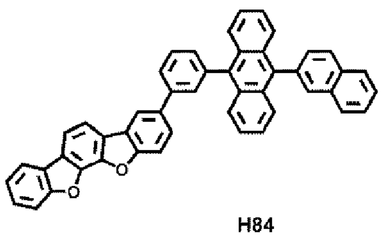
H84
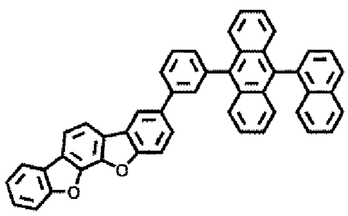
H85

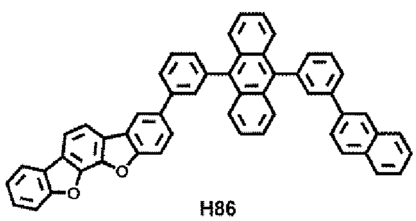
H86
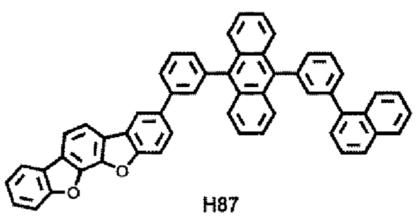
H87
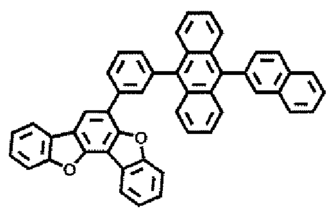
H88

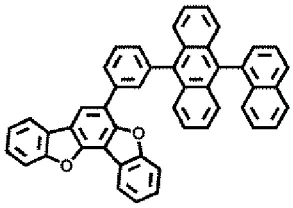
H89

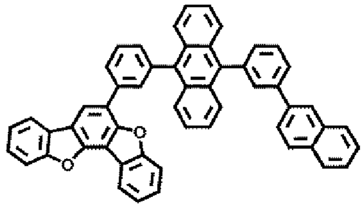
H90

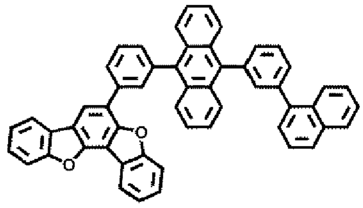
H91

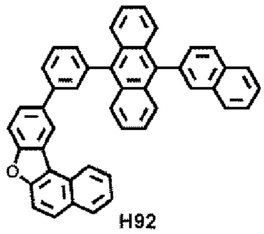
H92

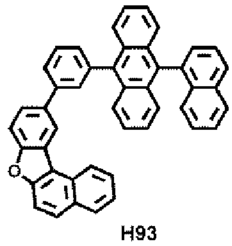
H93

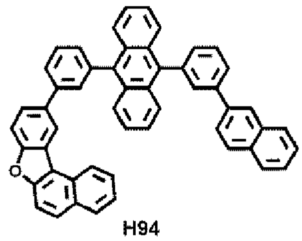
H94

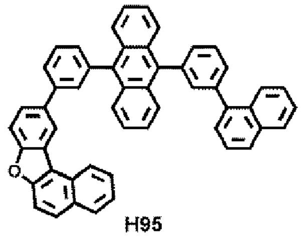
H95

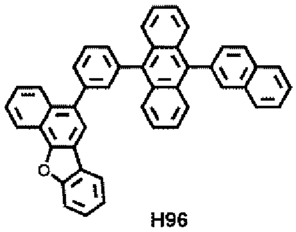
H96

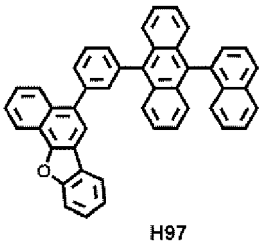
H97

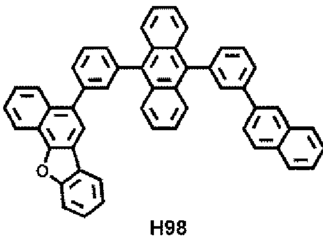
H98

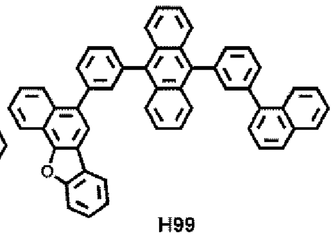
H99

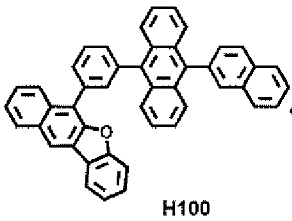
H100

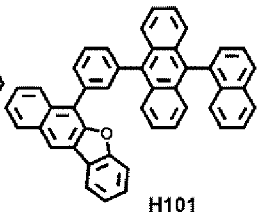
H101

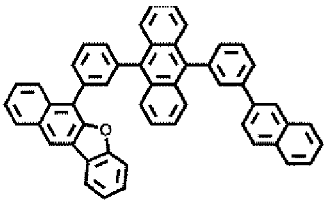
H102

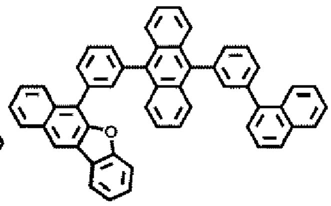
H103

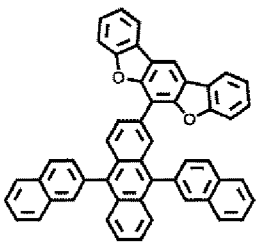
H104

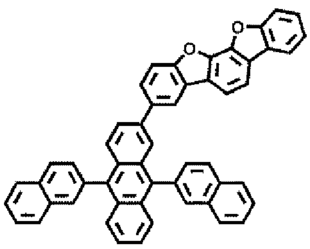
H105

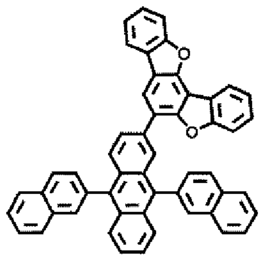
H106

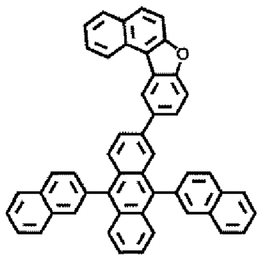
H107

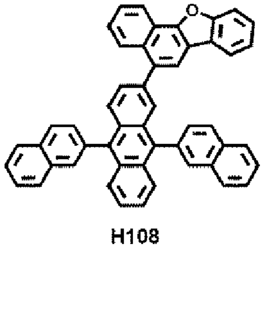
H108

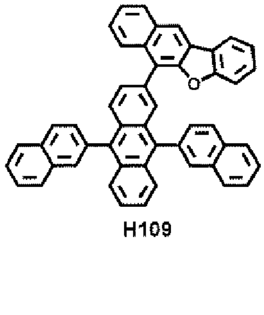
H109

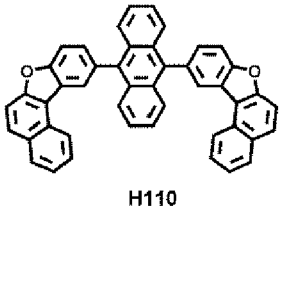
H110

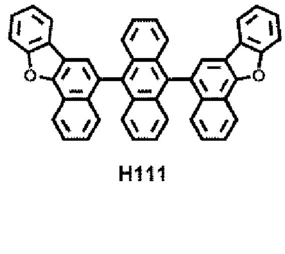
H111

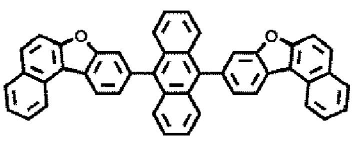

H112

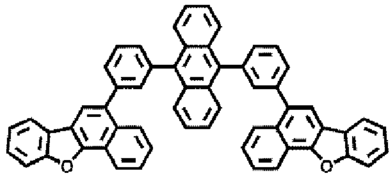

H113

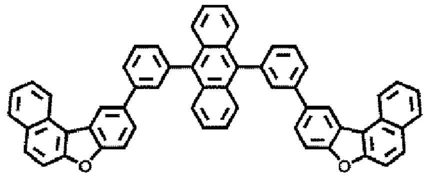

H114

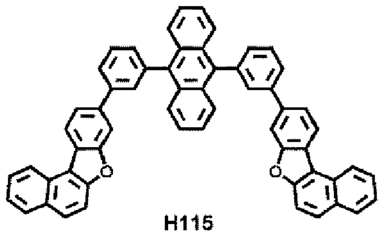

H115

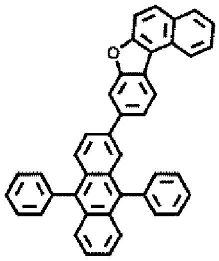

H116

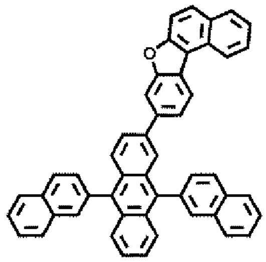

H117

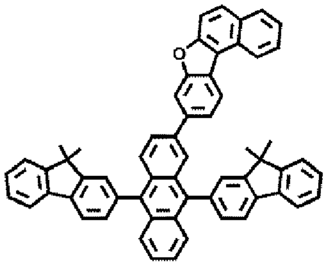

H118

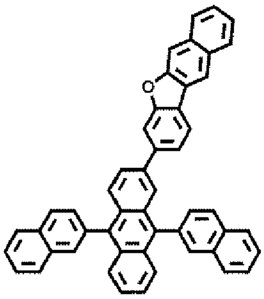

H119

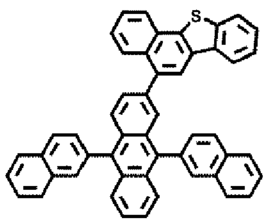

H120

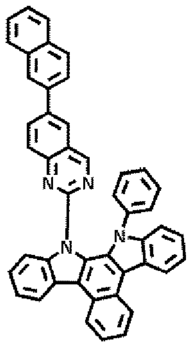

H121

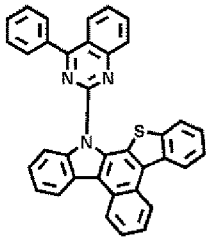

H122

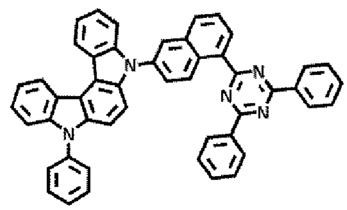

H123

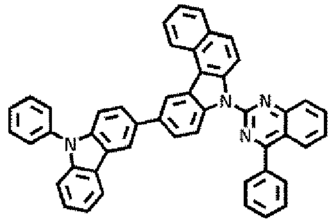

H124

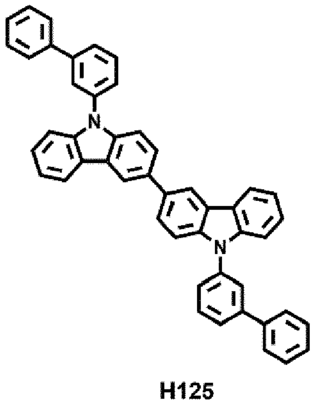

H125

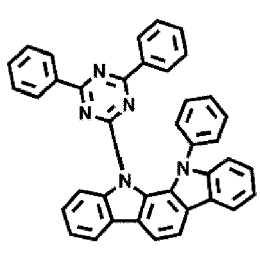

H126

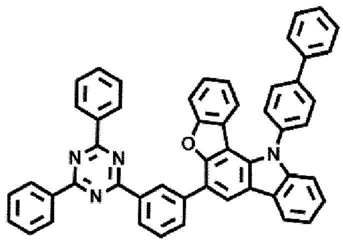

H127

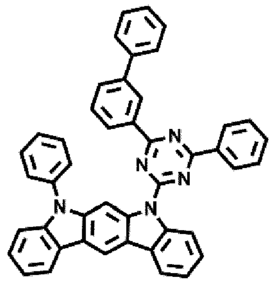

H128

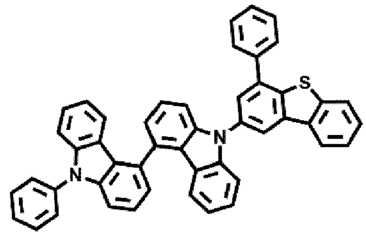

H129

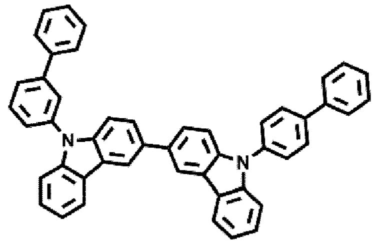

H130

In an embodiment, the host may include a silicon-containing compound, a phosphine oxide-containing compound, or a combination thereof.

The host may have one or more suitable modifications. For example, the host may include only one kind of compound, or may include two or more kinds of different compounds.

**Phosphorescent dopant**

The emission layer may include, as a phosphorescent dopant, the first emitter as described herein.

In an embodiment, the emission layer may further include, in addition to the first emitter as described in the present disclosure, an organometallic compound represented by Formula 401:

**Formula 401** $M(L_{401})_{xc1}(L_{402})_{xc2}$

**Formula 402**

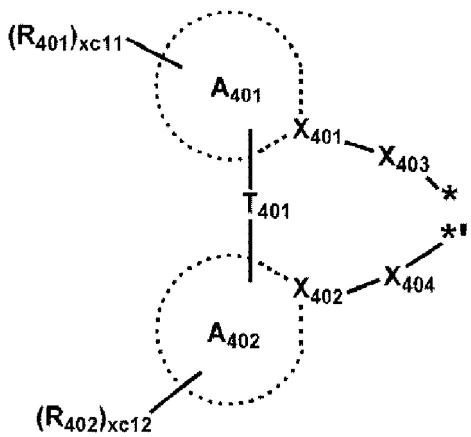

,

wherein, in Formulae 401 and 402,

M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),

$L_{401}$ may be a ligand represented by Formula 402, and xc1 may be 1, 2, or 3, wherein when xc1 is two or more, two or more of $L_{401}$(s) may be identical to or different from each other,

$L_{402}$ may be an organic ligand, and xc2 may be 0, 1, 2, 3, or 4, and when xc2 is 2 or more, two or more of $L_{402}$(s) may be identical to or different from each other,

$X_{401}$ and $X_{402}$ may each independently be nitrogen or carbon,

ring $A_{401}$ and ring $A_{402}$ may each independently be a $C_3$-$C_{60}$ carbocyclic group or a $C_1$-$C_{60}$ heterocyclic group,

$T_{401}$ may be a single bond, *-O-*', *-S-*', *-C(=O)-*', *-N($Q_{411}$)-*', *-C($Q_{411}$)($Q_{412}$)-*', *-C($Q_{411}$)=C($Q_{412}$)-*', *-C($Q_{411}$)=*', or *=C($Q_{411}$)=*',

$X_{403}$ and $X_{404}$ may each independently be a chemical bond (for example, a covalent bond or a coordination bond),

O, S, $N(Q_{413})$, $B(Q_{413})$, $P(Q_{413})$, $C(Q_{413})(Q_{414})$, or $Si(Q_{413})(Q_{414})$,
$Q_{411}$ to $Q_{414}$ may each be the same as described herein with respect to $Q_1$,
$R_{401}$ and $R_{402}$ may each independently be hydrogen, deuterium, -F, -Cl, -Br, -I, a hydroxyl group, a cyano group, a nitro group, a $C_1$-$C_{20}$ alkyl group unsubstituted or substituted with at least one $R_{10a}$, a $C_1$-$C_{20}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, $-Si(Q_{401})(Q_{402})(Q_{403})$, $-N(Q_{401})(Q_{402})$, $-B(Q_{401})(Q_{402})$, $-C(=O)(Q_{401})$, $-S(=O)_2(Q_{401})$, or $-P(=O)(Q_{401})(Q_{402})$,
$Q_{401}$ to $Q_{403}$ may each be the same as described herein with respect to $Q_1$,
xc11 and xc12 may each independently be an integer from 0 to 10, and
* and *' in Formula 402 each indicate a binding site to M in Formula 401.

For example, in Formula 402, i) $X_{401}$ may be nitrogen, and $X_{402}$ may be carbon, or ii) each of $X_{401}$ and $X_{402}$ may be nitrogen.
In one or more embodiments, when xc1 in Formula 402 is 2 or more, two ring $A_{401}$(s) in two or more of $L_{401}$(s) may be optionally linked to each other via $T_{402}$, which is a linking group, or two ring $A_{402}$(s) may be optionally linked to each other via $T_{403}$, which is a linking group (see Compounds PD1 to PD4 and PD7). $T_{402}$ and $T_{403}$ may each be the same as described herein with respect to $T_{401}$.
$L_{402}$ in Formula 401 may be an organic ligand. For example, $L_{402}$ may include a halogen group, a diketone group (for example, an acetylacetonate group), a carboxylic acid group (for example, a picolinate group), -C(=O), an isonitrile group, -CN group, a phosphorus group (for example, a phosphine group, a phosphite group, etc.), or one or more combinations thereof.

**Fluorescent dopant**

The emission layer may further include a fluorescent dopant in addition to the first emitter as described in the present disclosure.
The fluorescent dopant may include an arylamine compound, a styrylamine compound, a boron-containing compound, or one or more combinations thereof.
For example, the fluorescent dopant may include a compound represented by Formula 501:

Formula 501

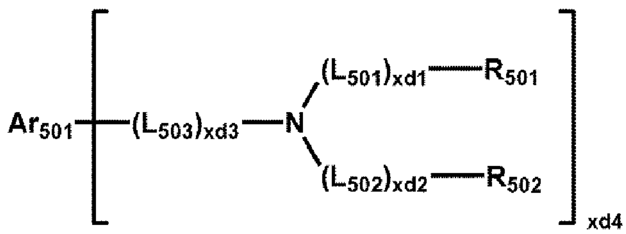

wherein, in Formula 501,

$Ar_{501}$, $L_{501}$ to $L_{503}$, $R_{501}$, and $R_{502}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
xd1 to xd3 may each independently be 0, 1, 2, or 3, and
xd4 may be 1, 2, 3, 4, 5, or 6.

For example, $Ar_{501}$ in Formula 501 may be a condensed cyclic group (for example, an anthracene group, a chrysene group, or a pyrene group) in which three or more monocyclic groups are condensed together.
In one or more embodiments, xd4 in Formula 501 may be 2.
For example, the fluorescent dopant may include: at least one of Compounds FD1 to FD36; DPVBi; DPAVBi; or one or more combinations thereof:

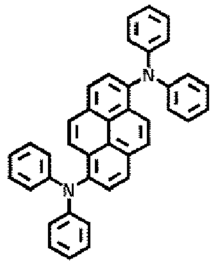

FD1

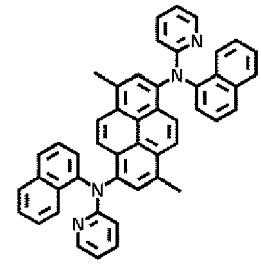

FD2

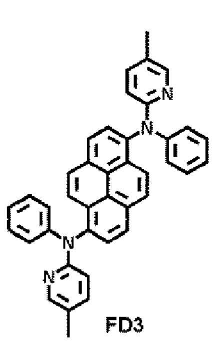

FD3

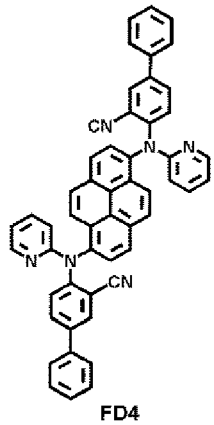

FD4

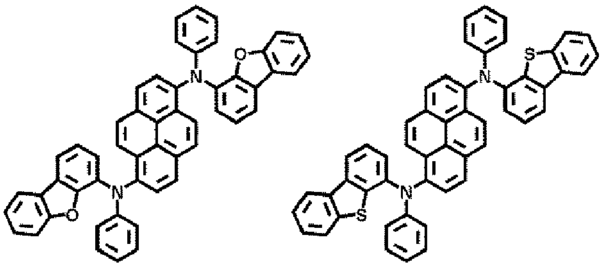

FD5

FD6

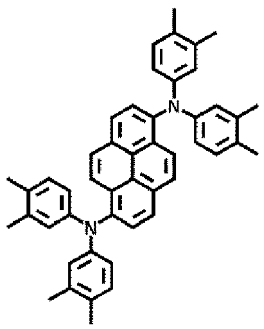

FD7

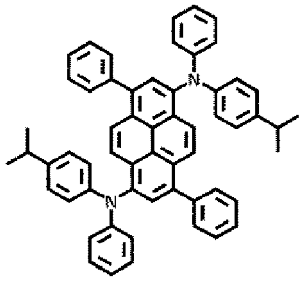

FD8

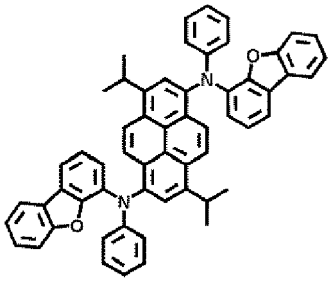

FD9

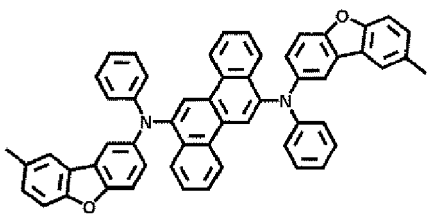

FD10

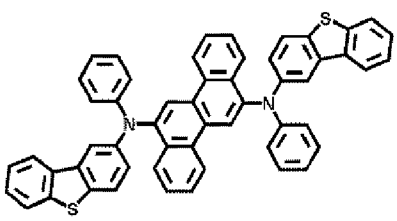

FD11

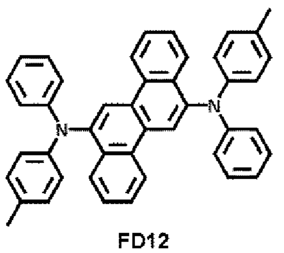

FD12

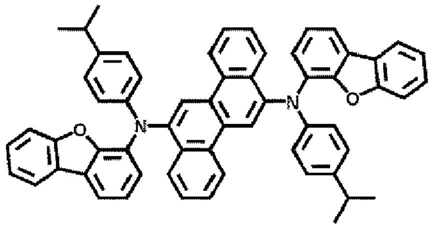

FD13

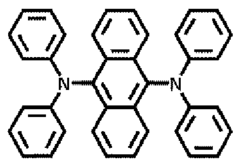

FD14

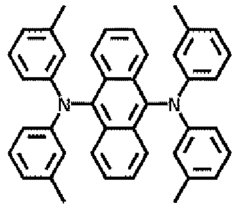
FD15

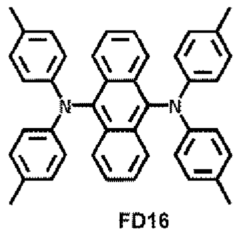
FD16

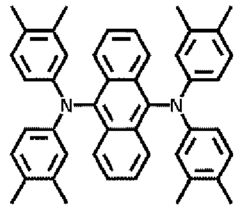
FD17

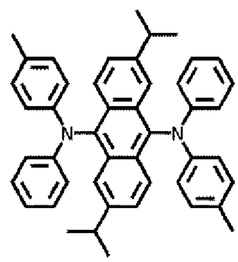
FD18

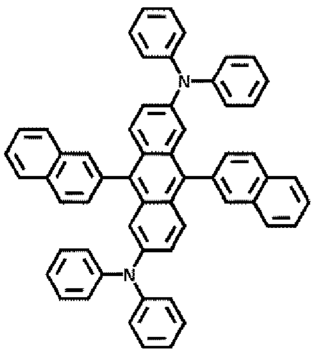
FD19

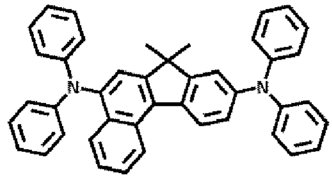
FD20

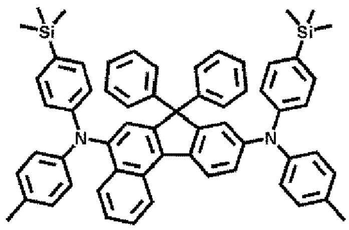
FD21

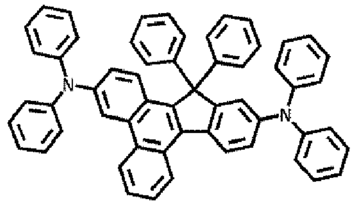
FD22

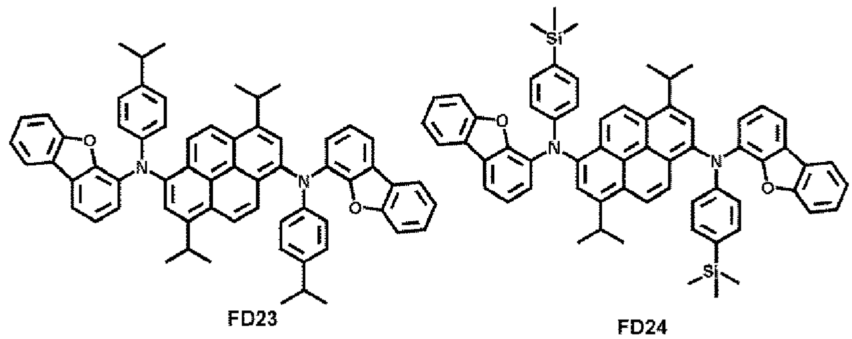
FD23

FD24

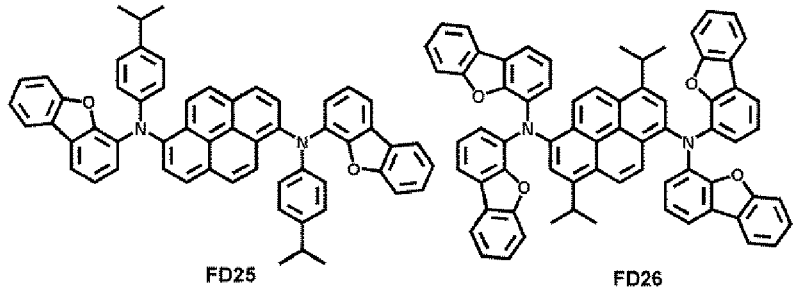
FD25

FD26

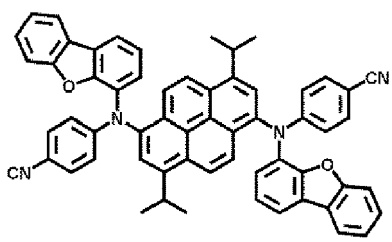
FD27

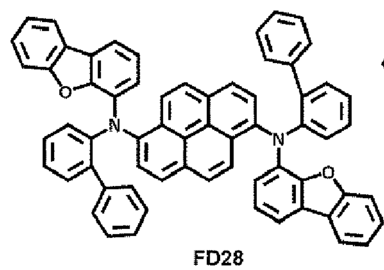

FD28

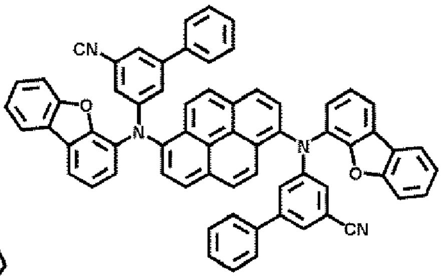

FD29

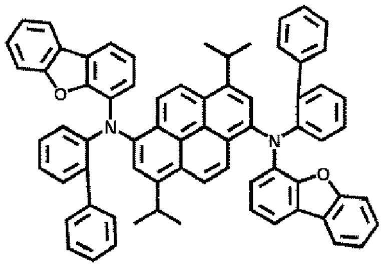

FD30

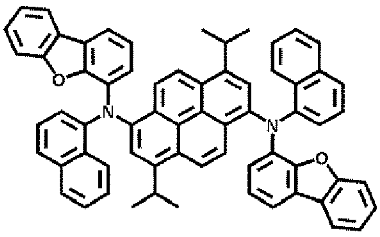

FD31

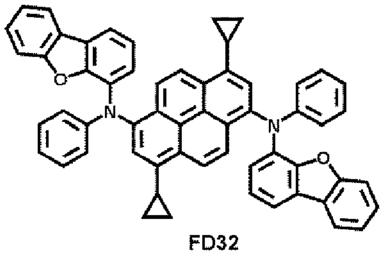

FD32

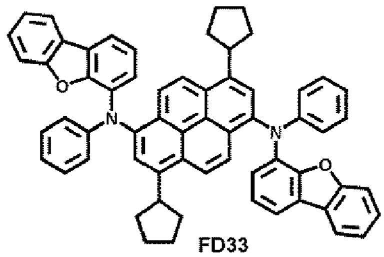

FD33

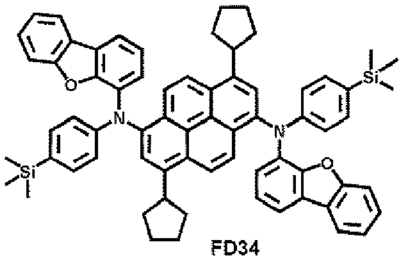

FD34

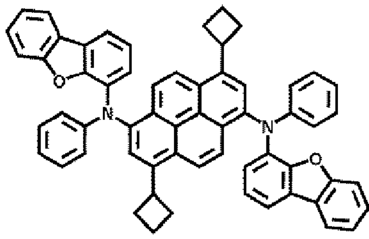

FD35

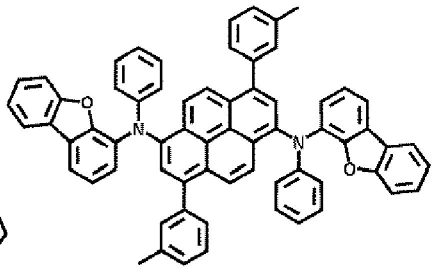

FD36

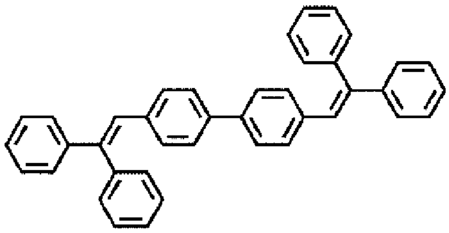

DPVBi

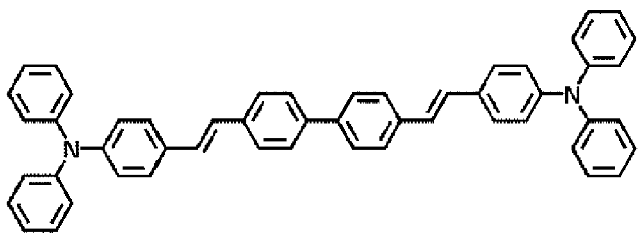

DPAVBi

**Delayed fluorescence material**

The emission layer may further include a delayed fluorescence material.

In the present disclosure, the delayed fluorescence material may be selected from compounds capable of emitting delayed fluorescent light based on a delayed fluorescence emission mechanism.

The delayed fluorescence material included in the emission layer may act as a host or a dopant depending on the type or kind of other materials included in the emission layer.

In one or more embodiments, the difference between the triplet energy level (eV) of the delayed fluorescence material and the singlet energy level (eV) of the delayed fluorescence material may be greater than or equal to 0 eV and less than or equal to 0.5 eV. When the difference between the triplet energy level (eV) of the delayed fluorescence material and the singlet energy level (eV) of the delayed fluorescence material satisfies the above-described range, up-conversion from the triplet state to the singlet state of the delayed fluorescence materials may effectively occur, and thus, the luminescence efficiency of the light-emitting device 10 may be improved (increased).

For example, the delayed fluorescence material may include i) a material including at least one electron donor

(for example, a π electron-rich $C_3$-$C_{60}$ cyclic group, such as a carbazole group) and at least one electron acceptor (for example, a sulfoxide group, a cyano group, or a π electron-deficient nitrogen-containing $C_1$-$C_{60}$ cyclic group), and ii) a material including a $C_8$-$C_{60}$ polycyclic group in which two or more cyclic groups are condensed while sharing boron (B).

Examples of the delayed fluorescence material may include at least one of the following compounds DF1 to DF9:

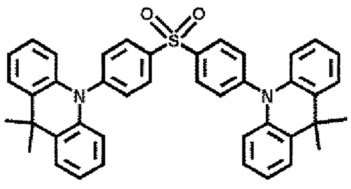

DF1(DMAC-DPS)

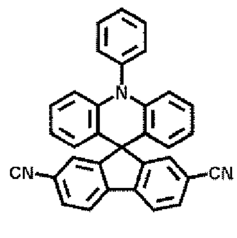

DF2(ACRFLCN)

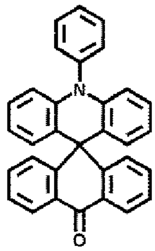

DF3(ACRSA)

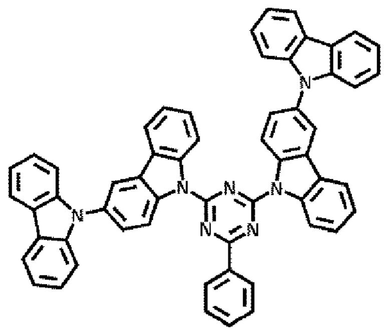

DF4(CC2TA)

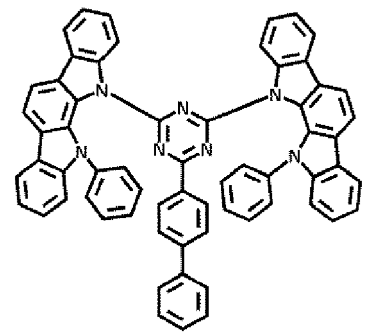

DF5(PIC-TRZ)

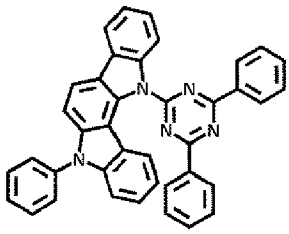

DF6(PIC-TRZ2)

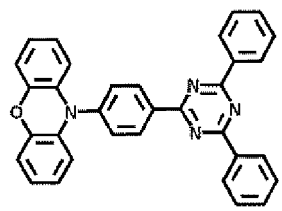

DF7(PXZ-TRZ)

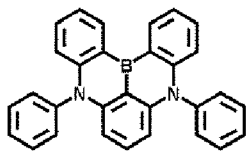

DF8(DABNA-1)

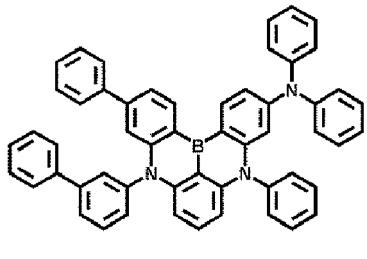

DF9(DABNA-2)

**Electron transport region in interlayer 130**

The electron transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron transport region may include a buffer layer, a hole-blocking layer, an electron control layer, an electron transport layer, an electron injection layer, or one or more combinations thereof.

For example, the electron transport region may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, the constituting layers of each structure being sequentially stacked from an emission layer.

In an embodiment, the electron transport region (for example, the buffer layer, the hole-blocking layer, the electron control layer, or the electron transport layer in the electron transport region) may include a metal-free compound including at least one π electron-deficient nitrogen-containing $C_1$-$C_{60}$ cyclic group.

For example, the electron transport region may include a compound represented by Formula 601:

**Formula 601** $[Ar_{601}]_{xe11}$-$[(L_{601})_{xe1}$-$R_{601}]_{xe21}$

wherein, in Formula 601,

$Ar_{601}$ and $L_{601}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
xe11 may be 1, 2, or 3,
xe1 may be 0, 1, 2, 3, 4, or 5,
$R_{601}$ may be a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, - $Si(Q_{601})(Q_{602})(Q_{603})$, $-C(=O)(Q_{601})$, $-S(=O)_2(Q_{601})$, or $-P(=O)(Q_{601})(Q_{602})$,
$Q_{601}$ to $Q_{603}$ may each be the same as described herein with respect to $Q_1$,
xe21 may be 1, 2, 3, 4, or 5,
at least one of $Ar_{601}$, $L_{601}$, and $R_{601}$ may each independently be a $\pi$ electron-deficient nitrogen-containing $C_1$-$C_{60}$ cyclic group unsubstituted or substituted with at least one $R_{10a}$.

For example, when xe11 in Formula 601 is 2 or more, two or more of $Ar_{601}$(s) may be linked to each other via a single bond.
In other embodiments, $Ar_{601}$ in Formula 601 may be a substituted or unsubstituted anthracene group.
In other embodiments, the electron transport region may include a compound represented by Formula 601-1:

**Formula 601-1**

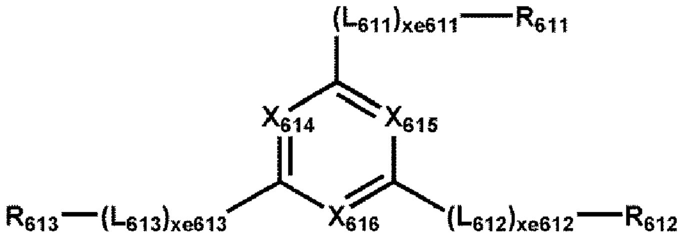

wherein, in Formula 601-1,

$X_{614}$ may be N or $C(R_{614})$, $X_{615}$ may be N or $C(R_{615})$, $X_{616}$ may be N or $C(R_{616})$, and at least one of $X_{614}$ to $X_{616}$ may be N,
$L_{611}$ to $L_{613}$ may each be the same as described herein with respect to $L_{601}$,
xe611 to xe613 may each be the same as described herein with respect to xe1,
$R_{611}$ to $R_{613}$ may each be the same as described herein with respect to $R_{601}$, and
$R_{614}$ to $R_{616}$ may each independently be hydrogen, deuterium, -F, -Cl, -Br, -I, a hydroxyl group, a cyano group, a nitro group, a $C_1$-$C_{20}$ alkyl group, a $C_1$-$C_{20}$ alkoxy group, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$.

For example, xe1 and xe611 to xe613 in Formulae 601 and 601-1 may each independently be 0, 1, or 2.
The electron transport region may include at least one of Compounds ET1 to ET46, 2,9-dimethyl-4,7-diphenyl-1,10-phenanthroline (BCP), 4,7-diphenyl-1,10-phenanthroline (Bphen), $Alq_3$, BAlq, TAZ, NTAZ, or one or more combinations thereof:

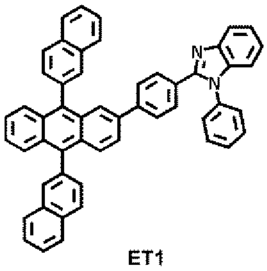
ET1

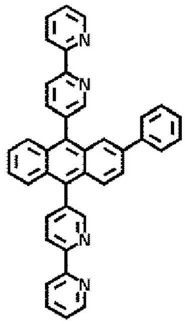
ET2

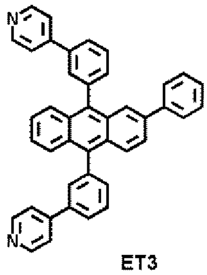
ET3

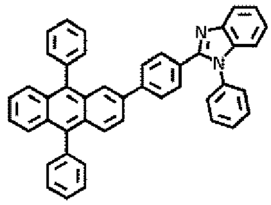
ET4

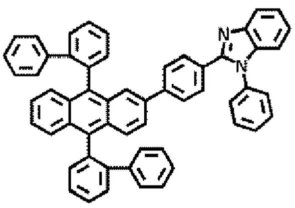
ET5

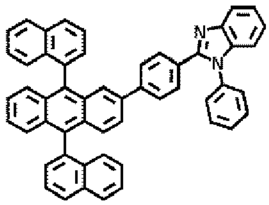
ET6

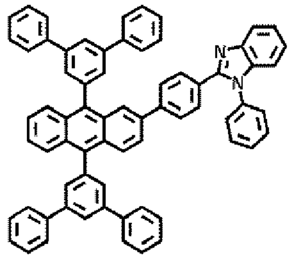
ET7

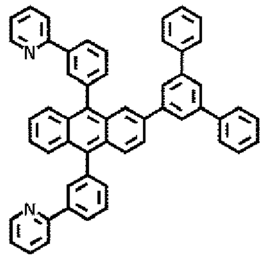
ET8

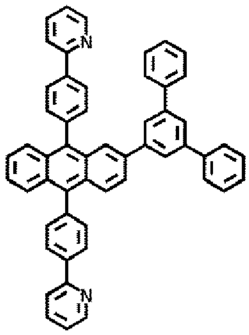
ET9

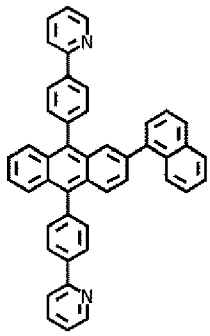
ET10

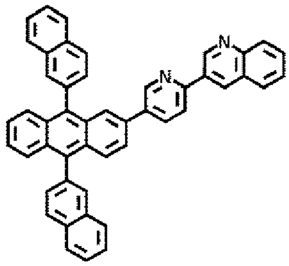
ET11

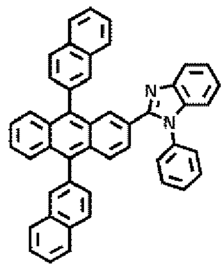
ET12

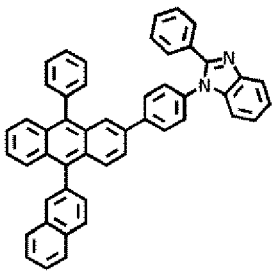
ET13

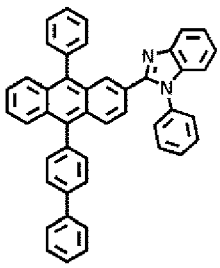
ET14

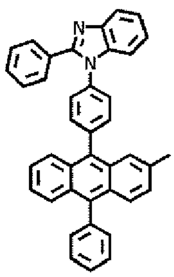
ET15

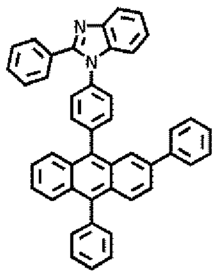
ET16

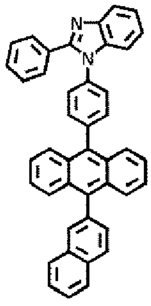
ET17

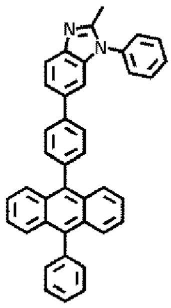
ET18

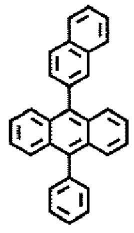
ET19

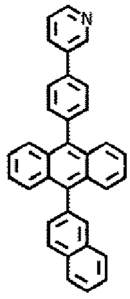
ET20

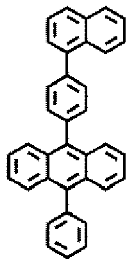
ET21

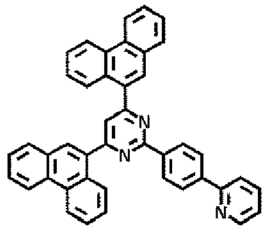
ET22

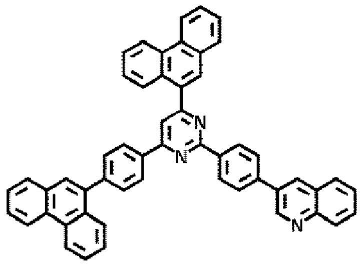
ET23

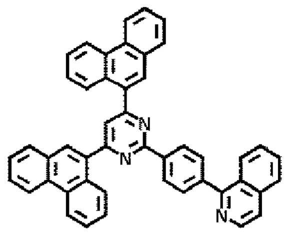
ET24

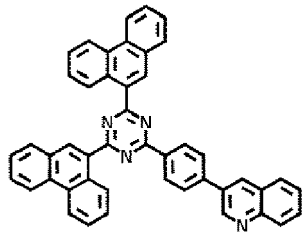
ET25

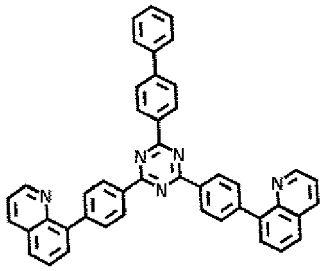
ET26

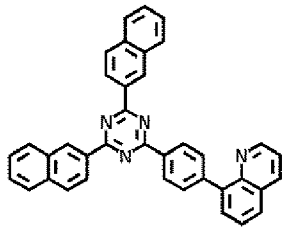
ET27

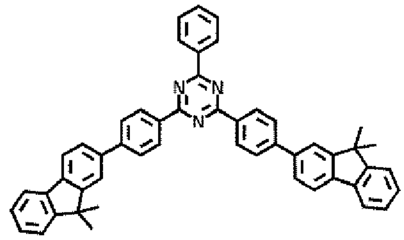
ET28

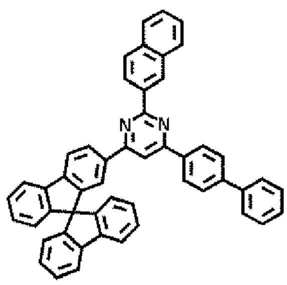
ET29

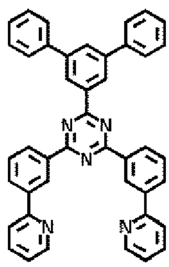
ET30

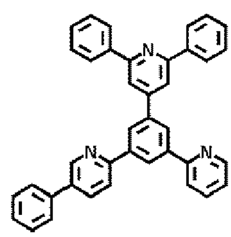
ET31

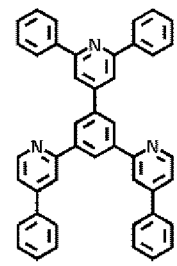
ET32

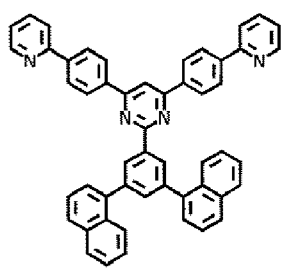
ET33

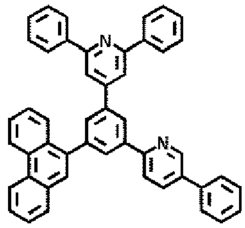
ET34

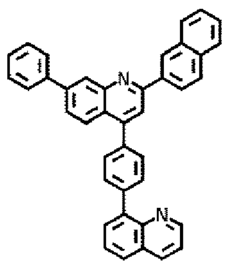
ET35

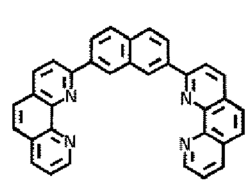
ET36

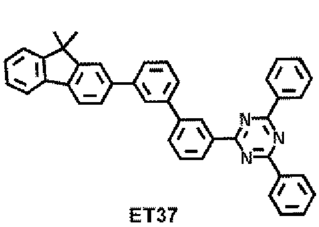
ET37

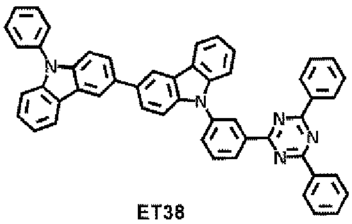
ET38

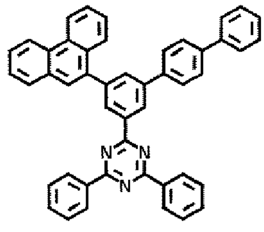
ET39

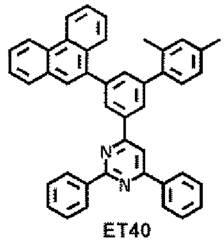
ET40

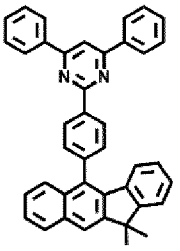
ET41

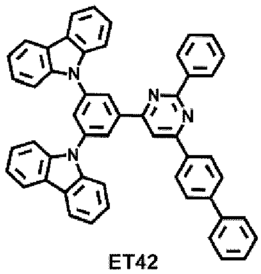
ET42

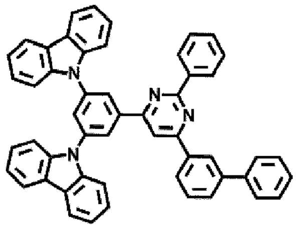
ET43

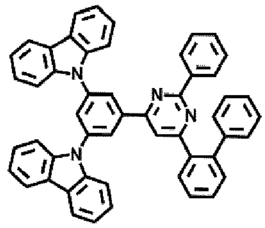
ET44

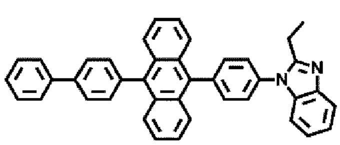
ET45

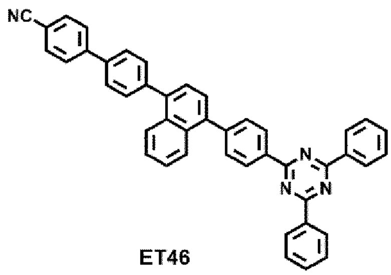
ET46

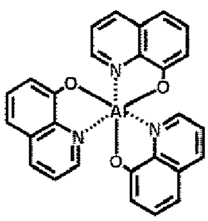
Alq$_3$

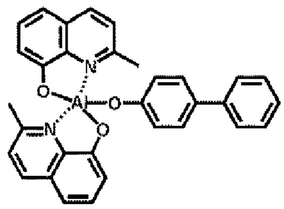
BAlq

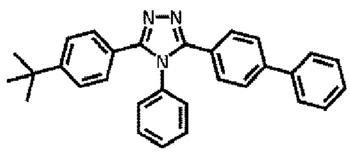
TAZ

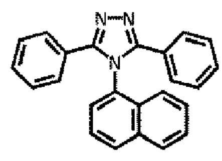
NTAZ

A thickness of the electron transport region may be from about 100 Å to about 5,000 Å, for example, about 160 Å to about 4,000 Å. When the electron transport region includes a buffer layer, a hole-blocking layer, an electron control layer, an electron transport layer, or one or more combinations thereof, the thickness of the buffer layer, the hole-blocking layer, or the electron control layer may each independently be from about 20 Å to about 1000 Å, for example, about 30 Å to about 300 Å, and the thickness of the electron transport layer may be from about 100 Å to about 1000 Å, for example, about 150 Å to about 500 Å. When the thickness of the buffer layer, the hole-blocking layer, the electron control layer, the electron transport layer, and/or the electron transport layer are within these ranges, satisfactory (suitable) electron transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or a combination thereof. The metal ion of an alkali metal complex may be a Li ion, a Na ion, a K ion, a Rb ion, or a Cs ion, and the metal ion of an alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or one or more combinations thereof.

For example, the metal-containing material may include a Li complex. The Li complex may include, for example,

Compound ET-D1 (LiQ) or ET-D2:

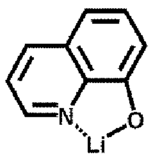

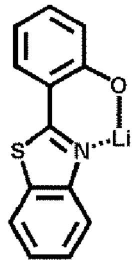

ET-D1 ET-D2

The electron transport region may include an electron injection layer that facilitates the injection of electrons from the second electrode 150. The electron injection layer may directly contact the second electrode 150.

The electron injection layer may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron injection layer may include an alkali metal, alkaline earth metal, a rare earth metal, an alkali metal-containing compound, alkaline earth metal-containing compound, a rare earth metal-containing compound, an alkali metal complex, an alkaline earth metal complex, a rare earth metal complex, or one or more combinations thereof.

The alkali metal may include Li, Na, K, Rb, Cs, or one or more combinations thereof. The alkaline earth metal may include Mg, Ca, Sr, Ba, or one or more combinations thereof. The rare earth metal may include Sc, Y, Ce, Tb, Yb, Gd, or one or more combinations thereof.

The alkali metal-containing compound, the alkaline earth metal-containing compound, and the rare earth metal-containing compound may be oxides, halides (for example, fluorides, chlorides, bromides, and/or iodides), or tellurides of the alkali metal, the alkaline earth metal, and the rare earth metal, or one or more combinations thereof.

The alkali metal-containing compound may include: alkali metal oxides, such as $Li_2O$, $Cs_2O$, or $K_2O$; alkali metal halides, such as LiF, NaF, CsF, KF, LiI, NaI, CsI, KI, RbI; or one or more combinations thereof. The alkaline earth metal-containing compound may include an alkaline earth metal compound, such as BaO, SrO, CaO, $Ba_xSr_{1-x}O$ (wherein x is a real number satisfying the condition of $0<x<1$), $Ba_xCa_{1-x}O$ (wherein x is a real number satisfying the condition of $0<x<1$), and/or the like. The rare earth metal-containing compound may include $YbF_3$, $ScF_3$, $Sc_2O_3$, $Y_2O_3$, $Ce_2O_3$, $GdF_3$, $TbF_3$, $YbI_3$, $ScI_3$, $TbI_3$, or one or more combinations thereof. In one or more embodiments, the rare earth metal-containing compound may include lanthanide metal telluride. Examples of the lanthanide metal telluride are LaTe, CeTe, PrTe, NdTe, PmTe, SmTe, EuTe, GdTe, TbTe, DyTe, HoTe, ErTe, TmTe, YbTe, LuTe, $La_2Te_3$, $Ce_2Te_3$, $Pr_2Te_3$, $Nd_2Te_3$, $Pm_2Te_3$, $Sm_2Te_3$, $Eu_2Te_3$, $Gd_2Te_3$, $Tb_2Te_3$, $Dy_2Te_3$, $Ho_2Te_3$, $Er_2Te_3$, $Tm_2Te_3$, $Yb_2Te_3$, and/or $Lu_2Te_3$.

The alkali metal complex, the alkaline earth-metal complex, and the rare earth metal complex may include i) one of metal ions of the alkali metal, the alkaline earth metal, and the rare earth metal and ii) as a ligand linked to the metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or one or more combinations thereof.

The electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or one or more combinations thereof, as described above. In one or more embodiments, the electron injection layer may further include an organic material (for example, a compound represented by Formula 601).

In one or more embodiments, the electron injection layer may include (e.g., consist of): i) an alkali metal-containing compound (for example, an alkali metal halide); or ii) a) an alkali metal-containing compound (for example, an alkali metal halide), and b) an alkali metal, an alkaline earth metal, a rare earth metal, or one or more combinations thereof. For example, the electron injection layer may be a KI:Yb co-deposited layer, an RbI:Yb co-deposited layer, a LiF:Yb co-deposited layer, and/or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or one or more combinations thereof may be substantially uniformly or non-uniformly dispersed in a matrix including the

organic material.

A thickness of the electron injection layer may be in a range of about 1 Å to about 100 Å, and, for example, about 3 Å to about 90 Å. When the thickness of the electron injection layer is within the ranges described above, satisfactory (suitable) electron injection characteristics may be obtained without a substantial increase in driving voltage.

**Second electrode 150**

The second electrode 150 may be on the interlayer 130 having a structure as described above. The second electrode 150 may be a cathode, which is an electron injection electrode, and as the material for the second electrode 150, a metal, an alloy, an electrically conductive compound, or one or more combinations thereof, each having a suitable low-work function, may be utilized.

The second electrode 150 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or one or more combinations thereof. The second electrode 150 may be a transmissive electrode, a semi-transmissive electrode, or a reflective electrode.

The second electrode 150 may have a single-layered structure or a multi-layered structure including a plurality of layers.

**Second capping layer 170**

The second capping layer 170 contains an amine-free compound as described in the present disclosure. The amine-free compound is the same as described in the present disclosure.

**Electronic apparatus**

The light-emitting device may be included in one or more suitable electronic apparatuses. For example, the electronic apparatus including the light-emitting device may be a light-emitting apparatus, an authentication apparatus, and/or the like.

The electronic apparatus (for example, a light-emitting apparatus) may further include, in addition to the light-emitting device, i) a color filter, ii) a color conversion layer, or iii) a color filter and a color conversion layer. The color filter and/or the color conversion layer may be in at least one traveling direction of light emitted from the light-emitting device. For example, the light emitted from the light-emitting device may be blue light, green light, or white light. For more details on the light-emitting device, related description provided above may be referred to. In one or more embodiments, the color conversion layer may include a quantum dot.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be among the subpixel areas to define each of the subpixel areas.

The color filter may further include a plurality of color filter areas and light-shielding patterns located among the color filter areas, and the color conversion layer may further include a plurality of color conversion areas and light-shielding patterns located among the color conversion areas.

The plurality of color filter areas (or the plurality of color conversion areas) may include a first area emitting first color light, a second area emitting second color light, and/or a third area emitting third color light, wherein the first color light, the second color light, and/or the third color light may have different maximum emission wavelengths from one another. For example, the first color light may be red light, the second color light may be green light, and the third color light may be blue light. For example, the plurality of color filter areas (or the plurality of color conversion areas) may include quantum dots. For example, the first area may include a red quantum dot, the second area may include a green quantum dot, and the third area may not include (e.g., may exclude) a quantum dot. For more details on the quantum dot, related descriptions provided herein may be referred to. The first area, the second area, and/or the third area may each include a scatterer.

For example, the light-emitting device may emit first light, the first area may absorb the first light to emit first-first color light, the second area may absorb the first light to emit second-first color light, and the third area may absorb the first light to emit third-first color light. In this regard, the first-first color light, the second-first color light, and the third-first color light may have different maximum emission wavelengths. In particular, the first light may be blue light, the first-first color light may be red light, the second-first color light may be green light, and the third-first color light may be blue light.

The electronic apparatus may further include a thin-film transistor, in addition to the light-emitting device as described above. The thin-film transistor may include a source electrode, a drain electrode, and an activation layer,

wherein one of the source electrode or the drain electrode may be electrically connected to the first electrode or the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

The electronic apparatus may further include a sealing portion for sealing the light-emitting device. The sealing portion may be between the color filter and/or the color conversion layer and the light-emitting device. The sealing portion allows light from the light-emitting device to be extracted to the outside, and concurrently (e.g., simultaneously) prevents (reduces) ambient air and moisture from penetrating into the light-emitting device. The sealing portion may be a sealing substrate including a transparent glass substrate and/or a plastic substrate. The sealing portion may be a thin-film encapsulation layer including at least one layer of an organic layer and/or an inorganic layer. When the sealing portion is a thin film encapsulation layer, the electronic apparatus may be flexible.

One or more suitable functional layers may be additionally located on the sealing portion, in addition to the color filter and/or the color conversion layer, according to the utilize of the electronic apparatus. Examples of the functional layers may include a touch screen layer, a polarizing layer, and/or the like. The touch screen layer may be a pressure-sensitive touch screen layer, a capacitive touch screen layer, or an infrared touch screen layer. The authentication apparatus may be, for example, a biometric authentication apparatus that authenticates an individual by utilizing biometric information of a living body (for example, fingertips, pupils, etc.).

The authentication apparatus may further include, in addition to the light-emitting device as described above, a biometric information collector.

The electronic apparatus may be applied to one or more suitable displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (for example, meters for a vehicle, an aircraft, and a vessel), projectors, and/or the like.

**Description of FIGs. 2 and 3**

FIG. 2 is a cross-sectional view showing a light-emitting apparatus according to an embodiment of the present disclosure.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be on the substrate 100. The buffer layer 210 may prevent or reduce penetration of impurities through the substrate 100 and may provide a substantially flat surface on the substrate 100.

A TFT may be on the buffer layer 210. The TFT may include an activation layer 220, a gate electrode 240, a source electrode 260, and a drain electrode 270.

The activation layer 220 may include an inorganic semiconductor such as silicon and/or polysilicon, an organic semiconductor, or an oxide semiconductor, and may include a source region, a drain region, and a channel region.

A gate insulating film 230 for insulating the activation layer 220 from the gate electrode 240 may be on the activation layer 220, and the gate electrode 240 may be on the gate insulating film 230.

An interlayer insulating film 250 may be on the gate electrode 240. The interlayer insulating film 250 may be between the gate electrode 240 and the source electrode 260 and between the gate electrode 240 and the drain electrode 270, to insulate (separate) the gate electrode from the source electrode and/or the gate electrode from the drain electrode.

The source electrode 260 and the drain electrode 270 may be on the interlayer insulating film 250. The interlayer insulating film 250 and the gate insulating film 230 may be formed so as to expose the source region and the drain region of the activation layer 220, and the source electrode 260 and the drain electrode 270 may be in contact with the exposed portions of the source region and the drain region of the activation layer 220.

The TFT is electrically connected to a light-emitting device to drive the light-emitting device, and is covered and protected by a passivation layer 280. The passivation layer 280 may include an inorganic insulating film, an organic insulating film, or a combination thereof. A light-emitting device is provided on the passivation layer 280. The light-emitting device may include a first electrode 110, an interlayer 130, and a second electrode 150.

The first electrode 110 may be on the passivation layer 280. The passivation layer 280 may be located (formed) so as to expose a portion of the drain electrode 270, not fully covering the drain electrode 270, and the first electrode 110 may be connected to the exposed portion of the drain electrode 270.

A pixel defining layer 290 including an insulating material may be on the first electrode 110. The pixel defining layer 290 may expose a certain region of the first electrode 110, and an interlayer 130 may be formed in the exposed

region of the first electrode 110. The pixel defining layer 290 may be a polyimide or polyacrylic organic film. At least some layers of the interlayer 130 may extend beyond the upper portion of the pixel defining layer 290 to be located in the form of a common layer (i.e., may be provided as a common layer).

A second electrode 150 may be on the interlayer 130, and a second capping layer 170 may be additionally formed on the second electrode 150. The second capping layer 170 may be formed so as to cover the second electrode 150.

The encapsulation portion 300 may be on the second capping layer 170. The encapsulation portion 300 may be on a light-emitting device to protect the light-emitting device from moisture or oxygen. The encapsulation portion 300 may include: an inorganic film including silicon nitride (SiNx), silicon oxide (SiOx), indium tin oxide, indium zinc oxide, or one or more combinations thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or one or more combinations thereof; or a combination of the inorganic films and the organic films.

FIG. 3 shows a cross-sectional view showing a light-emitting apparatus according to an embodiment of the present disclosure.

The light-emitting apparatus of FIG. 3 is substantially the same as the light-emitting apparatus of FIG. 2, except that a light-shielding pattern 500 and a functional region 400 are additionally located on the encapsulation portion 300. The functional region 400 may be i) a color filter area, ii) a color conversion area, or iii) a combination of the color filter area and the color conversion area. In an embodiment, the light-emitting device included in the light-emitting apparatus of FIG. 3 may be a tandem light-emitting device.

**Manufacturing method**

The layers included in the hole transport region, the emission layer, and the layers included in the electron transport region may be formed in a certain region by utilizing one or more suitable methods such as vacuum deposition, spin coating, casting, Langmuir-Blodgett (LB) deposition, ink-jet printing, laser-printing, laser-induced thermal imaging, and/or the like.

When layers constituting the hole transport region, an emission layer, and layers constituting the electron transport region are formed by vacuum deposition, the deposition may be performed at a deposition temperature of about 100 °C to about 500 °C, a vacuum degree of about $10^{-8}$ torr to about $10^{-3}$ torr, and a deposition speed of about 0.01 Å/sec to about 100 Å/sec, depending on a material to be included in a layer to be formed and the structure of a layer to be formed.

**Definition of Terms**

The term "$C_3$-$C_{60}$ carbocyclic group" as utilized herein refers to a cyclic group including (e.g., consisting of) carbon only as a ring-forming atom and having three to sixty carbon atoms, and the term "$C_1$-$C_{60}$ heterocyclic group" as utilized herein refers to a cyclic group that has one to sixty carbon atoms and further has, in addition to carbon, a heteroatom as a ring-forming atom. The $C_3$-$C_{60}$ carbocyclic group and the $C_1$-$C_{60}$ heterocyclic group may each be a monocyclic group including (e.g., consisting of) one ring or a polycyclic group in which two or more rings are condensed with each other. For example, the $C_1$-$C_{60}$ heterocyclic group has 3 to 61 ring-forming atoms.

The "cyclic group" as utilized herein may include the $C_3$-$C_{60}$ carbocyclic group, and the $C_1$-$C_{60}$ heterocyclic group.

The term "$\pi$ electron-rich $C_3$-$C_{60}$ cyclic group" as utilized herein refers to a cyclic group that has three to sixty carbon atoms and does not include *-N=*' as a ring-forming moiety, and the term "$\pi$ electron-deficient nitrogen-containing $C_1$-$C_{60}$ cyclic group" as utilized herein refers to a heterocyclic group that has one to sixty carbon atoms and includes *-N=*' as a ring-forming moiety.

For example, the $C_3$-$C_{60}$ carbocyclic group may be i) group T1 or ii) a condensed cyclic group in which two or more groups T1 are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),

the $C_1$-$C_{60}$ heterocyclic group may be i) group T2, ii) a condensed cyclic group in which two or more groups T2 are

condensed with each other, or iii) a condensed cyclic group in which at least one group T2 and at least one group T1 are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),

the $\pi$ electron-rich $C_3$-$C_{60}$ cyclic group may be i) group T1, ii) a condensed cyclic group in which two or more groups T1 are condensed with each other, iii) group T3, iv) a condensed cyclic group in which two or more groups T3 are condensed with each other, or v) a condensed cyclic group in which at least one group T3 and at least one group T1 are condensed with each other (for example, the $C_3$-$C_{60}$ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),

the $\pi$ electron-deficient nitrogen-containing $C_1$-$C_{60}$ cyclic group may be i) group T4, ii) a condensed cyclic group in which two or more groups T4 are condensed with each other, iii) a condensed cyclic group in which at least one group T4 and at least one group T1 are condensed with each other, iv) a condensed cyclic group in which at least one group T4 and at least one group T3 are condensed with each other, or v) a condensed cyclic group in which at least one group T4, at least one group T1, and at least one group T3 are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),

group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group,

the group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a petrahydropyrazine group, a dihydropyrazine group, a tetrahydropyridazine group, or a dihydropyridazine group,

group T3 may be a furan group, a thiophene group, a 1H-pyrrole group, a silole group, or a borole group, and

group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group,

a thiadiazole group, an azasilole group, an azaborole group, a pyridine group, a pyrimidine group, a pyrazine group, a pyridazine group, a triazine group, or a tetrazine group.

The terms "the cyclic group, the $C_3$-$C_{60}$ carbocyclic group, the $C_1$-$C_{60}$ heterocyclic group, the $\pi$ electron-rich $C_3$-$C_{60}$ cyclic group, or the $\pi$ electron-deficient nitrogen-containing $C_1$-$C_{60}$ cyclic group" as utilized herein refer to a group condensed to any cyclic group, a monovalent group, or a polyvalent group (for example, a divalent group, a trivalent group, a tetravalent group, etc.) according to the structure of a formula for which the corresponding term is utilized. For example, the "benzene group" may be a benzo group, a phenyl group, a phenylene group, and/or the like, which may be understood by one of ordinary skill in the art according to the structure of a formula including the "benzene group."

Examples of the monovalent $C_3$-$C_{60}$ carbocyclic group and the monovalent $C_1$-$C_{60}$ heterocyclic group are a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group. Examples of the divalent $C_3$-$C_{60}$ carbocyclic group and the monovalent $C_1$-$C_{60}$ heterocyclic group are a $C_3$-$C_{10}$ cycloalkylene group, a $C_1$-$C_{10}$ heterocycloalkylene group, a $C_3$-$C_{10}$ cycloalkenylene group, a $C_1$-$C_{10}$ heterocycloalkenylene group, a $C_6$-$C_{60}$ arylene group, a $C_1$-$C_{60}$ heteroarylene group, a divalent non-aromatic condensed polycyclic group, and a substituted or unsubstituted divalent non-aromatic condensed heteropolycyclic group.

The term "$C_1$-$C_{60}$ alkyl group" as utilized herein refers to a linear or branched aliphatic hydrocarbon monovalent group that has one to sixty carbon atoms, and specific examples thereof are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isoctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "$C_1$-$C_{60}$ alkylene group" as utilized herein refers to a divalent group having the same structure as the $C_1$-$C_{60}$ alkyl group.

The term "$C_2$-$C_{60}$ alkenyl group" as utilized herein refers to a monovalent hydrocarbon group having at least one carbon-carbon double bond in the middle or at the terminus of the $C_2$-$C_{60}$ alkyl group, and examples thereof are an ethenyl group, a propenyl group, and a butenyl group. The term "$C_2$-$C_{60}$ alkenylene group" as utilized herein refers to a divalent group having the same structure as the $C_2$-$C_{60}$ alkenyl group.

The term "$C_2$-$C_{60}$ alkynyl group" as utilized herein refers to a monovalent hydrocarbon group having at least one carbon-carbon triple bond in the middle or at the terminus of the $C_2$-$C_{60}$ alkyl group, and examples thereof include an ethynyl group and a propynyl group. The term "$C_2$-$C_{60}$ alkynylene group" as utilized herein refers to a divalent group having the same structure as the $C_2$-$C_{60}$ alkynyl group.

The term "$C_1$-$C_{60}$ alkoxy group" as utilized herein refers to a monovalent group represented by $-OA_{101}$ (wherein $A_{101}$ is the $C_1$-$C_{60}$ alkyl group), and examples thereof include a methoxy group, an ethoxy group, and an isopropyloxy group.

The term "$C_3$-$C_{10}$ cycloalkyl group" as utilized herein refers to a monovalent saturated hydrocarbon cyclic group having 3 to 10 carbon atoms, and examples thereof are a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, and a bicyclo[2.2.2]octyl group. The term "$C_3$-$C_{10}$ cycloalkylene group" as utilized herein refers to a divalent group having the same structure as the $C_3$-$C_{10}$ cycloalkyl group.

The term "$C_1$-$C_{10}$ heterocycloalkyl group" as utilized herein refers to a monovalent cyclic group of 1 to 10 carbon atoms, further including, in addition to carbon atoms, at least one heteroatom, as ring-forming atoms, and specific examples are a 1,2,3,4-oxatriazolidinyl group, a tetrahydrofuranyl group, and a tetrahydrothiophenyl group. The term "$C_1$-$C_{10}$ heterocycloalkylene group" as utilized herein refers to a divalent group having the same structure as the $C_1$-$C_{10}$ heterocycloalkyl group.

The term "$C_3$-$C_{10}$ cycloalkenyl group" utilized herein refers to a monovalent cyclic group that has three to ten carbon atoms and at least one carbon-carbon double bond in the ring thereof and no aromaticity, and specific examples thereof are a cyclopentenyl group, a cyclohexenyl group, and a cycloheptenyl group. The term "$C_3$-$C_{10}$ cycloalkenylene group" as utilized herein refers to a divalent group having the same structure as the $C_3$-$C_{10}$ cycloalkenyl group.

The term "$C_1$-$C_{10}$ heterocycloalkenyl group" as utilized herein refers to a monovalent cyclic group of 1 to 10 carbon atoms, further including, in addition to carbon atoms, at least one heteroatom, as ring-forming atoms, and having at least one carbon-carbon double bond in the cyclic structure thereof. Examples of the $C_1$-$C_{10}$ heterocycloalkenyl group include a 4,5-dihydro-1,2,3,4-oxatriazolyl group, a 2,3-dihydrofuranyl group, and a 2,3-dihydrothiophenyl group. The term "$C_1$-$C_{10}$ heterocycloalkenylene group" as utilized herein refers to a divalent group having the same structure as the $C_1$-$C_{10}$ heterocycloalkenyl group.

The term "$C_6$-$C_{60}$ aryl group" as utilized herein refers to a monovalent group having a carbocyclic aromatic system of 6 to 60 carbon atoms, and the term "$C_6$-$C_{60}$ arylene group" as utilized herein refers to a divalent group having a carbocyclic aromatic system of 6 to 60 carbon atoms. Examples of the $C_6$-$C_{60}$ aryl group are a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the $C_6$-$C_{60}$ aryl group and the $C_6$-$C_{60}$ arylene group each include two or more rings, the rings may be condensed with each other.

The term "$C_1$-$C_{60}$ heteroaryl group" as utilized herein refers to a monovalent group having a heterocyclic aromatic system of 1 to 60 carbon atoms, further including, in addition to carbon atoms, at least one heteroatom, as ring-forming atoms. The term "$C_1$-$C_{60}$ heteroarylene group" as utilized herein refers to a divalent group having a heterocyclic aromatic system of 1 to 60 carbon atoms, further including, in addition to carbon atoms, at least one heteroatom, as ring-forming atoms. Examples of the $C_1$-$C_{60}$ heteroaryl group are a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the $C_1$-$C_{60}$ heteroaryl group and the $C_1$-$C_{60}$ heteroarylene group each include two or more rings, the rings may be condensed with each other.

The term "monovalent non-aromatic condensed polycyclic group" as utilized herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group are an indenyl group, a fluorenyl group, a spiro-bifluorenyl group, and a benzofluorenyl group, an indenophenanthrenyl group, and an indeno anthracenyl group. The term "divalent non-aromatic condensed polycyclic group" as utilized herein refers to a divalent group having the same structure as the monovalent non-aromatic condensed polycyclic group described above.

The term "monovalent non-aromatic condensed heteropolycyclic group" as utilized herein refers to a monovalent group (for example, having 1 to 60 carbon atoms) having two or more rings condensed to each other, further including, in addition to carbon atoms, at least one heteroatom, as ring-forming atoms, and having non-aromaticity in its entire molecular structure. Examples of the monovalent non-aromatic condensed heteropolycyclic group are a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphtho silolyl group, a benzofurodibenzofuranyl group, a benzofurodibenzothiophenyl group, and a benzothienodibenzothiophenyl group. The term "divalent non-aromatic condensed heteropolycyclic group" as utilized herein refers to a divalent group having the same structure as the monovalent non-aromatic condensed heteropolycyclic group described above.

The term "$C_6$-$C_{60}$ aryloxy group" as utilized herein indicates $-OA_{102}$ (wherein $A_{102}$ is the $C_6$-$C_{60}$ aryl group), and the term "$C_6$-$C_{60}$ arylthio group" as utilized herein indicates $-SA_{103}$ (wherein $A_{103}$ is the $C_6$-$C_{60}$ aryl group).

The term "$C_{7-}C_{60}$ aryl alkyl group" utilized herein refers to $-A_{104}A_{105}$ (where $A_{104}$ may be a $C_1$-$C_{54}$ alkylene group, and $A_{105}$ may be a $C_6$-$C_{59}$ aryl group), and the term $C_2$-$C_{60}$ heteroaryl alkyl group" utilized herein refers to $-A_{106}A_{107}$ (where $A_{106}$ may be a $C_1$-$C_{59}$ alkylene group, and $A_{107}$ may be a $C_1$-$C_{59}$ heteroaryl group).

The term "$R_{10a}$" as utilized herein refers to:

deuterium, -F, -Cl, -Br, -I, a hydroxyl group, a cyano group, or a nitro group,

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_{7-}C_{60}$ aryl alkyl group, a $C_2$-$C_{60}$ heteroaryl alkyl group, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, $-P(=O)(Q_{11})(Q_{12})$, or one or more combinations thereof,

a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_{7-}C_{60}$ aryl alkyl group, or a $C_2$-$C_{60}$ heteroaryl alkyl group, each unsubstituted or substituted with deuterium, -F, -Cl, -Br,

-I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, - $Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$, or one or more combinations thereof; or $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or - $P(=O)(Q_{31})(Q_{32})$.

$Q_1$ to $Q_3$, $Q_{11}$ to $Q_{13}$, $Q_{21}$ to $Q_{23}$, and $Q_{31}$ to $Q_{33}$ in the present disclosure may each independently be: hydrogen; deuterium; -F; -Cl; -Br; -I; a hydroxyl group; a cyano group; a nitro group; or a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or one or more combinations thereof.

The term "heteroatom" as utilized herein refers to any atom other than a carbon atom. Examples of the heteroatom are O, S, N, P, Si, B, Ge, Se, and one or more combinations thereof.

The term "third-row transition metal" utilized herein includes hafnium (Hf), tantalum (Ta), tungsten (W), rhenium (Re), osmium (Os), iridium (Ir), platinum (Pt), gold (Au), and/or the like.

"Ph" as utilized herein refers to a phenyl group, "Me" as utilized herein refers to a methyl group, "Et" as utilized herein refers to an ethyl group, "ter-Bu" or "$Bu^t$" as utilized herein refers to a tert-butyl group, and "OMe" as utilized herein refers to a methoxy group.

The term "biphenyl group" as utilized herein refers to "a phenyl group substituted with a phenyl group." For example, the "biphenyl group" is a substituted phenyl group having a $C_6$-$C_{60}$ aryl group as a substituent.

The term "terphenyl group" as utilized herein refers to "a phenyl group substituted with a biphenyl group". For example, the "terphenyl group" is a substituted phenyl group having, as a substituent, a $C_6$-$C_{60}$ aryl group substituted with a $C_6$-$C_{60}$ aryl group.

**[0306]** * and *' as utilized herein, unless defined otherwise, each refer to a binding site to a neighboring atom in a corresponding formula or moiety.

Hereinafter, compounds according to embodiments and light-emitting devices according to embodiments will be described in more detail with reference to the following synthesis examples and examples. The wording "B was utilized instead of A" utilized in describing Synthesis Examples refers to that an identical molar equivalent of B was utilized in place of A.

## Examples

### Evaluation Example 1

According to the method in Table 1, the HOMO energy level, LUMO energy level, band gap and triplet ($T_1$) energy of each of Compounds GD-4, GD-8, GD-5, GD-6, A01, and A04 were evaluated. The results are shown in Table 2.

**Table 1**

| | |
|---|---|
| HOMO energy level evaluation method | By utilizing cyclic voltammetry (CV) (electrolyte: 0.1 M $Bu_4NPF_6$ / solvent: dimethylforamide (DMF) / electrode: 3-electrode system (working electrode: GC, reference electrode: Ag/AgCl, and auxiliary electrode: Pt)), the potential (V)-current (A) graph of each compound was obtained, and then, from the oxidation onset of the graph, the HOMO energy level of each compound was calculated. |
| LUMO energy level evaluation method | By utilizing cyclic voltammetry (CV) (electrolyte: 0.1 M $Bu_4NPF_6$ / solvent: dimethylforamide (DMF) / electrode: 3-electrode system (working electrode: GC, reference electrode: Ag/AgCl, and auxiliary electrode: Pt)), the potential (V)-current (A) graph of each compound was obtained, and then, from the reduction onset of the graph, the LUMO energy level of each compound was calculated. |
| Band gap evaluation method | The absolute value of the difference between HOMO energy level and LUMO energy level was calculated |
| Triplet ($T_1$) energy | A mixture of 2-methyl-THF(2-MeTHF) and each compound (each compound was dissolved to a concentration of 10 mM in 3 mL of 2-MeTHF) was put into a quartz cell, which was then placed in a cryostat containing liquid nitrogen (77 K)(Oxford, DN). Then, the |

(continued)

| | |
|---|---|
| | phosphorescent spectrum thereof was measured utilizing a luminescence measuring instrument (PTI, Quanta Master 400), and then the triplet energy level was measured from the peak wavelength of the phosphorescent spectrum. |

**Table 2**

| | HOMO (eV) | LUMO (eV) | Band gap (eV) | $T_1$ (eV) |
|---|---|---|---|---|
| GD-4 | -4.83 | -1.94 | 2.89 | 2.35 |
| GD-8 | -4.94 | -1.54 | 3.40 | 2.38 |
| GD-5 | -4.91 | -1.92 | 2.99 | 2.38 |
| GD-6 | -4.91 | -1.91 | 3.00 | 2.38 |
| A01 | -4.93 | -1.97 | 2.96 | 2.34 |
| A04 | -4.88 | -1.97 | 2.91 | 2.32 |

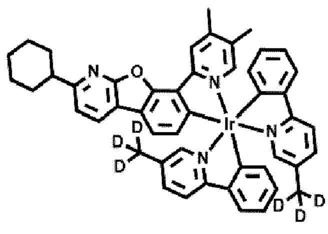

GD-4

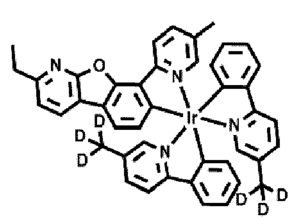

GD-8

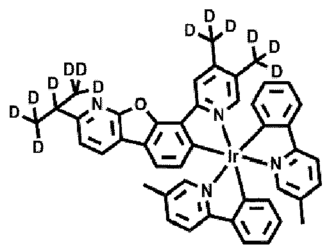

GD-5

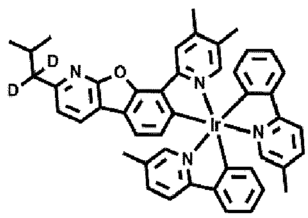

GD-6

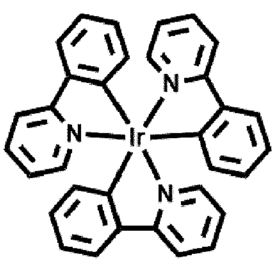

A01

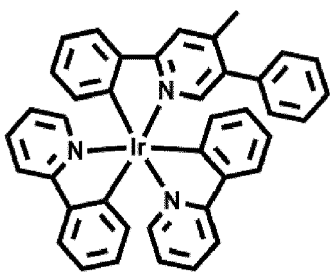

A04

**Evaluation Example 2**

PMMA in $CH_2Cl_2$ solution and Compound GD-4 (4 wt% to PMMA) were mixed, and then, the resultant obtained therefrom was coated on a quartz substrate utilizing a spin coater, and then heat treated in an oven at 80 °C, followed by cooling to room temperature to manufacture a film GD-4 having a thickness of 40 nm. Next, films GD-8, GD-5, GD-6, A01, and A04 were prepared utilizing substantially the same method as utilized to prepare film GD-4, except that GD-8, GD-5, GD-6, A01, and A04 were utilized instead of GD-1.

The emission spectrum of each of films GD-4, GD-8, GD-5, GD-6, A01, and A04 was measured by utilizing a Quantaurus-QY Absolute PL quantum yield spectrometer of Hamamatsu Inc. (equipped with a xenon light source, a monochromator, a photonic multichannel analyzer, and an integrating sphere, and utilizing PLQY measurement software (Hamamatsu Photonics, Ltd., Shizuoka, Japan)). During measurement, the excitation wavelength was scanned from 320 nm to 380 nm at 10 nm intervals, and the spectrum measured at the excitation wavelength of 340 nm was utilized to obtain the maximum emission wavelength (emission peak wavelength) and FWHM of the compound included in each film. Results thereof are shown in Table 3.

**Table 3**

| Film no. | Compound included in film (4 wt% in PMMA) | Maximum emission wavelength (nm) | FWHM (nm) |
|---|---|---|---|
| GD-4 | GD-4 | 525 | 55 |
| GD-8 | GD-8 | 525 | 53 |
| GD-5 | GD-5 | 534 | 56 |
| GD-6 | GD-6 | 525 | 54 |
| A01 | A01 | 516 | 62 |
| A04 | A04 | 559 | 81 |

From Table 3, it can be confirmed that Compounds GD-4, GD-8, GD-5, and GD-6 emit green light which satisfies the maximum emission wavelength range of about 520 nm to about 550 nm, and has a relatively small FWHM compared to Compounds A01 and A04.

**Evaluation Example 3**

Compound 15 was deposited on a glass substrate to prepare film 15 having a thickness of 60 nm. Then, for the film 15, the refractive index of Compound 15 with respect to light having a wavelength of 530 nm was measured according to the Cauchy Film Model by utilizing an Ellipsometer M-2000 (JA Woollam) at a temperature of 25 °C and in 50% relative humidity. Results thereof are shown Table 4. This experiment was performed on each of Compounds 18, 22, 36, 37, 46, 47, 50, 51, B01, and B02, and results thereof are shown in Table 4.

**Table 4**

| Film no. | Compound included in film | Refractive index for light having a wavelength of 530 nm |
|---|---|---|
| 15 | 15 | 1.950 |
| 18 | 18 | 1.929 |
| 22 | 22 | 1.939 |
| 36 | 36 | 1.948 |
| 37 | 37 | 1.886 |
| 46 | 46 | 1.900 |
| 47 | 47 | 1.890 |
| 50 | 50 | 1.922 |
| 51 | 51 | 2.080 |
| B01 | B01 | 1.757 |
| B02 | B02 | 1.844 |

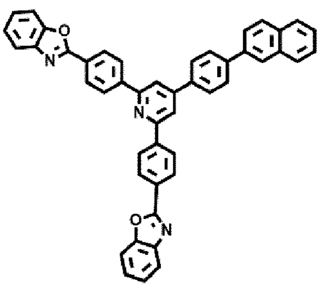

15

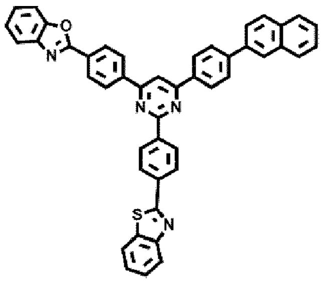

18

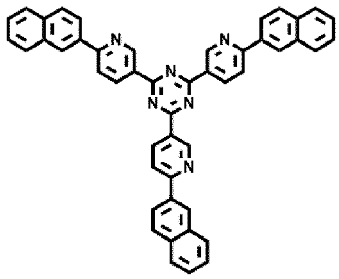

22

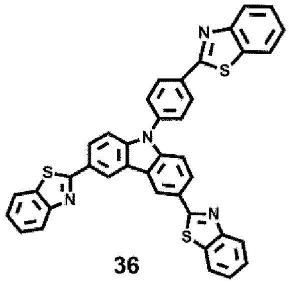

36

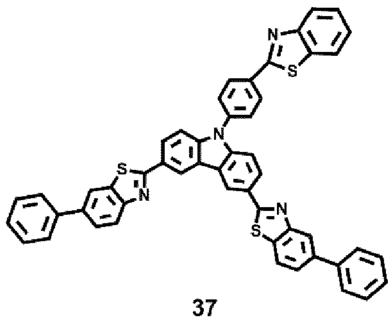

37

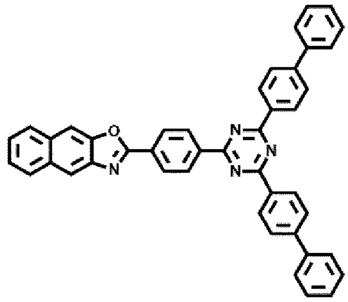

46

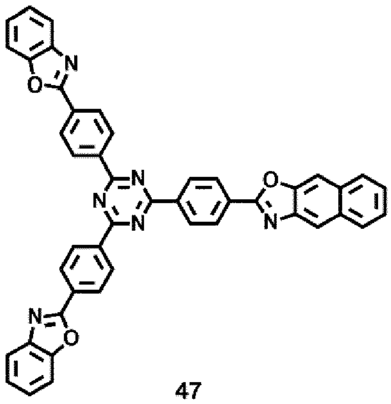

47

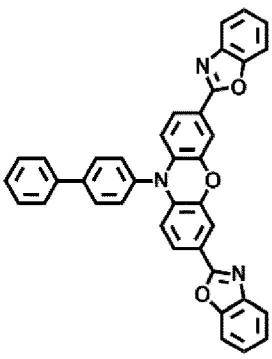

50

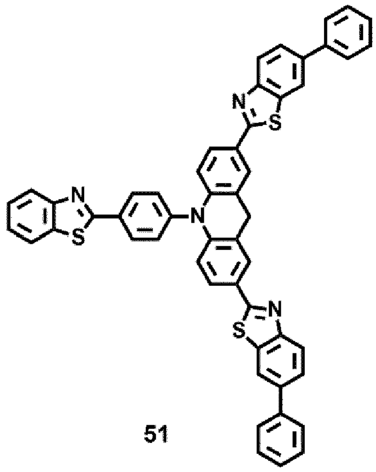

51

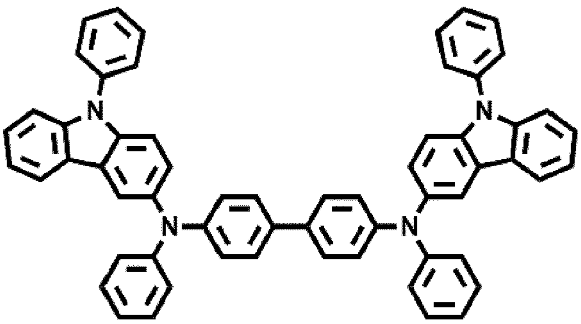

**B01**

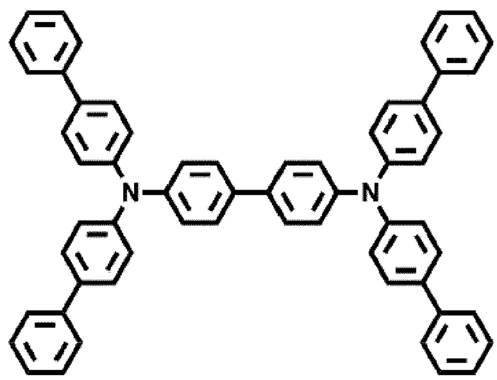

**B02**

**Example 1**

A glass substrate (available from Corning Co., Ltd) on which an ITO anode (15 Ohms per square centimeter ($\Omega/cm^2$)) having a thickness of 1,200 Å was formed, was cut to a size of 50 millimeters (mm)×50 mm×0.7 mm, sonicated for 5 minutes in isopropyl alcohol and then 5 minutes in pure water, cleaned with ultraviolet rays for 30 minutes, and then ozone, and was mounted on a vacuum deposition apparatus.

HT3 was vacuum-deposited on the ITO anode to form a hole transport layer having a thickness of 600 Å, and HT40 was vacuum-deposited on the hole transport layer to form an emission auxiliary layer having a thickness of 250 Å.

Compound H125, Compound H126, and Compound GD-4 (first emitter) were vacuum-deposited on the emission auxiliary layer at the weight ratio of 45 : 45 : 10 to form an emission layer having a thickness of 300 Å.

Compound ET37 was vacuum-deposited on the emission layer to form a buffer layer having a thickness of 50 Å, and ET46 and LiQ were vacuum-deposited on the buffer layer at the weight ratio of 5 : 5 to form an electron transport layer having a thickness of 310 Å. Subsequently, Yb was vacuum-deposited on the electron transport layer to form an electron injection layer having a thickness of 15 Å, and then, Ag and Mg were vacuum-deposited thereon to form a cathode having a thickness of 100 Å.

Subsequently, Compound 15 was vacuum-deposited on the cathode to form a capping layer having a thickness of 700 Å to complete the manufacturing of an organic light-emitting device.

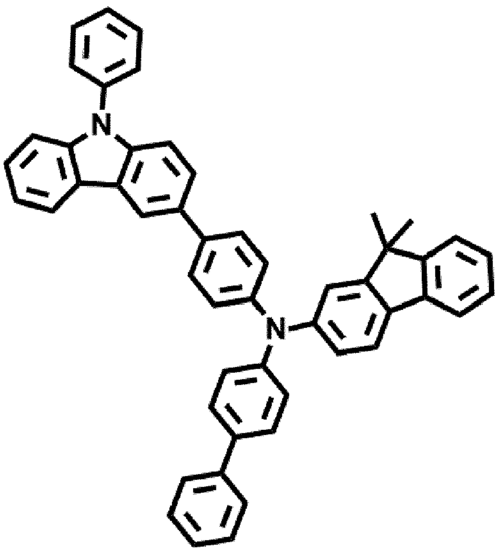

HT3

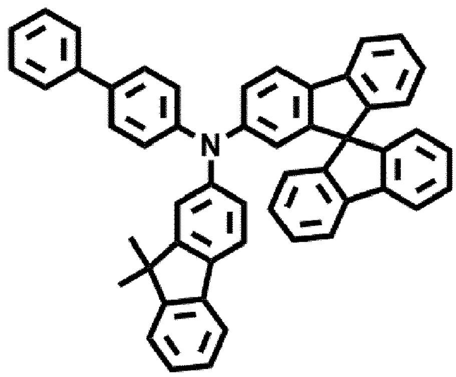

HT40

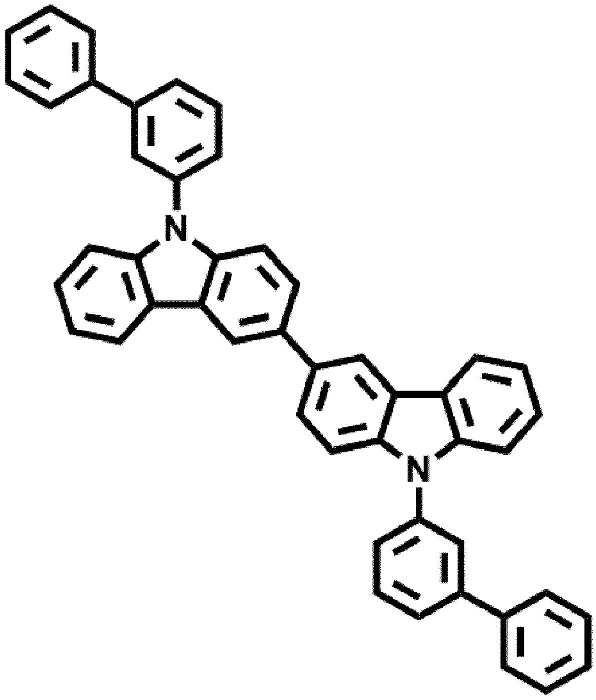

H125

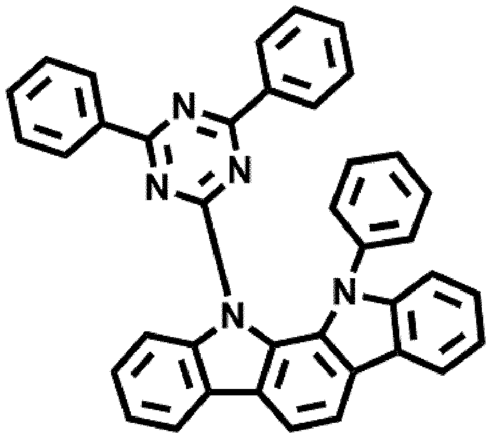

H126

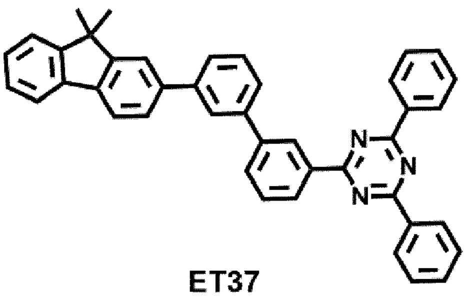

ET37

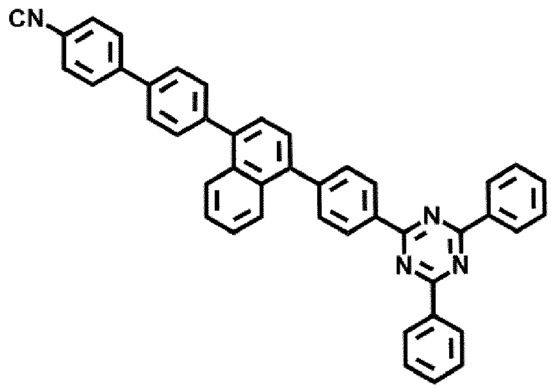

ET46

**Examples 2 to 12 and Comparative Examples 1 to 20**

Organic light-emitting devices were manufactured in substantially the same manner as in Example 1, except that each of the compounds shown in Table 5 were utilized as materials for forming the first emitter in the emission layer and the capping layer.

**Evaluation Example 4**

The color purity (CIEx and CIEy coordinates) at 400 cd/$m^2$, frontal (0°) luminescence efficiency (cd/A), and lateral (45°) luminescence efficiency (cd/A) of the organic light-emitting devices manufactured according to Examples 1 to 12 and Comparative Examples 1 and 20 were evaluated by utilizing a luminance meter (Minolta Cs-1000A). Results thereof are shown in Tables 6 to 9. The RCR values calculated with reference to Table 4 are also summarized in Table 5.

**Table 5**

| | First emitter | Material for capping layer | Refractive index of material for capping layer with respect to light having a wavelength of 530 nm | CIEx | CIEy | RCR value |
|---|---|---|---|---|---|---|
| Example 1 | GD-4 | 15 | 1.950 | 0.244 | 0.722 | 37.03 |
| Example 2 | GD-4 | 22 | 1.939 | 0.245 | 0.721 | 37.18 |
| Example 3 | GD-4 | 36 | 1.948 | 0.244 | 0.722 | 37.06 |
| Example 4 | GD-8 | 15 | 1.950 | 0.246 | 0.707 | 36.26 |
| Example 5 | GD-8 | 22 | 1.939 | 0.247 | 0.706 | 36.41 |
| Example 6 | GD-8 | 36 | 1.948 | 0.246 | 0.707 | 36.29 |
| Example 7 | GD-5 | 15 | 1.950 | 0.244 | 0.722 | 37.03 |
| Example 8 | GD-5 | 22 | 1.939 | 0.244 | 0.721 | 37.18 |
| Example 9 | GD-5 | 36 | 1.948 | 0.243 | 0.722 | 37.06 |
| Example 10 | GD-6 | 15 | 1.950 | 0.244 | 0.722 | 37.03 |
| Example 11 | GD-6 | 22 | 1.939 | 0.245 | 0.721 | 37.18 |
| Example 12 | GD-6 | 36 | 1.948 | 0.244 | 0.722 | 37.06 |
| Comparative Example 1 | A01 | B01 | 1.757 | 0.249 | 0.711 | 40.47 |
| Comparative Example 2 | A01 | B02 | 1.844 | 0.249 | 0.713 | 38.67 |
| Comparative Example 3 | A04 | B01 | 1.757 | 0.246 | 0.708 | 40.29 |
| Comparative Example 4 | A04 | B02 | 1.844 | 0.245 | 0.709 | 38.44 |
| Comparative Example 5 | A01 | 15 | 1.950 | 0.249 | 0.712 | 36.51 |
| Comparative Example 6 | A01 | 18 | 1.929 | 0.248 | 0.713 | 36.69 |
| Comparative Example 7 | A01 | 22 | 1.939 | 0.248 | 0.713 | 36.77 |
| Comparative Example 8 | A01 | 36 | 1.948 | 0.249 | 0.713 | 36.60 |
| Comparative Example 9 | A04 | 15 | 1.950 | 0.246 | 0.709 | 36.35 |
| Comparative Example 10 | A04 | 18 | 1.929 | 0.245 | 0.709 | 36.75 |
| Comparative Example 11 | A04 | 22 | 1.939 | 0.246 | 0.708 | 36.51 |
| Comparative Example 12 | A04 | 36 | 1.948 | 0.245 | 0.709 | 36.75 |
| Comparative Example 13 | GD-4 | B01 | 1.757 | 0.246 | 0.722 | 41.09 |
| Comparative Example 14 | GD-4 | B02 | 1.844 | 0.244 | 0.722 | 39.15 |

(continued)

| | First emitter | Material for capping layer | Refractive index of material for capping layer with respect to light having a wavelength of 530 nm | CIEx | CIEy | RCR value |
|---|---|---|---|---|---|---|
| Comparative Example 15 | GD-8 | B01 | 1.757 | 0.245 | 0.724 | 41.21 |
| Comparative Example 16 | GD-8 | B02 | 1.844 | 0.244 | 0.723 | 39.21 |
| Comparative Example 17 | GD-5 | B01 | 1.757 | 0.246 | 0.721 | 41.04 |
| Comparative Example 18 | GD-5 | B02 | 1.844 | 0.244 | 0.721 | 39.10 |
| Comparative Example 19 | GD-6 | B01 | 1.757 | 0.245 | 0.724 | 41.21 |
| Comparative Example 20 | GD-6 | B02 | 1.844 | 0.244 | 0.723 | 39.21 |

**Table 6**

| | First emitter | Material for capping layer | Frontal (0°) luminescence efficiency (cd/A) | Lateral (45°) luminescence efficiency (cd/A) |
|---|---|---|---|---|
| Example 1 | GD-4 | 15 | 179.1 | 87.8 |
| Example 2 | GD-4 | 22 | 172.8 | 84.7 |
| Example 3 | GD-4 | 36 | 177.8 | 85.3 |
| Comparative Example 1 | A01 | B01 | 150.3 | 87.2 |
| Comparative Example 2 | A01 | B02 | 153.1 | 88.8 |
| Comparative Example 3 | A04 | B01 | 152.8 | 85.6 |
| Comparative Example 4 | A04 | B02 | 155.3 | 88.5 |
| Comparative Example 5 | A01 | 15 | 167.2 | 93.6 |
| Comparative Example 6 | A01 | 18 | 160.1 | 88.1 |
| Comparative Example 7 | A01 | 22 | 163.1 | 88.1 |
| Comparative Example 8 | A01 | 36 | 164.9 | 90.7 |
| Comparative Example 9 | A04 | 15 | 165.4 | 91.0 |
| Comparative Example 10 | A04 | 18 | 159.1 | 89.1 |
| Comparative Example 11 | A04 | 22 | 162.3 | 87.6 |

(continued)

| | First emitter | Material for capping layer | Frontal (0°) luminescence efficiency (cd/A) | Lateral (45°) luminescence efficiency (cd/A) |
|---|---|---|---|---|
| Comparative Example 12 | A04 | 36 | 164.1 | 90.3 |
| Comparative Example 13 | GD-4 | B01 | 165.1 | 89.2 |
| Comparative Example 14 | GD-4 | B02 | 168.5 | 89.3 |

**Table 7**

| | First emitter | Material for capping layer | Frontal (0°) luminescence efficiency (cd/A) | Lateral (45°) luminescence efficiency (cd/A) |
|---|---|---|---|---|
| Example 4 | GD-8 | 15 | 178.6 | 89.3 |
| Example 5 | GD-8 | 22 | 172 | 84.3 |
| Example 6 | GD-8 | 36 | 176.9 | 84.9 |
| Comparative Example 1 | A01 | B01 | 150.3 | 87.2 |
| Comparative Example 2 | A01 | B02 | 153.1 | 88.8 |
| Comparative Example 3 | A04 | B01 | 152.8 | 85.6 |
| Comparative Example 4 | A04 | B02 | 155.3 | 88.5 |
| Comparative Example 5 | A01 | 15 | 167.2 | 93.6 |
| Comparative Example 6 | A01 | 18 | 160.1 | 88.1 |
| Comparative Example 7 | A01 | 22 | 163.1 | 88.1 |
| Comparative Example 8 | A01 | 36 | 164.9 | 90.7 |
| Comparative Example 9 | A04 | 15 | 165.4 | 91.0 |
| Comparative Example 10 | A04 | 18 | 159.1 | 89.1 |
| Comparative Example 11 | A04 | 22 | 162.3 | 87.6 |
| Comparative Example 12 | A04 | 36 | 164.1 | 90.3 |
| Comparative Example 15 | GD-8 | B01 | 163.1 | 88.1 |
| Comparative Example 16 | GD-8 | B02 | 164.8 | 87.3 |

**Table 8**

| | First emitter | Material for capping layer | Frontal (0°) luminescence efficiency (cd/A) | Lateral (45°) luminescence efficiency (cd/A) |
|---|---|---|---|---|
| Example 7 | GD-5 | 15 | 180.4 | 88.4 |
| Example 8 | GD-5 | 22 | 173.1 | 86.6 |
| Example 9 | GD-5 | 36 | 178.3 | 85.6 |
| Comparative Example 1 | A01 | B01 | 150.3 | 87.2 |
| Comparative Example 2 | A01 | B02 | 153.1 | 88.8 |
| Comparative Example 3 | A04 | B01 | 152.8 | 85.6 |
| Comparative Example 4 | A04 | B02 | 155.3 | 88.5 |
| Comparative Example 5 | A01 | 15 | 167.2 | 93.6 |
| Comparative Example 6 | A01 | 18 | 160.1 | 88.1 |
| Comparative Example 7 | A01 | 22 | 163.1 | 88.1 |
| Comparative Example 8 | A01 | 36 | 164.9 | 90.7 |
| Comparative Example 9 | A04 | 15 | 165.4 | 91.0 |
| Comparative Example 10 | A04 | 18 | 159.1 | 89.1 |
| Comparative Example 11 | A04 | 22 | 162.3 | 87.6 |
| Comparative Example 12 | A04 | 36 | 164.1 | 90.3 |
| Comparative Example 17 | GD-5 | B01 | 160.1 | 86.5 |
| Comparative Example 18 | GD-5 | B02 | 163.2 | 84.9 |

**Table 9**

| | First emitter | Material for capping layer | Frontal (0°) luminescence efficiency (cd/A) | Lateral (45°) luminescence efficiency (cd/A) |
|---|---|---|---|---|
| Example 10 | GD-6 | 15 | 179.4 | 87.9 |
| Example 11 | GD-6 | 22 | 172.5 | 82.8 |
| Example 12 | GD-6 | 36 | 178.4 | 85.6 |
| Comparative Example 1 | A01 | B01 | 150.3 | 87.2 |

(continued)

| | First emitter | Material for capping layer | Frontal (0°) luminescence efficiency (cd/A) | Lateral (45°) luminescence efficiency (cd/A) |
|---|---|---|---|---|
| Comparative Example 2 | A01 | B02 | 153.1 | 88.8 |
| Comparative Example 3 | A04 | B01 | 152.8 | 85.6 |
| Comparative Example 4 | A04 | B02 | 155.3 | 88.5 |
| Comparative Example 5 | A01 | 15 | 167.2 | 93.6 |
| Comparative Example 6 | A01 | 18 | 160.1 | 88.1 |
| Comparative Example 7 | A01 | 22 | 163.1 | 88.1 |
| Comparative Example 8 | A01 | 36 | 164.9 | 90.7 |
| Comparative Example 9 | A04 | 15 | 165.4 | 91.0 |
| Comparative Example 10 | A04 | 18 | 159.1 | 89.1 |
| Comparative Example 11 | A04 | 22 | 162.3 | 87.6 |
| Comparative Example 19 | GD-6 | B01 | 162 | 87.5 |
| Comparative Example 20 | GD-6 | B02 | 164.9 | 85.7 |

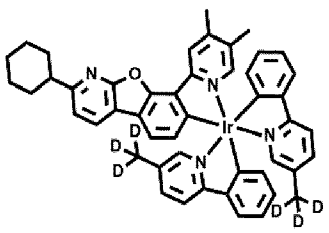
GD-4

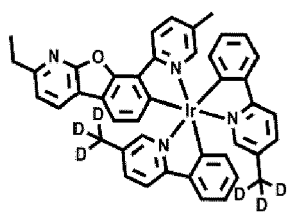
GD-8

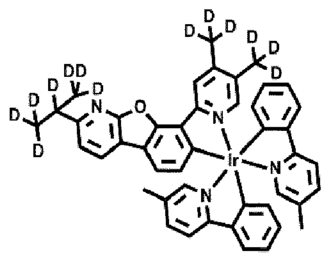
GD-5

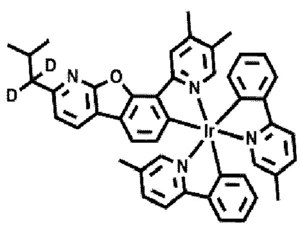
GD-6

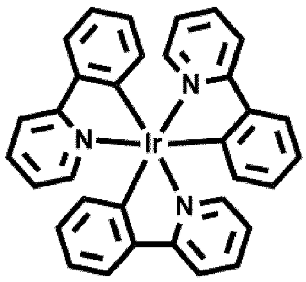

A01

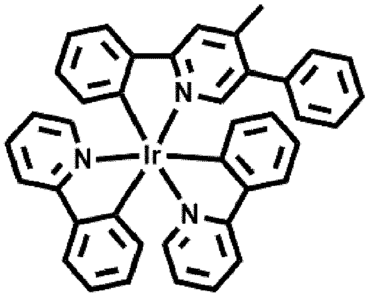

A04

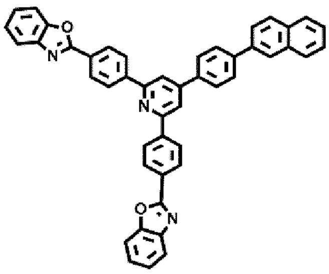

15

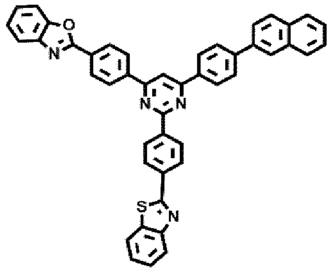

18

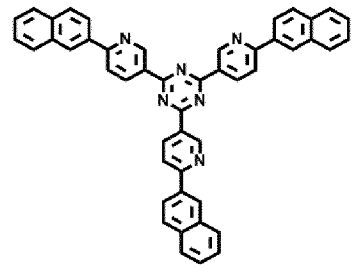

22

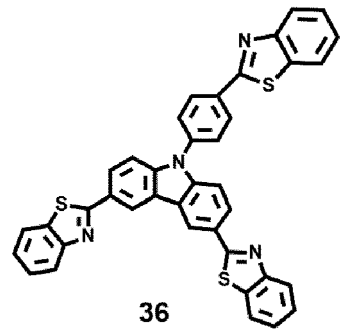

36

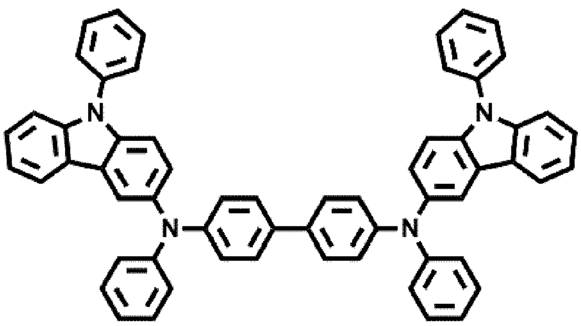

B01

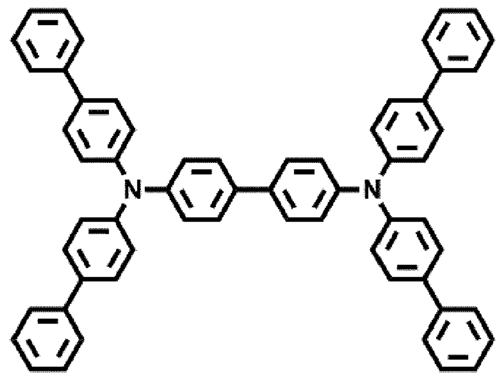

B02

1) From Tables 5 and 6, it can be seen that the organic light-emitting devices of Examples 1 to 3 each including the first emitter including iridium (emitting green light with the maximum emission wavelength in the range of 520 nm to 550 nm) and having the RCR value of 38 or less, has an equivalent level of lateral luminescence efficiency and improved (increased) frontal luminescence efficiency, compared to the organic light-emitting devices of Comparative Examples 1 to 14,

2) from Tables 5 and 7, it can be seen that the organic light-emitting devices of Examples 4 to 6 each including the first emitter including iridium (emitting green light with the maximum emission wavelength in the range of 520 nm

to 550 nm) and having the RCR value of 38 or less, has an equivalent level of lateral luminescence efficiency and improved frontal luminescence efficiency, compared to the organic light-emitting devices of Comparative Examples 1 to 12, 15, and 16,

3) from Tables 5 and 8, it can be seen that the organic light-emitting devices of Examples 7 to 9 each including the first emitter including iridium (emitting green light with the maximum emission wavelength in the range of 520 nm to 550 nm) and having the RCR value of 38 or less, has an equivalent level of lateral luminescence efficiency and improved frontal luminescence efficiency, compared to the organic light-emitting devices of Comparative Examples 1 to 12, 17, and 18, and

4) from Tables 5 and 9, it can be seen that the organic light-emitting devices of Examples 10 to 12 each including the first emitter including iridium (emitting green light with the maximum emission wavelength in the range of 520 nm to 550 nm) and having the RCR value of 38 or less, has an equivalent level of lateral luminescence efficiency and improved frontal luminescence efficiency, compared to the organic light-emitting devices of Comparative Examples 1 to 12, 19, and 20.

Because the light-emitting device has excellent or suitable frontal luminescence efficiency and lateral luminescence efficiency at the same time (concurrently), a high-quality electronic apparatus can be manufactured utilizing the same.

The use of "may" when describing embodiments of the present disclosure refers to "one or more embodiments of the present disclosure."

As used herein, the term "substantially," "about," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Also, any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this disclosure is intended to include all higher numerical limitations subsumed therein. Accordingly, Applicant reserves the right to amend this disclosure, including the claims, to expressly recite any sub-range subsumed within the ranges expressly recited herein.

The light emitting device, electronic apparatus or any other relevant devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the drawings, it will be understood by those of ordinary skill in the art that one or more suitable changes in form and details may be made therein without departing from the scope of the present disclosure as defined by the following claims and equivalents thereof.

**Claims**

1. A light-emitting device, comprising:

a first electrode (110),
a second electrode (150) facing the first electrode,
an interlayer (130) between the first electrode and the second electrode and comprising an emission layer, and a capping layer (170),
wherein the emission layer comprises a first emitter,
the first emitter is configured to emit a first light having a first emission spectrum,
the capping layer is in a path on which the first light travels,
an emission peak wavelength of the first light is from 520 nm to 550 nm,
the first emitter comprises iridium,
the capping layer comprises an amine-free compound, and
the value of ratio of CIEy to reflective index, RCR value, of the first light extracted to the outside through the capping layer is 38 or less, and
the RCR value is calculated according to Equation 1:

Equation 1

$$CIEy/R(cap) \times 100$$

wherein, in Equation 1,
CIEy is the y coordinate value of the CIE color coordinates of the first light extracted to the outside through the capping layer, and
R(cap) is the refractive index of the amine-free compound with respect to a second light having a wavelength of the emission peak wavelength of the first light ± 20 nm.

2. The light-emitting device of claim 1, wherein
an emission peak wavelength of the first light is in the range of 525 nm to 545 nm.

3. The light-emitting device of claim 1 or 2, wherein
a full width at half maximum of the first light is from 15 nm to 60 nm.

4. The light-emitting device of any of the preceding claims, wherein
the first light is a green light.

5. The light-emitting device of any of the preceding claims, wherein

the first emitter comprises a first ligand, a second ligand, and a third ligand, wherein each of the first ligand, second ligand and third ligand is bonded to the iridium,
the first ligand is a bidentate ligand comprising $Y_1$-containing ring $B_1$ and $Y_2$-containing ring $B_2$,
the second ligand is a bidentate ligand comprising $Y_3$-containing ring $B_3$ and $Y_4$-containing ring $B_4$,
the third ligand is a bidentate ligand comprising $Y_5$-containing ring $B_5$ and $Y_6$-containing ring $B_6$,
each of $Y_1$, $Y_3$, and $Y_5$ is nitrogen,N,
each of $Y_2$, $Y_4$, and $Y_6$ is carbon,C, and
$Y_2$-containing ring $B_2$ and $Y_4$-containing ring $B_4$ are different from each other.

6. The light-emitting device of any of the preceding claims, wherein
the amine-free compound is comprised in the capping layer, comprises three or more $C_1$-$C_{60}$ cyclic groups which are linked to each other only via a single bond, not an atom.

7. The light-emitting device of any of the preceding claims, wherein
the RCR value of the first light extracted to the outside through the capping layer is from 32.0 to 37.5.8.

8. The light-emitting device of any of preceding claims, wherein
CIEy is from 0.705 to 0.740.

**9.** The light-emitting device of any of the preceding claim, wherein
R(cap) is the refractive index of the amine-free compound with respect to the second light having a wavelength of 530 nm, and/or10.

**10.** The light emitting device any of the preceding claims, wherein
R(cap) is from 1.85 to 2.5.

**11.** The light-emitting device of any of claims 5 to 10, wherein
$Y_2$-containing ring $B_2$ is a polycyclic group.

**12.** An electronic apparatus comprising the light-emitting device of any of the preceding claims.

**13.** The electronic apparatus of claim 12, further comprising
a color filter, a color conversion layer, a touch screen layer, a polarizing layer, or any combination thereof.

**14.** A consumer product, comprising the light-emitting device of any of claims 1 to 11.

**15.** The consumer product of claim 14, selected from among a flat panel display, a curved display, a computer monitor, a medical monitor, a TV, a billboard, indoor or outdoor illuminations and/or signal light, a head-up display, a fully or partially transparent display, a flexible display, a rollable display, a foldable display, a stretchable display, a laser printer, a phone, a cell phone, a tablet, a phablet, a personal digital assistant (PDA), a wearable device, laptop computers, digital cameras, camcorders, viewfinders, micro displays, 3D displays, virtual or augmented reality displays, vehicles, a video wall comprising multiple displays tiled together, a theater or stadium screen, a phototherapy device, and a signage.

FIG. 1

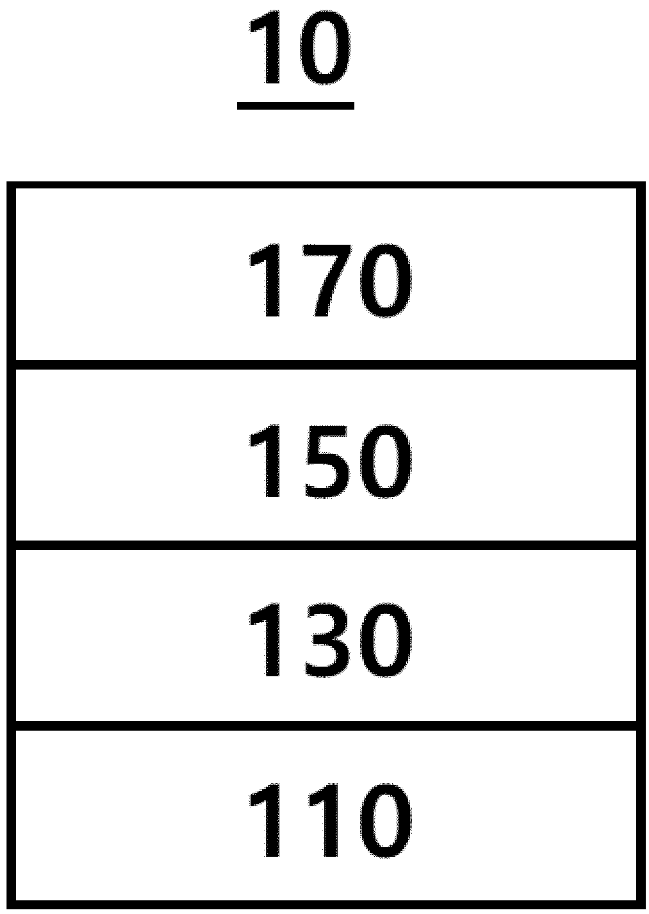

# FIG. 2

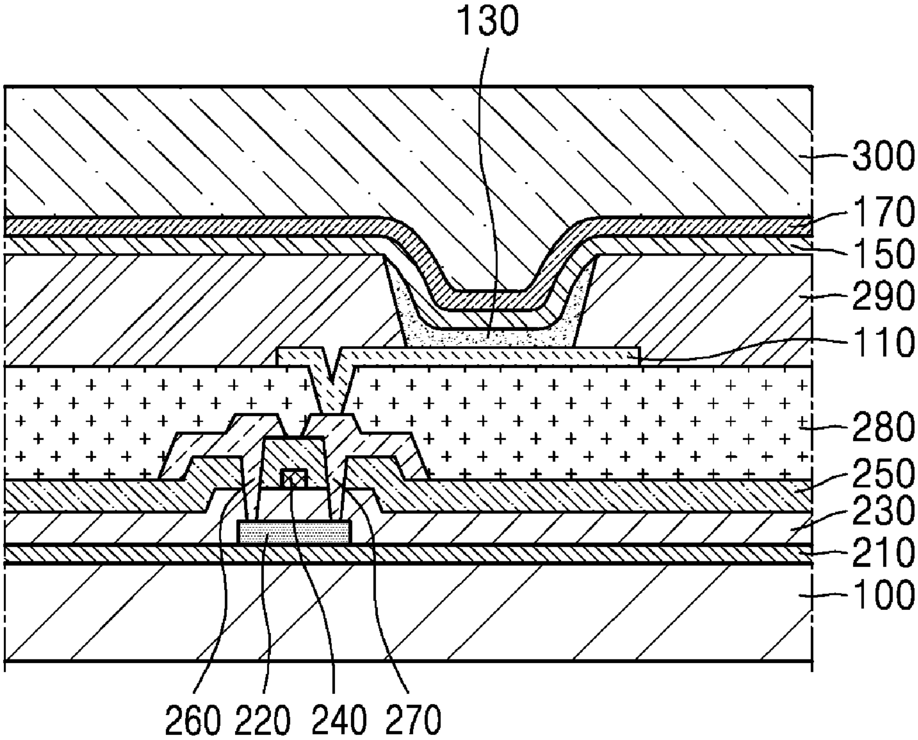

FIG. 3

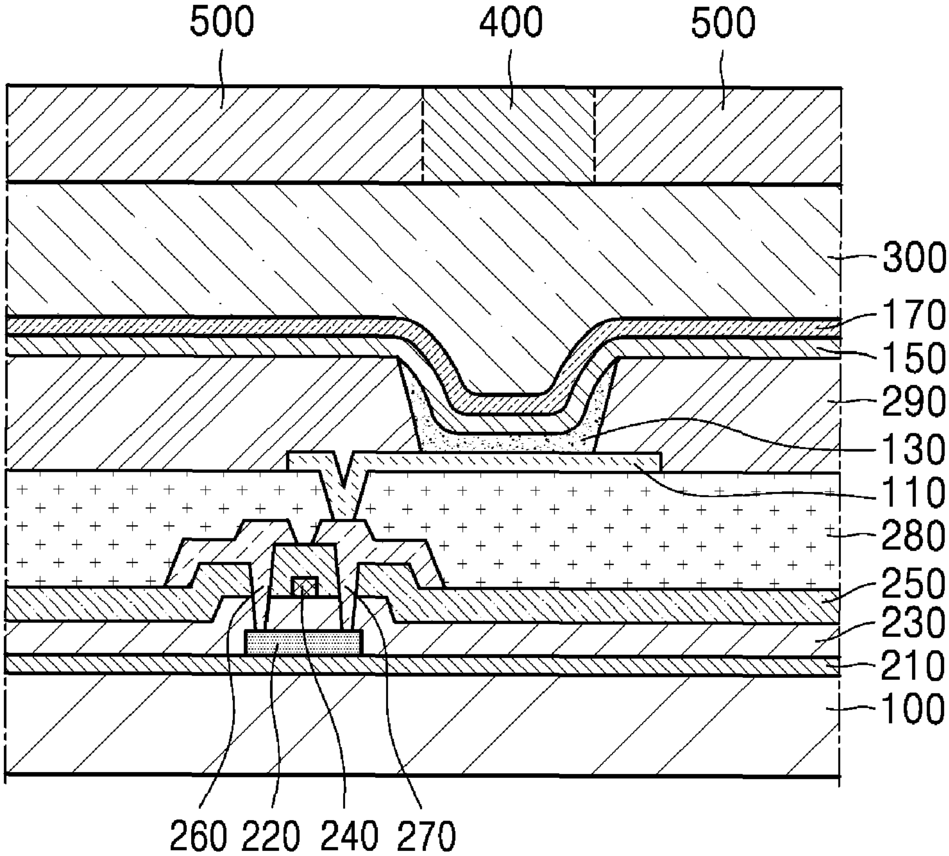
500
400
500
300
170
150
290
130
110
280
250
230
210
100
260 220 240 270

Europäisches Patentamt
European Patent Office
Office européen des brevets

# EUROPEAN SEARCH REPORT

Application Number
EP 23 15 0919

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>Y | US 2020/388791 A1 (ZHANG ZHAOCHAO [CN] ET AL) 10 December 2020 (2020-12-10)<br><br>* paragraphs [0140], [0073], [0132]; table 2; compound 1 *<br>----- | 1-4,6-8, 10,12, 14,15<br>5,11 | INV.<br>H10K50/858<br>H10K85/30<br><br>ADD.<br>H10K50/11 |
| X | US 2021/384442 A1 (WATABE TAKEYOSHI [JP] ET AL) 9 December 2021 (2021-12-09)<br>* paragraphs [0571] - [0578], [0072], [0452]; figure 17 *<br>* page 39; table 4; compounds DBT3P-II *<br>----- | 1-4,7,9, 12-15 | |
| T | WO 2023/052899 A1 (SEMICONDUCTOR ENERGY LAB [JP]) 6 April 2023 (2023-04-06)<br>* figure 14 *<br>----- | 1,9 | |
| Y | US 2020/161563 A1 (JANG KIPO [KR] ET AL) 21 May 2020 (2020-05-21)<br>* paragraph [0144]; compounds E-2 *<br>----- | 5,11 | |

TECHNICAL FIELDS SEARCHED (IPC)

H10K

The present search report has been drawn up for all claims

| Place of search | Date of completion of the search | Examiner |
|---|---|---|
| Munich | 23 May 2023 | Beierlein, Udo |

1

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 23 15 0919

This annex lists the patent family members relating to the patent documents cited in the above-mentioned European search report. The members are as contained in the European Patent Office EDP file on
The European Patent Office is in no way liable for these particulars which are merely given for the purpose of information.

23-05-2023

| Patent document cited in search report | Publication date | Patent family member(s) | Publication date |
| --- | --- | --- | --- |
| US 2020388791 A1 | 10-12-2020 | CN 109980085 A | 05-07-2019 |
| | | US 2020388791 A1 | 10-12-2020 |
| | | WO 2019128948 A1 | 04-07-2019 |
| US 2021384442 A1 | 09-12-2021 | CN 111183709 A | 19-05-2020 |
| | | DE 112018005069 T5 | 02-07-2020 |
| | | JP WO2019053559 A1 | 15-10-2020 |
| | | KR 20200051658 A | 13-05-2020 |
| | | US 2021384442 A1 | 09-12-2021 |
| | | WO 2019053559 A1 | 21-03-2019 |
| WO 2023052899 A1 | 06-04-2023 | NONE | |
| US 2020161563 A1 | 21-05-2020 | CN 110892538 A | 17-03-2020 |
| | | EP 3657559 A1 | 27-05-2020 |
| | | JP 7007455 B2 | 24-01-2022 |
| | | JP 2020528218 A | 17-09-2020 |
| | | KR 20190010350 A | 30-01-2019 |
| | | TW 201908463 A | 01-03-2019 |
| | | US 2020161563 A1 | 21-05-2020 |
| | | WO 2019017618 A1 | 24-01-2019 |

EPO FORM P0459

For more details about this annex : see Official Journal of the European Patent Office, No. 12/82